(19) **Europäisches Patentamt / European Patent Office / Office européen des brevets**

(11) **EP 2 437 307 A1**

(12) **EUROPEAN PATENT APPLICATION**
published in accordance with Art. 153(4) EPC

(43) Date of publication:
**04.04.2012 Bulletin 2012/14**

(21) Application number: **09845166.9**

(22) Date of filing: **25.05.2009**

(51) Int Cl.:
**H01L 31/042** (2006.01)

(86) International application number:
**PCT/JP2009/059495**

(87) International publication number:
**WO 2010/137099 (02.12.2010 Gazette 2010/48)**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(71) Applicant: **Toray Industries, Inc.**
**Tokyo 103-8666 (JP)**

(72) Inventors:
• **AOYAMA, Shigeru**
 **Otsu-shi**
 **Shiga 520-8558 (JP)**

• **OHIRA, Takayuki**
 **Otsu-shi**
 **Shiga 520-8558 (JP)**
• **TAKAHASHI, Kozo**
 **Otsu-shi**
 **Shiga 520-8558 (JP)**

(74) Representative: **Kador & Partner**
 **Corneliusstrasse 15**
 **80469 München (DE)**

(54) **FILM FOR SOLAR CELL BACKSHEET, SOLAR CELL BACKSHEET USING THE SAME, AND SOLAR CELL**

(57) The invention provides a solar cell backsheet film that maintains high mechanical strength and has a high partial discharge voltage though small in thickness, as well as a solar cell backsheet produced thereof that has a high partial discharge voltage though small in thickness. The invention also provides a highly durable and/or thin solar cell produced thereof.

The backsheet film has a multilayered configuration composed of at least two layers including a layer (hereinafter referred to as layer A) having a surface with a surface resistivity R0 of not less than $10^6$ $\Omega$/square but not more than $10^{14}$ $\Omega$/square (hereinafter referred to as surface A) and a base layer (hereinafter referred to as layer B) wherein layer B contains a layer (hereinafter referred to as layer B1) comprising polyester, the polyester of layer B1 having an weight average molecular weight of not less than 37,500 but not more than 60,000.

Fig. 1

**Description**

Technical Field

The present invention relates to a solar cell backsheet film having a high partial electrical discharge voltage even when the film is thin, and also relates to solar cell backsheets and solar cells produced thereof.

Background Art

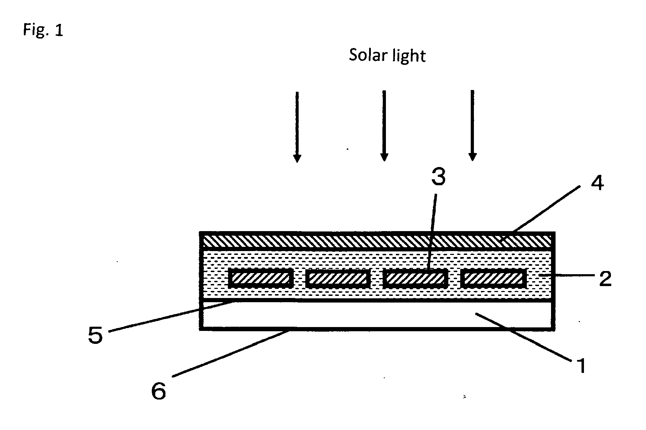

In recent years, as a next generation semi-permanent and pollution-free energy source, focus is on photovoltaic power generation that generates clean energy, and the solar cell is rapidly becoming popular. Fig. 1 illustrates a typical configuration of the solar cell. The solar cell is configured with generating elements 3 sealed with a transparent filling material 2 such as Ethylene-Vinyl Acetate copolymer (EVA), and the sealed body is applied to a transparent base plate 4, such as glass, and a resin sheet known as backsheet 1. Solar light is introduced into the solar cell through the transparent base plate 4. The solar light introduced into the solar cell is absorbed by the generating elements 3, and the absorbed solar energy is transformed into electric energy. The transformed electric energy is extracted through lead wires (not illustrated in Fig. 1) connected to the generating element 3, and the electric energy is applied to various electric devices. The backsheet 1 herein is a sheet member that is disposed on the opposite side of the generating elements 3 to the sun, and that is not in direct contact with the generating elements 3. While various ideas have been proposed concerning the solar cell system and different members, polyethylene-based, polyester-based, and fluorine-based resin films are mainly used (refer to Patent Documents 1 to 3). Furthermore, the use of air-bubble-containing films, which are used as reflection film for liquid displays, for solar cell backsheets has been proposed recently (refer to Patent Documents 4 and 5).
The solar cells are attached on the roofs of standard homes and communal facilities, as well as being installed in huge premises as a large-scale power generator. While in practical used, the solar cell system suffers high voltage for a long period of time, and therefore, the backsheets are desired to both maintain mechanical strength for long periods of time and to have high anti-electric characteristics. Inferior anti-electric characteristics will cause discharge of tiny charges inside the film while the solar cell system is functioning. The discharge is known as partial discharge. In the event that such discharge continues for a long time, chemical deterioration will proceed in the resin that constitutes the backsheets. This is because as progressive chemical deterioration is caused by partial discharge, the system could become likely to suffer fatal insulation breakdown when high voltage is momentarily applied from lightning strikes etc., even if the system has sufficient voltage resistance to lighting strikes of a common strength. Therefore, it is required to increase the voltage at which the partial discharge phenomenon starts to occur (hereinafter referred to as partial electrical discharge voltage), in order to allow the backsheet to inhibit the partial discharge phenomenon as effectively as possible. A thinner backsheet is also desired in view of conserving the space for solar cell system installation, and reducing its weight.

Documents on.Prior Technologies

Patent Documents

[Patent Document 1] Japanese Unexamined Patent Publication (Kokai) No. 11-261085
[Patent Document 2] Japanese Unexamined Patent Publication (Kokai) No. 11-186575
[Patent Document 3] Japanese Unexamined Patent Publication (Kokai) No. 2006-270025
[Patent Document 4] Japanese Unexamined Patent Publication (Kokai) No. 2009-12454
[Patent Document 5] Japanese Unexamined Patent Publication (Kokai) No. 2009-42421

Summary of the Invention

Problems to be solved by the Invention

However, there are no conventional film materials that have actively improved long-term moist heat resistance and partial electrical discharge voltage. Therefore, to develop high partial electrical discharge voltage while retaining long-term mechanical strength, there have been no other methods available than to increase the film thickness. This places a limit to the reduction in weight, and makes it difficult to retain long-term mechanical strength, high partial electrical discharge voltage, and reduced thickness at the same time.

Means of Solving the Problems

Therefore, in view of such technology in the background art, the present invention aims to provide a solar cell backsheet film retaining a mechanical strength for long periods of time, and having a high partial electrical discharge voltage despite of a small thickness, as well as a solar cell backsheet produced thereof and a solar cell produced. Specifically, the present invention provides a solar cell backsheet film comprising a multilayered configuration composed of at least two layers including a layer (layer A) having a surface with a surface resistivity R0 of not less than $10^6$ $\Omega$/square but not more than $10^{14}$ $\Omega$/square (hereinafter referred to as surface A) and a base layer (layer B) wherein layer B contains a layer (layer B1) comprising polyester, the polyester of layer B1 having an weight average molecular weight of not less than 37, 500 but not more than 60,000, and also provides a solar cell backsheet produced thereof and a solar cell produced thereof.

Effect of the Invention

The present invention can provide a solar cell backsheet film retaining a long-term mechanical strength and having high partial electrical discharge voltage despite of a small thickness. Furthermore, the use of the film serves to produce a solar cell backsheet with an improved durability and a reduced thickness, which in turn serves to produce a solar cell with an improved durability and a reduced thickness.

Brief Description of the Drawings

Fig. 1 is a cross-sectional view schematically illustrating an example of solar cell configuration.

Description of embodiments

As a result of careful examination of the aforementioned problems with providing a solar cell backsheet film retaining a long-term mechanical strength and having a high partial electrical discharge voltage despite a small thickness, the present invention now can solve these problems at once by controlling the electric characteristics on the surface within a certain range.

The solar cell backsheet film according to the present invention has the following configuration. Specifically, it is a solar cell backsheet film having a multilayered configuration composed of at least two layers including a layer (layer A) having a surface with a surface resistivity R0 of not less than $10^6$ $\Omega$/square but not more than $10^{14}$ $\Omega$/square (hereinafter referred to as surface A) and a base layer (layer B) wherein layer B contains a layer (layer B1) comprising polyester, the polyester of layer B1 having an weight average molecular weight of not less than 37, 500 but not more than 60,000.

When a high voltage is applied in.the thickness direction of the solar cell backsheet film, this configuration allows said layer A to conduct and diffuse an appropriate part of the electric field received by the film in in-plane directions of the film. Accordingly, the quantity of electric flux per unit volume received in the thickness direction of the film can be reduced. As a result, even when a high voltage is applied to the film, convergence of the electric flux to portions where insulation performance is inferior can be controlled, whereby the partial discharge phenomenon can be inhibited from occurring.

Furthermore, the film contains a layer comprising polyester (layer B1) as base layer (layer B) wherein the polyester of layer B1 has a weight average molecular weight of not less than 37,500 and not more than 60,000 an consequently can retain mechanical strength for longer periods of time in comparison with the conventional backsheets.

As described above, the film can retain mechanical strength for a long period of time and possess an increased partial electrical discharge voltage without increasing its film thickness, which has been difficult for the conventional films to achieve.

The solar cell backsheet film according to the present invention preferably has a surface resistivity R2 of not less than $10^{14}$ $\Omega$/square on surface A and the surface of the opposite side. As describe below, when incorporating the solar cell backsheet film according to the present invention in a solar cell system, it is preferable that surface A is on the opposite side of the resin layer in which the generating elements are sealed (6 in Fig. 1). Adoption of this configuration allows the partial electrical discharge voltage to be improved, thus serving to provide solar cells with high durability and solar cells with a reduced thickness.

This is because when the surface resistivity is not less than $10^6$ $\Omega$/square on both surfaces of the solar cell backsheet film, it can become likely that the anti-electric characteristics of the solar cell backsheet will deteriorate, and that extraction efficiency for electric energy extraction through the lead wires will decrease to cause a reduction in the power generation efficiency.

A solar cell backsheet film according to the present invention preferably has a rupture elongation of not less than 50%. The rupture elongation herein is measured by cutting out a sample with a size of 1 cm x 20 cm, and pulling the sample with a chuck distance of 5 cm and a tension speed of 300 mm/min according to ASTM-D822 (1999) . The elongation measured by the aforementioned method is preferably not less than 60%, more preferably not less than 80%, particularly preferably not less than 100%, and most preferably not less than 120%. If the rupture elongation of the solar cell backsheet film according to the present invention is less than 50%, a backsheet produced from it can surfer fracture after being incorporated in a solar cell when the cell receives some sort of external impact (for example, vibrations during transportation, and other loads applied during transportation or construction work for installation). In the solar cell backsheet film according to the present invention, setting an elongation retaining percentage of not less than 50% allows the solar cell to have an increased impact resistance.

Furthermore, a solar cell backsheet film according to the present invention preferably has an elongation retaining percentage of not less than 50% after being left to stand for 24 hours under the conditions of a temperature of 125°C and a humidity of 100%RH. The elongation retaining percentage herein is measured according to ASTM-D882 (1999), and calculated from the following formula (1) where E0 represents the rupture elongation of the film before treatment and E1 represents the rupture elongation of the film after being left to stand for 24 hours under the conditions of a temperature of 125°C and a humidity of 100%RH.

$$\text{Elongation retaining percentage (\%)} = E1/E0 \times 100 \qquad (1)$$

It should be noted that El is measured for a properly shaped specimen cut out from a sample and treated for 24 hours under the conditions of a temperature of 125°C and a humidity of 100%RH.

The elongation retaining percentage determined by the aforementioned method is more preferably not less than 55%, still more preferably not less than 60%, particularly preferably not less than 65%, and most preferably not less than 70%. In the solar cell backsheet film according to the present invention, an elongation retaining percentage of less than 50% will reduce the mechanical strength when used for a long period of time. As a result, the backsheet produced from it may be fractured when some sort of external impact is applied to the solar cell that incorporates the backsheet (for example, a stone falling to hit the solar cell). In the solar cell backsheet film according to the present invention, an elongation retaining percentage of not less than 50% allows backsheet to maintain an increased durability in terms of mechanical strength when used for a long period of time.

The configuration of the solar cell backsheet film according to the present invention will be described in more details below.

The solar cell backsheet film according to the present invention can be used preferably if it meets the aforementioned requirements, but as an aspect of its configuration, it is required to have a multiple layer structure consisting of at least two or more layers including an electrically conductive layer (layer A) and a base layer (layer B) wherein at least one surface comprises layer A. This configuration allows said electrically conductive layer A to work to improve the partial electrical discharge voltage while allowing the base layer (layer B) to serve for development of properties such as mechanical strength and electric insulation in the thickness direction of the film.

The conductive layer (layer A) in the solar cell backsheet film according to the present invention herein described is a layer having a surface (surface A) with a measured surface resistivity R0 of not less than $10^6$ Ω/square and not more than $10^{14}$ Ω/square. The surface resistivity is more preferably not less than $10^7$ Ω/square and not more than $10^{14}$ Ω/square, still more preferably not less than $10^8$ Ω/square and not more than $10^{14}$ Ω/square, particularly preferably not less than $10^9$ Ω/square and not more than $10^{14}$ Ω/squire, and most preferably not less than $10^9$ Ω/square and not more than $10^{13}$ Ω/square. A surface resistivity R0 of layer A of less than $10^6$ Ω/square is not preferable as layer A can become so conductive that electricity partly flows in the thickness direction. This may allow layer A as a whole to work as a pseudo-electrode to reduce the effect of relaxing the electric field in the in-plane directions and prevent the partial electrical discharge voltage from being improved or allow the extraction efficiency to decrease to cause a reduction in the generating efficiency when electric energy is extracted through the lead wires. On the other hand, a surface resistivity R0 of layer A exceeding $10^{14}$ Ω/square is not preferable either as the conductivity is so small that the effect of relaxing the electric field in the in-plane direction can be lost, possibly preventing the partial electrical discharge voltage from improving. Controlling the surface resistivity R0 of layer A in the solar cell backsheet film according to the present invention in the range between $10^6$ Ω/squire and $10^{14}$ Ω/square allows a part of the electric field applied in the film thickness direction to be conducted moderately in the film's in-plane directions when a high voltage is applied, which works to relax the concentration of the electric field in the thickness direction, whereby causing the partial electrical discharge voltage to increase without increasing the film thickness. Furthermore, backsheets produced of the film will have dramatically improved partial discharge characteristics and anti-electric characteristics.

In layer A in the solar cell backsheet film according to the present invention, surface A preferably has a surface resistivity of not less than $10^6$ Ω/square and not more than $10^{14}$ Ω/square after being left to stand for 24 hours under the conditions of a temperature of 125°C and a humidity of 100%. It is more preferably not less than $10^7$ Ω/square and

not more than $10^{14}$ Ω/square, still more preferably not less than $10^8$ Ω/square and not more than $10^{14}$ Ω/square, particularly preferably not less than $10^9$ Ω/square and not more than $10^{14}$ Ω/square, and most preferably not less than $10^9$ Ω/square and not more than $10^{13}$ Ω/square. When the surface resistivity R1 of layer A after being processed is less than $10^6$ Ω/square, the conductivity may be too high and lose its effect of relaxing the electric field in the in-plane direction as it is used for a long period of time, which can cause a decrease in the partial electrical discharge voltage or a decrease in the generating efficiency of the solar cell. On the other hand, when the surface resistivity exceeds $10^{14}$ Ω/square, the conductivity can become so small that its effect of relaxing the electric field in in-plane directions is lost, and the partial electrical discharge voltage may decrease. In the solar cell backsheet film according to the present invention, controlling the surface resistivity of layer A after being processed within the range from $10^6$ Ω/square to $10^{14}$ Ω/square allows the effect of improving the partial electrical discharge voltage to be maintained as it is used for a long period of time. As a result, backsheets produced of the solar cell backsheet film according to the present invention can have enhanced partial discharge characteristics and durability in terms of anti-electric characteristics.

In this respect, in the solar cell backsheet film according to the present invention, surface A must only meet the requirements for the characteristics described above, and a specific means is to add a component which develops conductivity in layer A. Here, preferable examples of said component to develop conductivity include organic conductive materials, inorganic conductive materials, and combinations of organic and inorganic conductive materials.

Examples of said organic conductive materials include cationic conductive compounds having cationic substituents such as ammonium groups, amine salt groups, and quaternary ammonium groups; anionic conductive compounds having anionic substituents such as sulfonate groups, phosphate groups, and carboxylate groups; amphoteric conductive compounds having both anionic and cationic substituent groups; and other ionic conductive materials; as well as conductive polymers such as polyacetylene, polyparaphenylene, polyaniline, polythiophene, polyparaphenylene vinylene, and polypyrrole that contain a conjugated polyene skeleton. These conductive materials are introduced into the matrix material that constitutes layer A by any of the methods 1) to 4) described below, and all these materials can be used preferably. Thus, they serve to develop conductivity in layer A.

1) Copolymerizing a conductive skeleton into the material serving as matrix;
2) Adding, mixing or misciblizing a conductive material to/with the material serving as matrix;
3) Adding or mixing a conductive material to/with the material serving as matrix, and then causing the conductive material to the surface so that it is concentrated near the surface; and
4) Adding or mixing the conductive material to/with the material serving as matrix, then causing the conductive material to disperse to form a conductive network.
All these methods can work to develop conductivity in layer A and can be used preferably.

of these compounds (conductive materials), ionic conductive materials are preferred when used to produce a film from a solution or to produce said layer A by coating the base layer (layer B) from the viewpoint of, for instance, maintaining a high conductivity even when a high voltage is applied, and cationic conductive compounds are more preferable from the viewpoint of the effect of maintaining improved coating properties, contact properties, and partial electrical discharge voltage for a long period. These conductive compounds may be either low molecular weight type conductive compounds or high molecular weight type conductive compounds, both of which may be preferably used, but high molecular weight type conductive compounds are more preferred for the present invention from the viewpoint of durability etc. In the case where the method 4) is used in a melt extrusion process to develop conductivity in surface A of layer A, it is preferable to use a polyether amide based copolymer type compound that can be dispersed in the matrix to form a conductive network, such as Irgastat P-series manufactured by Chiba Japan Co., Ltd., from the viewpoint of achieving high heat resistance as well as high moist heat resistance of layer A.

These organic conductive materials can be preferably used regardless of whether they are soluble or insoluble in water, but it is preferred to use water-insoluble conductive compounds because layer A of the solar cell backsheet film according to the present invention preferably have moist heat resistant characteristics. In the case of ionic conductive materials, their solubility and insolubility in water depends on the type of the monomer that constitutes the materials, and whether they are insoluble depends on the copolymerization ratio between the monomers having the above functional groups and the monomers not having the above functional groups. The ratio between the number of moles of the monomers having the above functional groups and the number of moles of the monomers not having the above functional groups (the number of moles of the monomers having the above functional groups / the number of moles of the monomer type not having the above functional groups) is preferably not less than 10/90 and not more than 90/10, more preferably not less than 20/80 and not more than 80/20, and still more preferably not less than 30/70 and not more than 70/30. When the ratio is smaller than 10/90, the surface resistivity R0 of surface A formed on layer A will be too high that the partial electrical discharge voltage improving effect may be lost. If the ratio exceeds 90/10, the water-solubility will be too high that the moist heat resistance characteristics of surface A formed may be inferior. In the solar cell backsheet film according to the present invention, controlling the copolymerization ratio between the monomers having the above functional groups and the monomers not having the above functional groups in the range from not less than 10/90 to not more than 90/10 allows the film to have an improved partial electrical discharge voltage and moist heat resistant characteristics.

Furthermore, if the conductive material used for layer A in the solar cell backsheet film according to the present invention is an organic conductive material, water-insoluble resins including polyester resins, acrylic resins, polyolefin resins, polyamide resins, polycarbonate, polystyrene, polyether, polyester amid, polyether ester, polyvinyl chloride, polyvinyl alcohol, and copolymers comprising these components are preferably used in addition to said organic conductive material as the matrix material that constitutes layer A, in order to improve the moist heat resistance and to strengthen layer A as well as to improve the film-forming property of layer A during the formation of layer A by in-line coating of the base layer (layer B). When layer A is formed by coating, these materials may be added to and mixed with the coating material, and when layer A is formed by melt extrusion, they may be mixed by melt-kneading. In this case, even if the above organic conductive material is a water-soluble conductive material, it will be possible to make it moist heat resistant, and if it is a water-insoluble conductive material, its moist heat resistance can be further improved. The mixing ratio between the above organic conductive material and the water-insoluble resin (mass of the organic conductive material / mass of the water-insoluble resin) is preferably between 5/95 and 50/50 when the organic conductive material is a water-soluble conductive material. It is more preferably between 10/90 and 40/60. A mixing ratio of less than 5/95 is not preferable because the surface resistivity R0 of layer A will be so high that the partial electrical discharge voltage may not be improved. If the above mixing ratio is more than 50/50, the moist heat resistance of layer A formed may be inferior. If the organic conductive material is a water-insoluble conductive material, the above mixing ratio between the above organic conductive material and the water-insoluble resin (mass of the organic conductive material / mass of the water-insoluble resin) is preferably between 26/74 and 98/2. More preferably, it is between 30/70 and 95/5. If the above mixing ratio is less than 26/74, it is not preferred because the surface resistivity R0 of layer A will be so high that the partial electrical discharge voltage may not be improved, and when the above mixing ratio is more than 98/2, the moist heat resistance of layer A formed may be inferior. In the solar cell backsheet film according to the present invention, the partial electrical discharge voltage can be improved, and the moist heat resistance of the property can be developed, by controlling the mixing ratio between the above organic conductive material and the water-insoluble resin (mass of the organic conductive material / mass of the water-insoluble resin) in the range from not less than 5/95 to not more than 50/50 when the organic conductive material is a water-soluble conductive material, and in the range from not less than 26/74 to not more than 98/2 when the organic conductive material is a water-insoluble conductive material.

Examples of water-insoluble resin to be used for forming layer A by melt extrusion include polyester-based resins such as polyethylene terephthalate (hereinafter occasionally referred to as PET), polyethylene-2,6-naphtalate, polypropylene terephthalate, polybutylene terephthalate, poly-1,4-cyclohexylene dimethylene terephthalate, and polylactic acid; polyolfin-based resins such as polyethylene, polystyrene, polypropylene, polyisobutylene, polybutene, and polymethyl pentene; and others such as cycloolefin-based resin, polyamide-based resin, polyimide-based resin, polyether-based resin, polyester amide based resin, polyether-ester-based resin, acrylic resin, polyurethane-based resin, polycarbonate-based resin, polyvinyl chloride-based resin, and fluorinate-based resin. Of these, it is preferable that the material used mainly comprise thermoplastic resins selected from the group of polyester-based resins, polyolefin-based resins, cycloolefin-based resins, polyamide-based resins, acrylic resins, fluorinate-based resins, and mixtures thereof because of the diversity of available monomers for copolymerization and the resulting easiness in adjusting material properties. It is particularly preferable that the layer comprises a polyester-based resin from the viewpoint of mechanical strength and cost: Furthermore, it is preferably a water-insoluble resin with a uniaxial or biaxial orientation because the mechanical strength can be increased as a result of oriented crystallization and also because the long-term hydrolysis resistance of layer A can be improved in the case of polyester-based resin.

Furthermore, in the case where the conductive material used for layer A is an organic conductive material, adding a cross-linking agent along with said organic conductive materials and water-insoluble resins has been a preferred practice in order to further improve the moist heat resistance, improve the contact of layer A with the base layer (layer B) during its formation by coating the base layer (layer B), and to prevent blocking of the film during film formation from a solution or coating of the base layer (layer B) with a material for layer A. The preferred cross-linking agents include those resins and compounds that can undergo a cross-linking reaction with the functional groups present in the resins constituting the aforementioned organic materials and/or the water-insoluble resins such as hydroxyl groups, carboxyl groups, glycidyl groups, and amid groups, and their examples include methylol-type or alkylol-type urea-based, melamine-based, acrylic amide-based, and polyamide-based resins, as well as epoxy compounds, oxetane-based compounds, isocyanate compounds, coupling agents, aziridine-based compounds, oxazoline-based compounds, carbodiimide-based compounds, acid anhydrides, carboxylate derivatives and mixtures thereof.

The type and content of said cross-linking agent is appropriately selected depending on the organic conductive material for layer A, water-insoluble resin, and the base layer (layer B) . In the case where the film is produced from a solution or a material for layer A is applied over the base layer (layer B), the cross-linking agent to be used in the solar cell backsheet film according to the invention is preferably an oxazoline compound if said organic conductive material and/or water-insoluble resin have an acrylic skeleton, and preferably a melamine-based compound if said organic conductive material and/or water-insoluble resin have a polyester-based skeleton, because the resulting layer A will be superior in moist heat resistance. In the case where layer A is formed by melt extrusion, furthermore, oxazoline-based compounds, epoxy-based compounds, oxetane-based compounds, carbodiimide-based compounds, acid anhydrides, and carboxylate derivatives are used preferably as cross-linking agents if a polyester-based resin is used as said water-insoluble resin.

Commonly, the content of the cross-linking agent is preferably not less than 0.01 parts by mass and not more than 50 parts by mass, more preferably not less than 0.2 part by mass and not more than 40 parts by mass, and still more preferably not less than 0.5 parts by mass and not more than 30 parts by mass, per 100 parts by mass, i.e. the total mass, of the resin components that constitute layer A.

Here, it is also preferable that a catalyst is used together with the cross-linking agent in order to promote the cross-linking. The method used for cross-linking reaction method may be heating, electromagnetic wave irradiation, and moisture absorption, of which heating is commonly preferred.

When the material to constitute layer A is an organic conductive material in the solar cell backsheet film according to the present invention, the surface resistivity R0 of surface A depends on the type of the organic conductive material contained in layer A, type and mixing ratio of the water-insoluble resin and the cross-linking agent, their mixing ratio with other materials, film thickness, etc. The surface resistivity R0 increases with increasing contents of the water-insoluble resins and the cross-linking agents compared with those of the organic conductive materials contained in layer A, while the surface resistivity R0 decreases with decreasing contents thereof. The surface resistivity R0 decreases with an increasing film thickness of layer A, while the surface resistivity R0 increases with a decreasing thickness thereof. The optimum composition and film thickness depend on the types of the materials to be used and the film configuration, but the film is produced so that the surface resistivity R0 of surface A meets the aforementioned requirements. In the case where for the solar cell backsheet film according to the present invention, the material to constitute layer A is an organic conductive material and layer A is formed by in-line coating of the base layer (layer B) during its production, it is more preferable that a cationic conductive compound having an acrylic skeleton used as said conductive material, a compound having an acrylic skeleton used as said water-insoluble resin, and an oxazoline compound used as said cross-linking agent are combined because layer A will have good film forming properties and also because the resulting layer A will have a high partial electrical discharge voltage and a high resistance to moist heat even if the layer is small in thickness. Furthermore, it is preferable that said organic conductive material accounts for not less than 50 parts by mass per 100 parts by mass, i.e. the total mass, of the resin components, and a mixing ratio between said organic conductive material and the water-insoluble resin (mass of the organic conductive material / mass of the water-insoluble resin) is not less than 25/75 and not more than 98/2 (more preferably not less than 50/50 and not more than 95/5), while the cross-linking agent is not less than 1 part by mass and not more than 20 parts by mass (more preferably not less than 2 parts by mass and not more than 20 parts by mass) per 100 parts by mass, i.e. the total mass, of the resin components.

If an inorganic conductive material is to be used as the material to constitute the conductive layer (layer A) in the solar cell backsheet film according to the present invention, useful examples thereof include oxidized, suboxidized or hypooxidized products of a material composed mainly of inorganic substances such as gold, silver, copper, platinum, silicon, boron, palladium, rhenium, vanadium, osmium, cobalt, iron, zinc, ruthenium, praseodymium, chromium, nickel, aluminum, tin, titanium, tantalum, zirconium, antimony, indium, yttrium, lanthanum, magnesium, calcium, cerium, hafnium, and barium, and mixtures of said inorganic substances with oxidized, suboxidized or hypooxidized products of said inorganic substances (hereinafter collectively referred to as inorganic oxides); nitrided, subnitrided or hyponitrided products of a material mainly composed of said inorganic substances, and mixtures of said inorganic substances with nitrided, subnitrided or hyponitrided products of said inorganic substances (hereinafter collectively referred to as inorganic nitrides); oxynitrided, suboxynitrided or hypooxynitrided products of a material mainly composed of said inorganic substances, and mixtures of said inorganic substances with oxynitrided, suboxynitrided or hypooxynitrided products of said inorganic substances (hereinafter collectively referred to as inorganic oxynitrides); carbonized, subcarbonize or hypocarbonized products of a material mainly composed of said inorganic substances, and mixtures of said inorganic substances with carbonized, subcarbonize or hypocarbonized products of said inorganic substances (hereinafter collectively referred to as inorganic carbides) ; fluorinated and/or chlorinated and/or brominated and/or iodinated (hereinafter collectively referred to as halogenated), subhalogenated or hypohalogenated products of a material mainly composed of said inorganic substances, and mixtures of said inorganic substances with halogenated, subhalogenated or hypohalogenated products of said inorganic substances (hereinafter collectively referred to as inorganic halides); mixtures of said inorganic substances with sulfidized, subsulfidized or hyposulfidized products of said inorganic substances (hereinafter collectively referred to as inorganic hydrosulfides); said compounds doped with a foreign element; carbon-based compounds such as graphite-like carbon, diamond-like carbon, carbon fiber, carbon nanotube, and fullerene (hereinafter referred to as carbon-based compounds); and mixtures thereof. Layer A is only required to contain any of the above materials, but if the thickness of layer A is not more than 1 $\mu$m, it is preferable that they are the main components to ensure that the surface resistivity is in the aforementioned range. Here, the main component is defined as one that accounts for more than 50% by mass of the layer.

If the material that constitutes the conductive layer (layer A) is an inorganic conductive material in the solar cell backsheet film according to the present invention, the surface resistivity R0 of surface A in layer A depends on the degree of modification (oxidization, nitridation, oxynitridation, carbonization, halogation, and sulfuration) of said inorganic substances contained in the film, the mixing ratio of said inorganic substances with said modified inorganic substances, their mixing ratio with other substances, and the film thickness. As the degree of modification in the inorganic substances increases, the surface resistivity R0 of layer A increases, while as the degree of modification decreases, the surface resistivity R0 of layer A decreases. The surface resistivity R0 increases as the content of the modified inorganic substances increases as compared with that of the unmodified inorganic substances, while the surface resistivity R0 decreases as the content decreases. The surface resistivity R0 decreases as the film thickness increases, while the surface resistivity R0 increases as the thickness decreases. The optimum composition and film thickness depend on the type of metal and the type of modification used, but the film should be formed so that the surface resistivity R0 meets the aforementioned requirements.

If layer A is to be produced from a composite organic/inorganic conductive material in the solar cell backsheet film according to the present invention (in such cases where, for example, i) a nonconductive water-insoluble resin is used for the matrix while an inorganic conductive material is used for said conductive material, ii) an organic conductive material is used together with an inorganic conductive material, iii) an organic conductive material is used together with an inorganic nonconductive material, or iv) a nonconductive water-insoluble resin is dispersed in an inorganic conductive material), organic conductive materials, inorganic conductive materials, water-insoluble resins, and cross-linking agents as listed above are used in combination with an inorganic nonconductive materials as required.

As an example of the case i), a water-insoluble resin may be used as the matrix of layer A, followed by dispersing an inorganic conductive material. This water-insoluble resin is preferably the same as the one used with said organic conductive material. There are no specific limitations on the shape of said inorganic conductive material to be dispersed in said water-insoluble resin that constitutes the matrix of layer A, and it may be pearl-like, spheroidal, flat, beaded, plate-like, or needle-like. Furthermore, it may be in the form of fine particles connected two-dimensionally or three-dimensionally in a water-insoluble resin. These inorganic particles may be either of a single element or more than one element.

From the viewpoint of the easiness of dispersion in an immiscible resin to be used as the matrix of layer A, it is preferable that that said inorganic conductive material is in the form of fine particles of a metal oxide such as zinc oxide, titanium oxide, cesium oxide, antimony oxide, tin oxide, indium tin oxide, yttrium oxide, ianthanum oxide, zirconium oxide, aluminum oxide, and silicon oxide or of a carbon-based material such as carbon black, carbon fiber, carbon nanotube, and fullerene. Furthermore, an inorganic conductive material with an appropriately selected average particle diameter may be used, but the diameter is preferably not less than 0.001 $\mu$m and not more than 20 $\mu$m. More preferably, it is not less than 0.005 $\mu$m and not more than 10 $\mu$m, particularly preferably not less than 0.01 $\mu$m and not more than 1 $\mu$m, and still more preferably not less than 0. 02 $\mu$m and not more than 0. 5 $\mu$m. The particle diameter as referred to herein is the median diameter d50. If the particle diameter is not more than 0.01 $\mu$m, it is not preferred because it may be difficult to disperse the particles in the water-insoluble resin to be used as the matrix, while it is difficult to produce a uniform layer A when the diameter is not less than 20$\mu$m.

Controlling the average particle diameter of the inorganic conductive material in the range of not less than 0.01 $\mu$m and not more than 20 $\mu$m makes it possible to achieve both a required conductivity and uniformity of the film formed.

Furthermore, adding a cross-linking agent along with said water-insoluble resin has been a preferred practice in order to further improve the mechanical strength and moist heat resistance, improve the contact of layer A with the base layer (layer B) during its formation by coating the base layer (layer B), and to prevent blocking during film formation from a solution or coating of the base layer (layer B) to form layer A. The same cross-linking agents as those used with said organic conductive material are used preferably.

If an organic conductive material is used as said conductive material in the cases of ii) and iii), it has been preferred to add fine particles along with said water-insoluble resin and cross-linking agents in order to improve the slipperiness of layer A, develop blocking resistance inlayer A, adjust the degree of brilliance, and control the surface resistivity. For instance, inorganic fine particles and organic fine particles may be used. Usable materials for said inorganic fine particles include, for example, metals such as gold, silver, copper, platinum, palladium, rhenium, vanadium, osmium, cobalt, iron, zinc, ruthenium, praseodymium, chromium, nickel, aluminum, tin, titanium, tantalum, zirconium, antimony, indium, yttrium, and lanthanum; carbon-based compounds such as graphite-like carbon and diamond-like carbon; inorganic conductive materials such as carbon nanotube and fullerene; metal oxides such as zinc oxide, titan oxide, cesium oxide, antimony oxide, tin oxide, indium tin oxide, yttrium oxide, lanthanum oxide, zirconium oxide, aluminum oxide, and silicon oxide; metal fluorides such as lithium fluoride, magnesium fluoride, aluminum fluoride, and cryolite; metal phosphates such as calcium phosphate; carbonates such as calcium carbonate; sulfates such as barium sulfate; and other inorganic nonconductive materials such as talc and kaoline. The particle diameter (number average particle diameter) of these fine particles is preferably not less than 0.05 μm and not more than 15 μm, preferably not less than 0.1 μm and not more than 10 μm. Furthermore, their content is preferably not less than 5% by mass and not more than 50% by mass, more preferably not less than 6% by mass and not more than 30% by mass, and still more preferably not less than 7% by mass and not more than 20% by mass, of the total resin components that constitute layer A. Particle contents in these ranges are preferred because surface slipperiness can be developed and the degree of surface glossiness can be adjusted while controlling the surface resistivity in the aforementioned range.

As an example of the case iv) is to produce a layered structure of at least two layers including a conductive layer (layer A) and a base layer (layer B) wherein a nonconductive water-insoluble resin is dispersed in the inorganic conductive material that constitutes layer A. It is preferable that the inorganic conductive material is the same as that used in the above case where an inorganic conductive material is used. There are no limitations on the shape of the water-insoluble resin dispersed in the inorganic conductive material, and it may be pearl-like, spheroidal, flat, beaded, plate-like, or needle-like. Furthermore, it may be in the form of fine particles of a. water-insoluble resin connected two-dimensionally or three-dimensionally in an inorganic conductive material. These water-insoluble resin particles may be either of a single resin or more than one resin.

With respect to the water-insoluble resin, those water-insoluble resins used in the case of above organic conductive materials are favorably used, and fine particles of silicone-based compounds and cross-linked materials such as cross-linked styrene, cross-linked acrylic resin, and cross-linked melamine may also be used.

In the solar cell backsheet film according to the present invention, layer A preferably contains a light stabilizing agent in order to protect layer A and/or the base layer (layer B) from ultraviolet degradation. Examples of the light stabilizing agent as referred to here include compounds which absorb light such as ultraviolet ray and convert it into thermal energy and materials which acquire radicals produced from layer A that is decomposed after absorbing light to inhibit chain reaction for decomposition. The use of compounds which absorb light such as ultraviolet ray and convert it into thermal energy is more preferable. Adding a light stabilizer in layer A makes it possible to prolong and maintain at a high level the effect of surface A on improving the partial electrical discharge voltage of layer A even if it is exposed to ultraviolet ray for a long period of time, or also serves prevent layer A and/or the base layer (layer B) from suffering changes in color tone or degradation in strength caused by ultraviolet ray. There are no limitations on the ultraviolet ray absorbing agent referred to here as long as it does not impair other characteristics, and its preferable examples include organic ultraviolet ray absorbing agents, inorganic ultraviolet ray absorbing agents, and combinations thereof, but it is desirable that they are high in moist heat resistance and can be uniformly dispersed in layer A. Examples of said ultraviolet ray absorbing agent include, for instance, organic ultraviolet ray absorbing agents such as salicylate-based, benzophenone-based, benzotriazole-based, and cyanoacrylate-based ultraviolet ray absorbing agents, as well as hindered amine-based ultraviolet ray stabilizing agents. More specifically, they include salicylate-based ones such as p-t-butylphenyl salicylate and p-octylphenyl salicylate; benzophenone-based ones such as 2,4-dihydroxy-benzophenone, 2-hydroxy-4-methoxy benzophenone, 2-hydroxy-4-methoxy-5-sulfo-benzophenone, 2,2',4,4'-tetrahydroxy benzophenone, and bis (2-methoxy-4-hydroxy-5-benzoyl-phenyl) methane; benzotriazole-based ones such as 2-(2'-hydroxy-5'-methylphenyl) benzotriazole, 2-(2'-hydroxy-5'-methylphenyl) benzotriazole, and 2,2'-methylene-bis[4-(1,1,3,3-tetramethylbutyl)-6-(2H-benzotri azol-2-yl) phenol]; cyanoacrylate-based ones such as ethyl-2-cyano-3,3'-diphenyl acrylate; triazine-based ones such as 2-(4,6-diphenyl-1,3,5-triazine-2-yl)-5-[(hexyl) oxy]-phenol; hindered amine-based ones such as bis(2,2,6,6-tetramethyl-4-piperidyl) sebacate, and polycondensates of dimethyl succinate and 1-(2-hydroxyethyl)-4-hydroxy-2,2,6,6-tetramethylpiperidine; and others such as nickel bis(octylphenyl) sulfide and 2,4-di-t-butyl-phenyl-3'5'di-t-butyl-4'-hydroxy benzoate. Of these ultraviolet ray absorbing agents, triazine-based ultraviolet ray absorbing agents are preferred from the viewpoint of their high resistance to repeated absorption of ultraviolet ray. It should be noted that these ultraviolet ray absorbing agents may be added singly to layer A, or introduced in the form of a copolymer of an organic conductive material or a water-insoluble resin combined with a monomer that has an ultraviolet ray absorbing function.

Examples of said inorganic ultraviolet ray absorbing agents include metal oxides such as titan oxide, zinc oxide, and cerium oxide, and carbon-based materials such as carbon, fullerene, carbon fiber, and carbon nanotube. It should be noted that these ultraviolet ray absorbing agents may be added singly to layer A, may serve also as said inorganic conducive material, or may be introduced into said organic conductive material or water-insoluble resin.

Furthermore, the above ultraviolet ray absorbing agents may be used singly or in combination with one or more thereof, and inorganic and organic compounds may be used in combination.

The content of said ultraviolet ray absorbing agent in layer A of the solar cell backsheet film according to the present invention is preferably not less than 0.05% by mass and not more than 20% by mass, more preferably not less than 0.1% by mass and not more than 15% by mass, and still more preferably not less than 0.15% by mass and not more than 15% by mass, of the total solid components of said layer A, in case where it is an organic ultraviolet ray absorbing agent. If the content of the ultraviolet ray absorbing agents is less than 0.05% by mass, it is not preferred because the light resistance is insufficient and layer A may become so deteriorated that the partial electrical discharge voltage is reduced in a long-term use, while if the content is more than 20% by mass, coloring of layer A may become significant.

In the case of inorganic ultraviolet ray absorbing agents, their content is preferably not less than 1% by mass and not more than 50% by mass, more preferably not less than 2% by mass and not more than 45% by mass, still more preferably not less than 5% by mass and not more than 40% by mass, particularly preferably not less than 8% by mass and not more than 35% by mass, and most preferably not less than 12% by mass and not more than 30% by mass, of the total solid components in layer A. In the case of these inorganic ultraviolet ray absorbing agents, if the content of the ultraviolet ray absorbing agents is less than 1% by mass, it is not preferred because the light resistance is insufficient and layer A may become so deteriorated that the partial electrical discharge voltage is reduced in a long-term use, while if the content is more than 50% by mass, the strength of layer A may be reduced.

In layer A of the solar cell backsheet film according to the present invention, light resistance can be developed without coloring of layer A and reduction in the strength of layer A by controlling the content of these ultraviolet ray absorbing agents in the range of not less than 0.05% by mass and not more than 20% by mass of the total solid components of layer A in the case where an organic ultraviolet ray absorbing agent is used, and in the range of not less than 1% by mass and not more than 50% by mass in the case where an inorganic ultraviolet ray absorbing agent is used.

The thickness of layer A is preferably not less than 0.001 $\mu$m and not more than 50 $\mu$m. It is generally preferable that the thickness is not less than 0.01 $\mu$m and not more than 50 $\mu$m if the material to constitute layer A comprises an organic material as'the main component and is subjected to a coating process to form said layer A, while in particular, if the base layer (layer B) comprises a film stretched uniaxially or biaxially and is produced simultaneously with the formation of said layer A, it is preferably in the range of not less than 0.01 $\mu$m and not more than 1 $\mu$m, more preferably in the range not less than 0.02 $\mu$m and not more than 1 $\mu$m, and still more preferably in the range not less than 0.05 $\mu$m and not more than 1 $\mu$m, from the viewpoint of formability and uniformity of layer A. If the material to constitute layer A comprises an inorganic material as main component, the thickness is preferably not less than 0.001 $\mu$m and not more than 1 $\mu$m, and in particular, it is preferably not less than 0.005 $\mu$m and not more than 0.8 $\mu$m, more preferably not less than 0.01 $\mu$m and not more than 0. 5 $\mu$m from the viewpoint the formation process controllability and uniformity of said layer A in the case where the layer is formed by a dry method such as evaporation and sputtering a s described below. Controlling the thickness of layer A in the aforementioned range serves to improve the partial electrical discharge voltage, formability and uniformity of layer A at the same time.

When it is desired to increase durability of layer A against ultraviolet rays, it is preferable to increase the thickness of layer A, and in that case, it is preferable to form layer A by melt extrusion. The preferable thickness of layer A in that case is not less than 0.05 $\mu$m and not more than 50$\mu$m. It is more preferably not less than 1 $\mu$m and not more than 50 $\mu$m, still more preferably not less than 2 $\mu$m and not more than 30 $\mu$m, particularly preferably not less than 3 $\mu$m and not more than 20 $\mu$m, and most preferably not less than 3 $\mu$m and not more than 15 $\mu$m. Controlling the thickness of layer A within the aforementioned range serves for enhancing the durability in addition to improving the partial electrical discharge voltage, formability and uniformity of layer A.

The usable materials for the base layer (layer B) in the solar cell backsheet film according to the present invention include organic film base materials such as polyester resins, polyolefin resins, acrylic resins, polyamide resins, polyimide resins, polyether-based resins, and polycarbonate-based resins; metal base materials such as silicon, glass, stainless steel, aluminum, aluminum alloy, iron, steel, and titaniun; inorganic base materials such as concrete; organic/inorganic composite base materials such as silicon-based resins; and combinations thereof; but they preferably contain organic components and have flexibility from the viewpoint of handleability and light weight. More preferably, a thermoplastic resin is used as the main component. Usable examples of said thermoplastic resin include polyester-based resins such as polyethylene terephthalate, polyethylene-2,6-naphtalate, polypropylene terephthalate, polybutylene terephthalate, poly-1,4-cyclohexylene dimethylene terephthalate, and polylactic acid; polyolefin-based resins such as polyethylene, polystyrene, polypropylene, polyisobutylene, polybutene, and polymethyl pentene; and others such as cycloolefin-based resins, polyamide-based resins, polyimide-based resins, polyether-based resins, polyester amide based resins, polyether-ester-based resins, acrylic resins, polyurethane-based resins, polycarbonate-based resins, polyvinyl chloride-based resin, and fluorinate-based resins. In particular, because of the diversity of useful monomers for copolymerization and the resulting easiness in adjustment of material properties, it is preferable that the layer mainly comprises a thermoplastic resin selected from the group of polyester-based resins, polyolefin-based resins, cycloolefin-based resins, polyamide-based resins, acrylic resins, fluorinate-based resins, and mixtures thereof. It is particularly preferable that it mainly comprises a polyester-based resin from the viewpoint of mechanical strength and cost.

Furthermore, these resins may be homogeneous resins, copolymers, or blended reins, but if the resin used for layer B is a polyester resin, its main repeating units are preferably selected from the group of ethylene terephthalate, ethylene-2,6-naphthalene dicarboxylate, propylene terephthalate, butylene terephthalate, 1,4-cyclohexylene dimethylene terephthalate, ethylene-2,6-naphthalene dicarboxylate, and mixtures thereof. With respect to the main repeating unit referred to here, the total of the above repeating units preferably accounts for not less than 70 mol%, more preferably not less than 80 mol%, and still more preferably not less than 90 mol%, of the total repeating units contained in the polyester resin from the viewpoint of mechanical strength and thermal resistance.

Furthermore, ethylene terephthalate, ethylene-2,6-naphthalene dicarboxylate, and mixtures thereof are preferably the main components from the viewpoint of low cost availability as well as easier polymerization and higher thermal resistance. In this case, a lower-cost, general-purpose, moist heat resistant film can be obtained when ethylene terephthalate accounts for a large content, and a film with superior moist heat resistance is produced when ethylene-2,6-naphthalene dicarboxylate accounts for a large content.

Layer B needs to contain a layer (layer B1) comprising polyester from the viewpoint of thermal resistance and mechanical strength. Said polyester that constitutes layer B1 is preferably selected from those polyester described above.

Furthermore, it is necessary that the weight average molecular weight Mw1 of the polyester that constitutes layer B1 is not less than 37,500 and not more than 60, 000. The weight average molecular weight referred to herein is determined by gel permeation chromatography. Specifically, a molecular weight calibration curve is prepared by using PET-DMT (standard grade) and a value is determined based on this molecular weight calibration curve.

More specifically, using a GCP-244 gel permeation chromatograph (manufactured by Waters Corporation) equipped with two Shodex HFIP 806M columns (manufactured by Showa Denko K.K.) and a RI type refractive index detector (Model 2414, sensitivity 256, manufactured by Waters Corporation), GPC measurements are made with PET-DMT (standard grade) at room temperature ($23°C$) and a flow rate of 0.5 ml/min. The measurements of the elution volume (V) and molecular weight (M) thus obtained are used to calculate the factor $A_1$ of the three-order approximation formula given as formula (2) below, followed by drawing a calibration curve.

$$\text{Log (M)} = A_0 + A_1\ V + A_2\ V^2 + A_3\ V^3 \qquad (2)$$

Next, hexafluoropropanol (0.005 N sodium trifluoroacetate) is used as a solvent to prepare a solution in which the material of layer B1 is dissolved so that it accounts for 0.06% by mass, and this solution is applied to GPC measurement. The measurement conditions may be set up appropriately, but the description here is based on values obtained at an injection quantity of 0.300 ml and a flow rate of 0.5 ml/min.

The elution-based molecular weight curve thus measured and the molecular weight calibration curve are superimposed to determine a molecular weight for each efflux time zone, and the value calculated by the following formula (3) is taken as weight average molecular weight.

$$\text{Weight average molecular weight (Mw)} = \Sigma(\text{Ni}\cdot\text{Mi}^2)\ /\ \Sigma(\text{Ni}\cdot\text{Mi}) \qquad (3)$$

(where Ni is molar fraction, and Mi is the molar at different weight at each elution points of the GPC curve determined based on the molecular weight calibration curve.)

If organic fine particles, inorganic fine particles, metals, metal salts, and other additives insoluble in the solvent were found to be contained in layer B1 material to be applied to the measurement, such insoluble components were removed by filtration with a filter or centrifugal separation, followed by readjustment of the solution, to obtain the measurements used herein. Furthermore, in the case where additives such as plasticizing agents, surface acting agents, and dyes were likely to be contained in the material for layer B1, the insoluble components were removed first, and then said insoluble additives were removed as in the above case by methods such as reprecipitation, recrystallization, chromatography, and extraction, followed by readjustment of the solution and implementation of measurement.

In the solar cell backsheet film according to the present invention, the weight average molecular weight of layer B is preferably not less than 37, 500 and not more than 60, 000, more preferably not less than 38,500 and not more than 58,000, and still more preferably not less than 40,000 and not more than 55, 000. If the weight average molecular weight of the polyester resin that constitutes layer B1 is less than 37,500, it is not preferable because the layer can be low in moist heat resistance and suffer hydrolysis over long-term use, resulting in a reduction in mechanical strength. If it exceeds 60,000, it is not preferable because it is difficult to perform polymerization, and even if polymerization is possible, it will be difficult to extrude the resin from an extruder, making it difficult to produce a film. In the solar cell backsheet film according to the present invention, both film-forming property and hydrolysis resistance can be maintained if the weight average molecular weight of layer B1 in layer B is controlled within the range from 37,500 to 60,000.

If the base layer (layer B) has a layered structure, measurements are obtained from samples containing layer B1 alone that is prepared by peeling the other layers or polishing the film while observing it with a microscope.

Furthermore, the number average molecular weight of the polyester that constitutes layer B1 is preferably not less than 8,000 and not more than 40, 000. The number average molecular weight referred to herein is calculated by the following formula (4) from molecular weight values corresponding to different efflux times determined from the weight average molecular weight measurement described above.

$$\text{Number average molecular weight (Mn)} = \Sigma(Ni \cdot Mi) \,/\, \Sigma(Ni) \tag{4}$$

(where Ni is molar fraction, and Mi is the molar at different weight at each elution points of the GPC curve determined based on the molecular weight calibration curve.)

For the solar cell backsheet film according to the present invention, the number average molecular weight of layer B1 is preferably not less than 9,500 and not more than 40,000, still more preferably not less than 10,000 and not more than 40,000, still more preferably not less than 10,500 and not more than 40,000, still more preferably not less than 11,000 and not more than 40,000, still more preferably not less than 18,500 and not more than 40,000, still more preferably not less than 19,000 and not more than 35,000, and most preferably not less than 20,000 and not more than 33,000. If the number average molecular weight of the polyester resin to constitute layer B1 is less than 8,000, the layer is inferior in moist heat resistance and suffers hydrolysis in a long-term use, resulting in a reduction in mechanical strength. If it exceeds 40,000, it can be difficult to perform polymerization, and even if polymerization is possible, it will be difficult to extrude the resin from an extruder, making it difficult to produce a film. In the solar cell backsheet film according to the present invention, both film-forming property and hydrolysis resistance can be maintained if the number average molecular weight of layer B1 in layer B is controlled within the range from 8,000 to 40,000.

In the solar cell backsheet film according to the present invention, the intrinsic viscosity (IV) of the polyester of layer B1 is preferably not less than 0.65. It is more preferably not less than 0.68, still more preferably not less than 0.7, and particularly preferably not less than 0.72. If IV is less than 0.65, retaining the mechanical strength for a long term may be difficult. For the polyester film according to the present invention, controlling the IV of the polyester resin to constitute the polyester layer (layer P) at not less than 0.65 contributes to inhibiting reductions in mechanical strength over long-term use. It should be noted that there are no specific limitations on the upper limit of IV, but it is preferably not more than 1.0, more preferably not more than 0.9, because otherwise a long polymerization time will be required, leading to increased cost, and melt extrusion will be difficult to carry out.

In the solar cell backsheet film according to the present invention, layer B1 in layer B is preferably oriented in one or two directions. Extension can cause oriented crystallization which strengthens the mechanical strength, and improve hydrolysis resistance in the case of polyester-based resins. The degree of plane orientation which represents the degree of said orientation is preferably not less than 0.16. It is more preferably not less than 0.162, still more preferably not less than 0.165. If the degree of plane orientation is less than 0.16, the moist heat resistance may not improve in some cases. In the polyester film according to the present invention, controlling the degree of plane orientation at not less than 0.16 serves to achieve a high moist heat resistance.

In this case, the minute endothermic peak temperature TmetaB1 of layer B1 and the melting point TmB1 of layer B1 that are determined by differential scanning calorimetry (DSC) preferably satisfy the following formula (5).

$$40°C \leq TmB1 - TmetaB1 \leq 90°C \tag{5}$$

TmetaB1 and the melting point TmB1 of layer B1 referred to herein are values in the heating process (heating rate of 20°C/min) of differential scanning calorimetry (hereinafter referred to as DSC). Specifically, the material is heated (1st run) from 25°C to 300°C at a heating rate of 20°C/min according to JIS K-7121 (1999), retaining the state for five minutes, then quenching it to not more than 25°C, and raising the temperature again from room temperature to 300°C at a heating rate of 20°C/min to obtain the 1st run chart of differential scanning calorimetry, and the minute endothermic peak temperature before the crystal melting peak in the 1st run chart is taken as TmetaB1 while the peak-top temperature of the crystal melting peak in the 2nd run chart is taken as TmB1 of layer B1.

It is more preferably 50°C ≤ Tmb1-TmetaB1 ≤ 80°C, still more preferably 55°C ≤ TmB1-TmetaB1 ≤ 75°C. If the value of TmB1-TmetaB1 exceeds 90°C, the residual stress resulting from extension will not be removed adequately. As a result of this, the film can suffer large thermal contraction, and it can become difficult to apply the film in the application step when being incorporated into the solar cell, even if the film can be applied, the solar cell system can be warped as the film works at high temperatures after being incorporated in the solar cell. If the value of TmB1-TmetaB1 is less than 40°C, the degree of oriented crystallinity can decrease, leading to a poor hydrolysis resistance. For the solar cell backsheet film according to the present invention, maintaining layer B1 that constitutes layer B in the state of 40°C≤ TmB1-TmetaB1 ≤ 90°C allows the film-forming property and hydrolysis resistance to be achieved simultaneously.

Furthermore, in the solar cell backsheet film according to the present invention, TmetaB1 of layer B1 that constitutes layer B is preferably not less than 160˚C and not more than the value of TmB1-40˚C (subject to TmB1-40˚C > 160˚C). More preferably, it is not less than 170˚C and not more than the value of TmB1-50˚C (subject to TmB1-50˚C > 170˚C), and still more preferably not less than 180˚C and not more than the value of TmB1-55˚C (subject to TmB1-55˚C > 180˚C) . In cases where TmetaB1 is less than 160˚C, the thermal resistance of the film will be low, and the durability of the resulting backsheet may decrease.

In the solar cell backsheet film according to the present invention, the melting point TmB1 of layer B1 that constitutes layer B is preferably not less than 220˚C, more preferably not less than 240˚C, and still more preferably not less than 250˚C, from the viewpoint of heat resistance. There are no specific limitations on the upper limit to the melting point TmB1 of layer B1, but it is preferably not more than 300˚C from the viewpoint of productivity.

In the solar cell backsheet film according to the present invention, the number of the carboxylic acid end groups in layer B1 that constitutes layer B is preferably not more than 20 eq/t, more preferably not more than 15 eq/t, still more preferably not more than 13 eq/t, and particularly preferably not more than 10 eq/t. If it exceeds 15 eq/t, hydrolysis caused by the catalytic action of the protons in the carboxylic acid end groups can be promoted to accelerate the degradation. The number of the carboxylic acid end groups can be controlled at not more than 20 eq/t by, for instance, the following methods: 1) the dicarboxylic acid components and the diol components are esterified and melt-polymerized, and when the material reaches a predetermined melt viscosity, it is discharged into strands, which are cut into chips and subjected to solid phase polymerization; 2) a buffering agent is added during the period from the completion of ester exchange reaction or esterification reaction to the early stage of polycondensation reaction (where the intrinsic viscosity is less than 0.3); 3) a buffering agent, end-sealing agent, etc., are added during the molding process; and a combination of these methods.

In the solar cell backsheet film according to the present invention, the polyester that constitutes layer B1 preferably contains a buffering agents in the range from not less than 0.1 mol/t to not more than 5.0 mol/t. Said buffering agent for the present invention is a substance that is soluble in the diol residue component of the polyester that constitutes layer B1, such as ethylene glycol, and dissociated to show ionic characteristics after being dissolved. In the solar cell backsheet film according to the present invention, adding a buffering agent to the polyester that constitutes layer B1 contributes to further reducing the number of carboxyl acid end groups in the early stage, and inhibiting the hydrolysis reaction. Furthermore, the protons that are contained in the carboxyl end groups newly formed from the hydrolysis reaction and that work as catalysis of the hydrolysis reaction can be neutralized to inhibit the hydrolysis reaction, serving to further reduce the hygrothermal degradation of the polyester film.

Said buffering agent is preferably a alkali metal salt from the viewpoint of polymerization reactivity and moist heat resistance, and thus examples of said buffering agent include alkali metal salts formed from compounds such as phthalic acid, citric acid, carbonic acid, lactic acid, tartaric acid, phosphoric acid, phosphorous acid, hypophosphoric acid, and polyacrylic acid. In particular, the alkali metal element is preferably potassium or sodium from the viewpoint of slow growth of deposits from the catalyst residue, and specific examples include potassium hydrogen phthalate, sodium dihydrogen citrate, disodium hydrogen citrate, potassium dihydrogen citrate, dipotassium hydrogen citrate, sodium carbonate, sodium tartrate, potassium tartrate, sodium lactate, potassium lactate, sodium hydrogen carbonate, disodium hydrogen phosphate, dipotassium hydrogen phosphate, potassium dihydrogen phosphate, sodium dihydrogen phosphate, sodium hydrogen phosphite, potassium hydrogen phosphite, sodium hypophosphite, potassium hypophosphite, and sodium polyacrylate.

Furthermore, it is preferably an alkali metal salt represented by the following formula from the viewpoint of polymerization reactivity of the polyester that constitutes layer B1 and the thermal resistance during the melting/molding process, and it is more preferable that the alkali metal is sodium and/or potassium from the viewpoint of polymerization reactivity, heat resistance and moist heat resistance, still more preferable that the metal salt comprises phosphoric acid and sodium and/or potassium from the viewpoint of polymerization reactivity and moist heat resistance.

$$PO_xH_yM_z \qquad (I)$$

(where x represents an integer of 2 to 4, y either 1 or 2, z either 1 or 2, and M an alkali metal.)

The content of the buffering agent is preferably not less than 0.1 mol/t and not more than 5.0 mol/t of layer B1 that constitutes layer B. More preferably, it is not less than 0.3 mol/t and not more than 3.0 mol/t. If the content is less than 0.1 mol/t, a sufficient moist heat resistance cannot be obtained, and hydrolysis gradually proceeds over long-term use, causing deterioration in mechanical characteristics. If the content exceeds 5.0 mol/t, the molecular weight is reduced to causes a decrease in moist heat resistance and mechanical characteristics because excess alkali metal works to accelerate decomposition.

The buffering agent may be added during the polymerization of the polyester that constitutes layer B1 in layer B or during the melting/molding process, but it is more preferable to add the agent during polymerization from the viewpoint of uniform dispersion of the buffering agent in the film. If the agent is added during polymerization, it may be added at any appropriate time during the period after the completion of the esterification or ester exchange reaction in the polyester polymerization duration to the early stages of the polycondensation reaction (where the intrinsic viscosity is less than 0.3) . As the method of adding the buffering agent, powder may be directly added, or a solution prepared by dissolving the agent in the diol component such as ethylene glycol is added, but it is more preferable to add it as a solution prepared by dissolving it in the diol component such as ethylene glycol. In this case, it is preferable that the solution is diluted to a concentration of not more than 10% by mass from the viewpoint of a smaller amount of the buffering agents left adhered around the feed port, a smaller error in feed rate, and an increase in reactivity.

In the solar cell backsheet film according to the present invention, the polyester that constitutes layer B1 preferably contains an end-sealing agent in the range from not less than 0.1% by mass to not more than 10% by mass. The end-sealing agent referred to herein is a compound having a substituent group that can react with the carboxyl end group at the end of polyester, and examples of said substituent group include compounds having a carbodiimide group, epoxy group, or an oxazoline group.

The carbodiimide-based compounds having a carbodiimide group include monofunctional carbodiimides and multifunctional carbodiimides, and the monofunctional carbodiimides include dicyclohexyl carbodiimide, diisopropyl carbodiimide, dimethyl carbodiimide, diisobutyl carbodiimide, dioctyl carbodiimide, t-butylisopropyl carbodiimide, diphenyl carbodiimide, di-t-butyl carbodiimide, and di-β-naphthyl carbodiimide. Particularly preferred are dicyclohexyl carbodiimide and diisopropyl carbodiimide. As the multifunctional carbodiimides, carbodiimides with a polymerization degree in the range from 3 to 15 are preferred. Specifically, examples include 1,5-naphthalene carbodiimide, 4,4'-diphenylmethane carbodiimide, 4,4'-dimethyldimethylmethane carbodiimide, 1,3-phenylene carbodiimide, 1,4-phenylene diisocyanate, 2,4-tolylene carbodiimide, 2,6-tolylene carbodiimide, mixtures of 2,4-tolylene carbodiimide and 2,6-tolylene carbodiimide, hexamethylene carbodiimide, cyclohexane-1,4-carbodiimide, xylylene carbodiimide, isophorone carbodiimide, isophorone carbodiimide, dicyclohexylmethane-4,4'-carbodiimide, methylcyclohexane carbodiimide, tetramethylxylylene carbodiimide, 2,6-diisopropylphenyl carbodiimide, and 1,3,5-triisopropylbenzene-2,4-carbodiimide.

Preferable examples of said epoxy compound include glycidyl ester based compounds and glycidyl ether based compounds. Examples of said glycidyl ester based compounds include glycidyl benzoate, glycidyl t-Bu-benzoate, glycidyl p-toluate, glycidyl cyclohexane carboxylate, glycidyl pelargonate, glycidyl stearate, glycidyl laurate, glycidyl palmitate, glycidyl behenate, glycidyl versatate, glycidyl oleate, glycidyl linoleate, glycidyl linoleate, glycidyl behenolate, glycidyl stearolate, diglycidyl terephthalate, diglycidyl isophthalate, diglycidyl phthalate, diglycidyl naphthalene dicarboxylate, diglycidyl methyl terephthalate, diglycidyl hexahydrophthalate, diglycidyl tetrahydrophthalate, diglycidyl cyclohexane dicarboxylate, diglycidyl adipate, diglycidyl succinate, diglycidyl sebacate, diglycidyl dodecanedioate, diglycidyl octadecane dicarboxylate, triglycidyl trimellitate, and tetraglycidyl pyromellitate, which can be used singly or in combination with one or more thereof. Examples of said glycidyl ether include phenyl glycidyl ether, o-phenyl glycidyl ether, 1,4-bis-(β,γ-epoxypropoxy) butane, 1,6-bis-(β,γ-epoxypropoxy) hexane, 1,4-bis-(β,γ-epoxypropoxy) benzene, 1-(β,γ-epoxypropoxy)-2-ethoxy-ethane, 1-(β,γ-epoxypropoxy)-2-benzyloxy ethane, 2,2-bis-[p-(β,γ-epoxypropoxy)phenyl] propane, and 2,2-bis-(4-hydroxyphenyl) propane, as well as bisglycidyl polyethers produced through a reaction of a bisphenol, such as 2,2-bis-(4-hydroxyphenyl) methane, and epychlorohydrin. These may be used singly or in combination.

Said oxazoline compound is preferably a bisoxazoline based compound, and specific examples include 2,2'-bis-(2-oxazoline), 2,2'-bis-(4-methyl-2-oxazoline), 2,2'-bis-(4,4-dimethyl-2-oxazoline), 2,2'-bis-(4-ethyl-2-oxazoline), 2,2'-bis-(4,4'-diethyl-2-oxazoline), 2,2'-bis-(4-propyl-2-oxazoline), 2,2'-bis-(4-butyl-2-oxazoline), 2,2'-bis-(4-hexyl-2-oxazoline), 2,2'-bis-(4-phenyl-2-oxazoline), 2,2'-bis- (4-cyclohexyl-2-oxazoline), 2,2'-bis- (4-benzyl-2-oxazoline), 2,2'-p-phenylene-bis-(2-oxazoline), 2,2'-m-phenylene-bis-(2-oxazoline), 2,2'-o-phenylene-bis- (2-oxazoline), 2,2'-p-phenylene-bis-(4-methyl-2-oxazoline), 2,2'-p-phenylene-bis-(4,4-dimethyl-2-oxazoline), 2,2'-m-phenylene-bis-(4-methyl-2-oxazoline), 2,2'-m-phenylene-bis-(4,4-dimethyl-2-oxazoline), 2,2'-ethylene-bis-(2-oxazoline), 2,2'-tetramethylene-bis-(2-oxazoline), 2,2'-hexamethylene-bis-(2-oxazoline), 2,2'-octamethylene-bis-(2-oxazoline), 2,2'-decamethylene-bis-(2-oxazoline), 2,2'-ethylene-bis-(4-methyl-2-oxazoline), 2,2'-tetramethylene-bis-(4, 4-dimethyl-2-oxazoline), 2,2'-9,9'-diphenoxylethane-bis-(2-oxazoline), 2,2'-cyclohexylerie-bis-(2-oxazoline), and 2,2'-diphenilenebis-(2-oxazoline), of which 2, 2' -bis- (2-oxazoline) is the most preferable from the viewpoint of the reactivity with polyester. These may be used singly or in combination.

In the solar cell backsheet film according to the present invention, the content of the end-sealing agent in the polyester that constitutes layer B1 is more preferably 0.3% by mass and 8% by mass, still more preferably not less than 0.5% by mass and not more than 5% by mass, and particularly preferably 0.5% by mass and 2% by mass. If the end-sealing agent accounts for less than 0.1% by mass, it is not preferred because the effect of sealing the carboxyl end group may not be developed. If the end-sealing agent accounts for more than 10% by mass, on the other hand, foreign objects or decomposed gases may be generated during formation of the film to make film formation difficult, and even if film formation is possible, the resulting film may have a reduced thermal resistance. For the solar cell backsheet according to the present invention, controlling the content of the end-sealing agents at not less than 0.1% by mass and not more than 10% by mass allows the moist heat resistance to improve without a reduction in thermal resistance.

In the solar cell backsheet film according to the present invention, when polyester that constitutes layer B1 is added with carbodiimide based compounds as end-sealing agents, the compounds are preferably added so as to control the content of nitrogen in layer B1 at less than 0.01% by mass and not more than 0.5% by mass for film forming. More preferably, it is not less than 0.05% by mass and not more than 0.3% by mass, and further preferably not less than 0.08% by mass and not more than 0.2% by mass. If nitrogen accounts for less than 0.01% by mass, it is not preferred because the effect of sealing the carboxyl end group may not be developed. If nitrogen accounts for more than 0.5% by mass, on the other hand, foreign objects or decomposed gases may be generated during formation of the film to make film formation difficult, and even if film formation is possible, the resulting film may have a reduced thermal resistance. For the solar cell backsheet according to the present invention, controlling the content of nitrogen in layer B1 at not less than 0.01% by mass and not more than 0.5% by mass allows the moist heat resistance to further improve without a reduction in thermal resistance.

In the solar cell backsheet film according to the present invention, layer B1 that constitutes layer B may contain other additives as needed, as long as they do not impair the effect of the present invention. Such additives include thermal stabilizing agents, oxidation resistant stabilizing agents, ultraviolet ray absorbing agents, ultraviolet ray stabilizing agents, organic/inorganic lubricating agents, organic/inorganic fine particles, filling agents, nucleating agents, dyes, dispersing agents, and coupling agents, as well as air bubbles. For example, it is preferable to develop reflectivity on layer B1 in order to increase the power generation efficiency of the solar cell, and to this end, the layer may contain organic/inorganic fine particles and air bubbles. For coloring the layer to improve appearance, color materials of the desired color may be added.

In the solar cell backsheet film according to the present invention, the base layer (layer B) may be composed only of layer B1 that meets the aforementioned requirements, or otherwise, may have a layered construction with another layer (layer B2) . Furthermore, the film thickness is preferably not less than 10 $\mu$m and not more than 500 $\mu$m, more preferably not less than 20 $\mu$m and not more than 300 $\mu$m. It is still more preferably not less than 25 $\mu$m and not more than 200 $\mu$m. If the thickness is less than 10 $\mu$m, it is difficult to maintain film flatness. If the thickness is more than 500 $\mu$m, on the other hand, the thickness can be too large for use in a solar cell.

In the solar cell backsheet film according to the present invention, if the base layer (layer B) has a layered construction containing layer B1, the thickness of layer B1 accounts for preferably not less than 20%, more preferably not less than 30%, and still more preferably not less than 50%, of the entire thickness of layer B. If the thickness is less than 20%, the moist heat resistance may be too low.

In the solar cell backsheet film according to the present invention, the base layer (layer B) may be further provided with a layer (layer C) having other functions such as an adhesion improving layer for improvement of the contact with layer A, other sheet materials or an ethylene vinyl acetate layer that contains generating elements, a hard coat layer for increasing the shock resistance, an ultraviolet ray resistant layer for increasing the ultraviolet ray resistance, or a flame resistant layer for developing flame resistance.

In the solar cell backsheet film according to the present invention, layer B1 and/or layer B2 that constitute the base layer (layer B) preferably contain air bubbles. Containing air bubbles allows the base layer to have a low dielectric constant, and consequently allows the partial electrical discharge voltage to be further improved. The content of air bubbles is preferably not less than 10% by volume, more preferably not less than 20% by volume, and still more preferably not less than 30% by volume. There is no specific upper limit, but the film is easily cleaved if the content is 80% by volume or more, possibly leading to a reduction in the mechanical strength of the backsheet film.

Next, a typical method of manufacturing the solar cell backsheet film will be described below with reference to Examples, but it should be understood that the invention is not construed as being limited thereto.

First, with respect to the method of manufacturing materials to constitute the base layer (layer B), a polyester-based resin can be produced as follows.

For the method of manufacturing a solar cell backsheet film according to the present invention, resins to be used as input material can be obtained by using a known method to carry out ester exchange reaction of aliphatic dicarboxylic acids such as malonic acid, succinic acid, glutaric acid, adipic acid, suberic acid, sebacic acid, dodecanedioic acid, dimer acid, eicosandioic acid, pimelic acid, azelaic acid, methylmalonic acid, and ethyl malonate; alicyclic dicarboxylic acids such as adamantane dicarboxylic acid, norbornene dicarboxylic acid, isosorbide, cyclohexane dicarboxylic acid, and decane dicarboxylic acid; dicarboxylic acids such as terephthalic acid, isophthalic acid, phthalic acid, 1,4-naphthalene dicarboxylic acid, 1,5-naphthalene dicarboxylic acid, 2,6-naphthalene dicarboxylic acid, 1,8-naphthalene dicarboxylic acid, 4,4'-diphenyl dicarboxylic, 4,4'-diphenyl ether dicarboxylic acid, 5-sodium sulfoisophthalic acid, phenylindane dicarboxylic acid, anthracene dicarboxylic acid, phenanthrene dicarboxylic acid, 9,9'-bis(4-carboxylphenyl) fluorensic acid ; or ester derivatives thereof; with aliphatic diols such as ethylene glycol, 1,2-propanediol, 1,3-propanediol, 1,4-butanediol, 1,2-butanediol, and 1,3-butanediol; alicyclic diols such as cyclohexane dimethanol, spiroglycol, and isosorbide; aromatic diols such as bisphenol A, 1,3-benzene dimethanol, 1,4-bensen dimethanol, and 9,9'-bis(4-hydroxyphenyl) fluorine, or other diols. The conventionally known catalysts for the reaction include alkali metal compounds, alkali earth metal compounds, zinc compounds, lead compounds, manganic compounds, cobalt compounds, aluminum compounds, antimony compounds, titanic compounds, and phosphorus compounds. It is preferable that an antimony compound, germanium compound, or titanium compound may be added as a polymerization catalyst commonly at an appropriate stage before the completion of the polyester resin production step. In the case of using a germanium compound, for example, for such a method, it is preferable that powder of the germanium compound is added directly.

In the case of using a germanium compound, for example, for this method, it is preferable that powder of the germanium compound is added directly. In the case of using an antimony compound and/or germanium compound as polymerization catalysts, it is preferable that their content as the antimony element or the germanium element is not less than 50 ppm and not more than 300 ppm in point of polycondensation reaction and solid polymerization reaction, and further preferably not less than 50 ppm and not more than 200 ppm from the viewpoint of the thermal resistance and moist heat resistance. If the content exceeds 300 ppm, the polycondensation reactivity and solid polymerization reactivity do improve, but the decomposition reaction during the re-melting is also promoted to increase the number of carboxylic acid end groups, possibly leading to a decrease in the thermal resistance and moist heat resistance. The antimony compounds and germanium compounds that are favorably used include antimony pentoxide, antimony trioxide, and germanium dioxide, of which appropriate ones may be selected to meet the purpose. For example, germanium compounds can serve most effectively for coloring, while antimony compounds can increase the polymerization reactivity effectively. In the case of adopting a non-antimony-based compound for the manufacturing process in consideration of environmental effects, it is preferable to use a titanium catalyst from the viewpoint of increasing the polycondensation reactivity and solid polymerization reactivity.

If titanium compounds are used as polycondensation catalyst, their content as the titanium element is preferably controlled at not less than 0.1 ppm and not more than 20 ppm from the viewpoint of polycondensation reactivity and solid polymerization reactivity. If the content of the titanium element exceeds 20 ppm, the polycondensation reactivity and solid polymerization reactivity do improve, but the content may cause a deterioration in thermal resistance and moist heat resistance as well as color. Materials used as said titanium catalyst for polycondensation include alkoxides such as tetrabutoxy titanate and tetraisopropyl titanate, and titanium chelate compounds produced from titanium with lactic acid or citric acid, of which titanium chelate compounds are preferably used from the viewpoint of the thermal resistance, moist heat resistance, and color.

If titanium compounds are used as polycondensation catalyst, it is preferable to use non-phosphorous-based buffering agents such as potassium hydrogen phthalate, disodium hydrogen citrate, sodium dihydrogen citrate, potassium dihydrogen citrate, dipotassium hydrogen citrate, sodium carbonate, sodium tartrate, potassium tartrate, sodium lactate, potassium lactate, and sodium hydrogen carbonate, from the viewpoint of increasing the moist heat resistance while maintain the polycondensation reactivity and solid polymerization reactivity. Furthermore, if a compound as represented by the following formula (1) is used as buffering agent, it is preferable for the buffering agent to be added not less than five minutes before or not less than five minutes after the addition of the titanium compound, from the viewpoint of increasing the moist heat resistance while maintain the polycondensation reactivity and solid polymerization reactivity.

$$POxHyMz \qquad (I)$$

where x denotes an integer from 2 to 4, y either 1 or 2, z either 1 or 2, and M an alkali metal.

Said esterification reaction and polycondensation reaction can be executed by conventional methods, and it is preferable that phosphoric acid and phosphates used as thermal resistant stabilizing agent, and antimony compounds, germanium compounds, and titanium compounds used as polycondensation catalysts are added during the period from the end of the esterification reaction to the early stage of the polycondensation (intrinsic viscosity of less than 0.3). If a buffering agent is to be added during the polymerization step, then that buffering agent is also preferably added during this period. With respect to the order of addition, it is preferable that they are added in the order of the thermal resistant stabilizing agents, polycondensation catalysts, and buffering agents at intervals of not less than five minutes; from the viewpoint of polycondensation reactivity and moist heat resistance.

If end-sealing agents are to be added to the polyester material that constitutes layer B1, it is preferable to use master chips which are produced in advance by evenly melt-kneading the materials with the agents, or to feed it directly into the melt-kneading extruder. For the present invention, however, it is preferable to use master batches which are prepared in advance by melt-kneading in a twin screw extruder, or to form a film immediately following the melt-kneading in a twin screw extruder from the viewpoint of dispersion of the end-sealing agents.

In order to control the weight average molecular weight of polyester that constitutes layer B1 at not less than 37, 500 and not more than 60, 000, it is preferable that the input material to be used is chips prepared by solid phase polymerization as follows: a polyester-based resin with a common molecular weight, i.e. about 36, 000 in terms of weight average molecular weight, is polymerized first, and then heated at a temperature not less than 190˚C and not more than the melting point of thermoplastic resins under reduced pressure or in a flow of an inert gas such as nitrogen gas. Furthermore, in order to control the number average molecular weight of polyester that constitutes layer B1 at not less than 18, 500 and not more than 40, 000, it is preferable that a polyester-based resin with a common molecular weight, i.e. about 18, 000 in terms of number average molecular weight, is polymerized first, and then heated at a temperature not less than 190˚C and not more than the melting point of thermoplastic resins under reduced pressure or in a flow of an inert gas such as nitrogen gas (solid phase polymerization), followed by extrusion with a short retention time in a nitrogen atmosphere. The method is preferable from the viewpoint of increasing the weight average molecular weight and the number average molecular weight, without increasing the carboxyl end groups in the thermoplastic resins.

Next, for the method of manufacturing a base layer (layer B) that comprises a single film composed only of layer B1, the input materials for layer B1 may be melted and heated in an extruder, and extruded from the orifice onto a cooled cast drum to produce a sheet (melt casting method). As another method, the input materials for layer B1 may be dissolved in a solvent, followed by extruding the solution onto a supporting body such as a cast drum and an endless belt to form a film-like material, and drying/removing the solvent from this film-like material to produce a sheet (solution casting method).

Methods of manufacturing layer B with a layered construction containing layer B1 are as follows. If the materials of each layer in the layered construction comprise a thermoplastic resin as the main component, the available methods include: feeding two different thermoplastic resins into two extruders, melting these resins, and co-extruding them from the orifice onto a cooled cast drum to produce a sheet (co-extrusion method); preparing a single layer sheet in advance and feeding a coating material to an extruder, followed by melt extrusion from the orifice onto the sheet to produce a laminate (melt laminating method); preparing the material for layer B1 and the material for the layer separately and performing thermocompression bonding to produce a sheet using heated rolls (thermolaminating method); bonding the materials together with an adhesive agent (adhesion method); dissolving the materials for layer formation in a solvent, and applying the solution over layer B1 prepared in advance (coating method); as well as combinations of these methods.

Furthermore, in the case where the materials to be used for layers are not thermoplastic resins, the available methods include: preparing the material for layer B1 and the material for the layer separately and bonding the materials together with an adhesive agent (adhesion method) ; and in the case of a curable material, applying it over layer B1 and curing it by electromagnetic wave irradiation, heat treatment, etc.

If a uniaxially or biaxially stretched film base is adopted as the base layer (layer B) and/or layer B1 that constitutes layer B, it is produced by first feeding the input material into an extruder (multiple extruders in the case of a layered construction), melting it, extruding it from the orifice (co-extruding in the case of a layered construction), and solidifying it by bringing it electrostatically into close contact with a drum cooled to a surface temperature of not less than 10°C and not more than 60°C to achieve the formation of an unstretched film. This unstretched film is led to a group of rollers heated to a temperature of not less than 70°C and not more than 140°C, and stretched not less than 3 times and not more than 5 times in the length direction (longitudinal direction, i.e., the traveling direction of the film), followed by cooling between rolls controlled at not less than 20°C and not more than 50°C.

Then, both ends of the film are gripped with clips, led to a tenter, and stretched not less than 3 times and not more than 5 times in the direction perpendicular to its length direction (namely, width direction) in an atmosphere heated to a temperature of not less than 80°C and not more than 150°C. The draw ratio is set to not less than 3 times and not less than 5 times respectively in the length direction and the width direction; however, the area ratio (longitudinal draw ratio x transverse draw ratio) is preferably not less than 9 times and not more than 16 times, respectively. If the area ratio is less than 9 times, the film strength and moist heat resistance of the resulting biaxially stretched film will be insufficient, while the film is prone to break when stretched if the area ratio exceeds 16 times. To carry out the biaxial stretching, two methods are available and either may be used, namely, the sequential biaxial stretching method to stretch the material in the length direction and in the width direction separately, and the simultaneous biaxial stretching method to carry out the stretching in the length direction and the stretching in the width direction at the same time.

In order to complete crystal orientation of the resulting biaxially stretched film to make it highly flat and dimensionally stable, it is preferable that heat treatment is continued in the tenter so that the film is heated for not shorter than 1 second and not longer than 30 seconds at a temperature of Tg or more and less than the melting point of the resin material to be used as input material, and then cooled uniformly and slowly down to room temperature. If the heat treatment temperature Ts is low, heat shrinkage of the film is generally large, and therefore, the heat treatment temperature is preferably higher in order to enhance the dimensional stability at high temperatures. However, the crystallinity of oriented crystals becomes lower as the heat treatment temperature becomes too high, and as a result, the film formed may be inferior in hydrolysis resistance. Therefore, the heat treatment temperature Ts for the solar cell backsheet film according to the preset invention is preferably $40°C \leq TmB1-Ts \leq 90°C$. It is more preferably $50°C \leq TmB1-Ts \leq 80°C$, and still more preferably $55°C \leq TmB1-Ts \leq 75°C$. Furthermore, the solar cell backsheet film according to the present invention is to be used as material for the backsheet of solar cells, and the atmosphere temperature may rise to around 100°C during its use, and thus it is preferable that the heat treatment temperature Ts is not less than 160°C and not more than TmB1-40°C (subject to TmB1-40°C > 160°C). It is more preferably not less than 170°C and not more than TmB1-50°C (subject to TmB1-50°C > 170°C), and still more preferably, the temperature Ts is not less than 180°C and not more than TmB1-55°C (subject to TmB1-55°C > 180°C) . It should be noted that controlling the temperature Ts serves to control the value of TmetaB1. During the above heat treatment process, the film may be relaxed by 3% to 12% in the width direction or the length direction as needed. Subsequently, corona discharge and other treatments are performed as needed in order to further increase the contact with other materials, and then the film is wound up to form the base layer of the solar cell backsheet film according to the present invention.

Next, the methods available for forming an electrically conductive layer (layer A) on the base layer (layer B) include dry methods such as vapor deposition and spattering; wet methods such as plating; the use of multiple extruders so that the material for layer A and the material for layer B are melted in different extruders and co-extruded from the orifice onto a cooled cast drum to produce a sheet (co-extrusion method); the preparation of a single layered base layer (layer B) in advance, followed by feeding the material for layer A to an extruder and melt-extruding it from the orifice onto the former layer to produce a laminate (melt laminating method); the preparation of the base layer (layer B) and layer A separately and subsequent thermocompression bonding between heated rolls etc. (thermolaminating method); bonding the layers together with an adhesive agent (adhesion method); dissolving the material for layer A in a solvent, and applying the solution over the base layer (layer B) prepared in advance (coating method); as well as combinations of these methods.

If layer A is composed mainly of organic materials, or if it is an organic/inorganic electrically conductive composite material that is, as described above, i) composed of an electrically nonconductive water-insoluble resin as matrix and an inorganic electrically conductive material as said electrically conductive material, ii) composed of an organic electrically nonconductive material and an inorganic electrically conductive material used in combination, or iii) composed of an organic electrically nonconductive material and an inorganic electrically nonconductive material used in combination, the co-extrusion method and the coating method are the preferred ones of those listed above because they serve to form layer A easily.[0097] The methods available for forming layer A on the base layer (layer B) by the co-extrusion method include using multiple extruders so that the material for layer B and/or layer B1 that constitutes layer B and the material for layer A are melted in different extruders, co-extruded from the orifice, solidified by bringing it electrostatically into close contact with a drum cooled to a surface temperature of not less than 10˚C and not more than 60˚C to achieve the formation of a sheet that is composed of layer A formed on layer B and/or layer B1 that constitutes layer B.

Furthermore, if the base layer (layer B) and/or layer B1 that constitutes layer B is a uniaxially or biaxially stretched film base material, said sheet that is composed of layer A laminated on the base layer (layer B) material and/or layer B1 that constitutes layer B may be produced by stretching by the same procedure as above.

Furthermore, the procedures for forming layer A on the base layer (layer B) and/or layer B1 that constitutes layer B with the coating method include carrying out the coating step simultaneously with the formation of the base layer (layer B) and/or layer B1 that constitutes layer B, namely, the in-line coating method and carrying out the coating step after the formation of the base layer (layer B) and/or layer B1 that constitutes layer B, namely, the off-line coating method, of which the in-line coating method is preferred because it is more efficient as it is performed simultaneously with the formation of the base layer (layer B) and/or layer B1 that constitutes layer B and also because a strong contact can be achieved between layer A and the base layer (layer B) and/or layer B1 that constitutes layer B. If the coating method is adopted, corona treatment is preferably performed on the base layer (layer B) and/or layer B1 that constitutes layer B, from the viewpoint of improving the wettability and adhesion of the coating liquid on the substrate.

The available means for carrying out said coating method to form layer A on the base layer (layer B) and/or layer B1 that constitutes layer B also include preparing a coating liquid by dissolving/dispersing said material to constitute layer A in a solvent and allying it over the base layer (layer B) and/or layer B1 that constitutes layer B, followed by drying. Any appropriate solution may be used for this, but for the in-line coating method in particular, it is preferable to use a solvent composed mainly of water from the viewpoint of maintaining safety. In this case, a small amount of water-soluble organic solvent may be added in order to improve the coatability and solubility.

Furthermore, if layer A is composed mainly of an inorganic material, the dry methods such as vapor deposition and sputtering is the most preferable ones of those listed above for the formation of layer A because it can be controlled easily during its formation, can come in a strong contact with the base layer and can be high in uniformity.

For manufacturing a solar cell backsheet film according to the present invention, the available techniques for forming layer A with a dry method include vacuum deposition techniques such as resistance heating deposition, electron beam deposition, and induction heating deposition, which may be assisted with plasma' or ion beams; sputtering techniques such as reactive spattering, ion beam spattering, and ECR (electron cyclotron) sputtering; physical vapor deposition (PVD) techniques such as ion plating; and chemical vapor deposition (CVD) techniques using heat, light, or plasma.

Here, if the material used to form layer A is composed mainly of inorganic oxide, inorganic nitride, inorganic oxynitride, inorganic halide, and inorganic sulfide, a material having the same composition as layer A to be formed may be directly volatilized and deposited on the surface of the base layer (layer B) and/or layer B1 that constitutes layer B, but when this method is carried out, the composition may change during the volatilization, and as a result, the film formed may not have uniform characteristics. The processes to avoid thus include: 1) A material having the same composition as layer A to be formed is used as the volatilizing source and volatilization is performed while assisting it by supplying oxygen gas, nitrogen gas, mixture of oxygen gas and nitrogen gas, halogen-based gas, or sulfur-based gas into the system when the material is respectively inorganic oxide, inorganic nitride, inorganic oxynitride, inorganic halide, or inorganic sulfide; 2) Inorganic substances are used as volatilizing source, and while volatilizing them, oxygen gas, nitrogen gas, mixture of oxygen gas and nitrogen gas, halogen-based gas, or sulfur-based gas are supplied into the system when the material is respectively inorganic oxide, inorganic nitride, inorganic oxynitride, inorganic halide, or inorganic sulfide, so that the inorganic substances are allowed to react with the supplied gas for deposition on the surface of the base material; and 3) Inorganic substances used as volatilizing source are volatilized to form a layer of these inorganic substances, and then the layer is left in an atmosphere of oxygen gas, nitrogen gas, mixture of oxygen gas and nitrogen gas, halogen-based gas, or sulfur-based gas when the layer material is respectively inorganic oxide, inorganic nitride, inorganic oxynitride, inorganic halide, or inorganic sulfide, in order to cause reaction between the inorganic layer and the supplied gas. Of these, the methods 2) and 3) are more preferable because it is easy to volatilize the substances from the volatilizing sources. The method 2) is still more preferable because the properties of the film can be controlled more easily. In the case where layer A is made of inorganic oxide, inorganic substances used as volatilizing source may be volatilized to form a layer of these inorganic substances, followed by leaving it in air for natural oxidation of the inorganic substances, and this procedure is used preferably because the layer formation can be performed easily.

If layer A is formed with a dry method for the solar cell backsheet film according to the present invention, the surface resistivity R0 of surface A in layer A can be adjusted by controlling the degree of reaction of the gas. The degree of reaction can be adjusted by controlling the flow rate and temperature of the supplied gas. The surface resistivity R0 becomes lower as the degree of reaction decreases, while the surface resistivity R0 becomes higher as the degree of reaction increases. The optimum conditions may change depending on the type of metal used, the gas used for reaction, and apparatus, but the layer may be formed successfully if the conditions are adjusted so that the surface resistivity R0 meets the aforementioned requirements.

In the case where layer A is formed by the PVD method, it is preferable to increase the degree of vacuum in the system when the pressure is reduced before the volatilization. Increasing the degree of vacuum in the system contributes to forming layer A that is dense and has less defects, making it possible to produce layer A with high uniformity.

Furthermore, if layer A is to have a laminated structure composed of different inorganic substances, an apparatus equipped with multiple volatilization sources may be used to form the first layer first, followed by changing the volatilization source to form the second layer and then the third layer; or if the same inorganic substances are used at different degrees of reaction and/or with different reaction gases, then the first layer is formed first, followed by forming the second layer and then the third layer after changing the flow rate of the gas to be supplied and/or changing the gas to be supplied.

If the material used to constitute layer A of the solar cell backsheet film according to the present invention is an electrically conductive organic/inorganic composite material and falls under case iv), an appropriate one of the production methods listed above may be selected for use depending on the type and composition of the material to be used.

The solar cell backsheet film according to the present invention can be formed by the aforementioned processes, and the resulting film will be characterized by a higher partial electrical discharge voltage in spite of a small thickness in comparison with the conventional films.

The solar cell backsheet according to the present invention is characterized by containing the aforementioned solar cell backsheet film. Because the solar cell backsheet film according to the present invention has a higher partial electrical discharge voltage, in spite of a small thickness, than that of the conventional films, it is possible to reduce the thickness of the backsheet.

With respect to the configuration of solar cell backsheets according to the present invention, any appropriate configuration may be arbitrarily adopted as long as the aforementioned solar cell backsheet is used, and the solar cell backsheet according to the present invention is configured by forming an EVA contact layer designed to enhance the contact of the EVA material which seals power generating devices with the solar cell backsheet according to the present invention, an anchor layer designed to increase the contact with the EVA contact layer, a vapor barrier layer, an ultraviolet ray absorbing layer designed to prevent degradation by ultraviolet ray, a light reflecting layer designed to improve the power generation efficiency, a light absorbing layer designed to enhance the appearance, and an adhesive layer designed to maintain adhesion between other layers.

The EVA contact layer is designed to enhance the contact with the EVA-based resin which seals power generating devices, and it is located at the closest position to the power generating devices to maintain its adhesion with the backsheet and the system. There is no particular limitation to its material, as long as the contact with the EVA-based resin is maintained, and its preferable examples include EVA, and a mixture of EVA with an ethylene-methylacrylate (EMA) copolymer, ethylene-ethylacrylate copolymer (EEA), ethylene-butylacrylate copolymer (EBA), ethylene-methacrylic acid copolymer (EMAA), ionomer resin, polyester resin, urethane resin, acrylic resin, polyethylene resin, polypropylene resin, or polyamide resin.

Furthermore, in order to improve the contact of the EVA contact layer with the backsheet, forming an anchor layer, as needed, has been a preferable means. There is no particular limitation on the materials thereof, as long as its contact with the EVA contact layer is maintained, and its preferable examples include a mixture composed mainly of resins such as acrylic resin and polyester resin.

The vapor barrier layer is a layer designed to prevent vapor from entering into the solar cell through the backsheet, in order to prevent vapor degradation of the power generating devices after construction of the solar cell. The layer is formed by producing a layer of an oxide such as silicon oxide and aluminum oxide or a layer of a metal such as aluminum on the surface of the film by using a known method such as vacuum deposition and sputtering. The thickness thereof, in general, is preferably in the range between 100Å and 200Å.

To achieve this, the means preferably used include providing a gas barrier layer directly on the solar cell backsheet film according to the present invention, and preparing a separate film with a gas barrier property followed by attaching the film on the surface of the film according to the present invention. It is also preferable to provide a metal foil (for example, aluminum foil) on the surface of the film. The thickness of the metal foil in this case is preferably in the range of 10 $\mu$m and 50 $\mu$m, from the viewpoint of the processability and gas barrier property.

The ultraviolet ray absorbing layer is a layer designed to block ultraviolet rays in order to prevent ultraviolet degradation of the resins located at inner positions, and any appropriate material may be used as long as it has the function of blocking ultraviolet rays of 380 nm and less.

The light reflection layer is a layer designed to reflect light, and the formation of the layer serves to prevent ultraviolet degradation of the resins inside the system, and in addition, the light reflection layer can act to increase the power generation efficiency as the light that has reached the backsheet without being absorbed by the solar cell system is reflected back into the system. The layer contains white pigments such as titanium oxide and barium sulfate, as well as air bubbles.

The light absorption layer is a layer designed to absorb light, and the formation of the layer serves to prevent ultraviolet degradation of the resins inside the system, and this layer also works to improve the appearance of the solar cell.

Combining each of the above layers with the film according to the present invention provides the solar cell backsheet according to the present invention. It should be noted that in the solar cell backsheet according to the present invention, all of the aforementioned layers are not necessarily independent ones, but as a preferable embodiment, a multifunctional layer that combines multiple functions may be used. If the solar cell backsheet film according to the present invention already has some of the functions, the corresponding layers may not be used. For example, the light reflection layer may be eliminated if the backsheet film according to the present invention contains white pigments and air bubbles that serve for light reflection, or the light absorption layer may be eliminated if the film contains light absorption agents that serve for light absorption. The ultraviolet ray absorption layer may be eliminated if the film contains ultraviolet ray absorption agents.

With respect to the gas barrier layer, a gas barrier layer may be provided directly on the solar cell backsheet film according to the present invention, or a layer having a gas barrier property is formed on a film which is then applied to the surface of the polyester film according to the present invention, either of which may be performed preferably. Another preferable method is to form a metal foil (for example, aluminum foil) on the film surface. The thickness of the metal foil in this case is preferably in a range of 10 $\mu$m and 50 $\mu$m from the viewpoint of the processability and gas barrier property.

Here, the solar cell backsheet film according to the present invention has a higher partial electrical discharge voltage than that of the conventional films, and if a backsheet is produced from this film, it can have a higher partial electrical discharge voltage than that of the conventional backsheets. In the solar cell backsheet according to the present invention, both surface layers of the solar cell backsheet may be formed from a film that is different from the according to the present invention, or one or more surface layers may be formed from the film according to the present invention. In any case, a solar cell backsheet with increased safety or reduced thickness can be produced because the film has a higher partial electrical discharge voltage than that of the conventional films. It is more preferable that the solar cell backsheet has such a structure that at least one of the surfaces of the backsheet has a surface resistivity R0 of $10^6$ $\Omega$/square or more and not more than $10^{14}$ $\Omega$/square (hereinafter referred to as surface A1), and it is still more preferable that surface A1 is surface A of the solar cell backsheet film according to the present invention because the partial electrical discharge voltage can be further increased. In addition, it is preferable the structure is such that at least one surface layer is layer A of the solar cell backsheet film according to the present invention. If the backsheet has such a structure, the partial electrical discharge voltage can be increased as compared with a structure in which surface A is contained inside the backsheet. As a result, the electric shock resistance of the solar cell backsheet can be increased, and the thickness of the backsheet can be reduced.

If the solar cell backsheet according to the present invention is structured to have surface A1, it is preferable that the surface opposite to surface A1 has a surface resistivity R3 of not less than $10^{14}$ $\Omega$/square. As described below, when the solar cell backsheet film according to the present invention is incorporated in a solar cell system, a more preferable structure can be achieved by providing layer A1 on the opposite side of the resin layer in which power generating devices are sealed in order to produce a solar cell with higher durability and decrease the thickness. Here, the electric shock resistance of the solar cell backsheet can decrease or, as electric energy is extracted through the lead wire, the efficiency of energy extraction can decrease to reduce the power generation efficiency if the surface opposite to surface A1 of the solar cell backsheet according to the present invention has a surface resistivity R3 of not less than $10^{14}$ $\Omega$/square.

The thickness of the solar cell backsheet according to the present invention is preferably not less than 20 $\mu$m and not more than 500 $\mu$m, more preferably not less than 25 $\mu$m and not more than 300 $\mu$m. It is still more preferably not less than 30 $\mu$m and not more than 200 $\mu$m. If the thickness is less than 10 $\mu$m, it will be difficult to secure a sufficient flatness of the film. If the thickness is greater than 500 $\mu$m, on the other hand, a solar cell that incorporates the backsheet will have too large a thickness.

The solar cell according to the present invention is characterized by containing the solar cell backsheet according to the present invention. The solar cell backsheet according to the present invention is characterized by having a partial electrical discharge voltage that is more than that of the conventional backsheets, and this allows it to serve to produce a solar cell that has a higher durability and a smaller thickness.

In Fig. 1, as base material 4 which transmits light is positioned to form the outermost layer of the solar cell, a transparent material having high weather resistance, high contamination resistance, high mechanical strength characteristics, as well as high transmittance, is used. For the solar cell according to the present invention, any material may be used as base material 4 which transmits light, as long as it meets the above requirements for properties. Preferable examples thereof include glass; fluorine-based resins such asethylene- tetrafluoroethylene copolymer (ETFE), poly(vinyl fluoride) resin (PVF), polyvinylidene fluoride (PVDF), polytetrafluoroethylene resins (TFE), tetrafluoroethylene - hexafluoropropylene copolymer (FEP), polychlorotrifluoroethylene resin (CTFE), polyvinylidene fluoride resin, others such as olefin-based resins and acrylic resins; and mixtures thereof. If it is a resin-based light transmitting base material, the above mentioned resin may be stretched either uniaxially or biaxially to increase the mechanical strength, and the surface of the base material may undergo corona treatment, plasma treatment, ozone treatment, and adhesion improving treatment.

Resin 2 for sealing the power generating device is intended to protect the power generating devices from the external environment and has the function of adhering the power generating device to the base material, which has electrical insulating properties and transmits light, and the backsheet. The major examples thereof include ethylene - vinyl acetate copolymer (EVA), ethylene - methylacrylate copolymer (EMA), ethylene - ethylacrylate copolymer (EEA) resin, ethylene - methacrylic acid copolymer (EMMA), ionomer resin, polyvinyl butyral resin, and mixtures thereof.

Here, in the solar cell according to the present invention, the aforementioned solar cell backsheet 1 is located on the rear surface of the resin layer 2 that contains the power generating device, and if the aforementioned solar cell backsheet is configured to have surface A1, said surface A1 may be disposed on the side facing resin layer 2 (5 in Fig. 1) or may be disposed on the side opposite to resin layer 2 (6 in Fig. 1) . In any of the above configurations, the solar cell backsheet according to the present invention is high in partial electrical discharge voltage than the conventional backsheets, even if it is smaller in thickness, making it possible to produce a solar cell system that is high in durability and small in thickness. It is more preferable that surface A1 of the aforementioned solar cell backsheet is located on the side opposite to the resin layer (6 in Fig. 1). The configuration contributes to producing a solar cell higher in durability and smaller in thickness than the configuration in which surface A1 is located on the side facing the resin layer (5 in Fig. 1).

As described above, incorporating the backsheet according to the present invention into a solar cell system allows the solar cell system to be higher in durability and/or smaller in thickness in comparison with the conventional solar cells.

The solar cell according to the present invention is not limited to outdoor or indoor applications such as photovoltaic power generation systems and power supplies for compact electronic components, and can be used favorably for various other applications.

[Methods for Evaluation of Properties]

A. Surface resistivity R0, R1, R2, R3

The surface resistivities R0 and R2 of the film and the surface resistivity R3 of the surface of the backsheet opposite to surface A were measured with an R8340 digital ultrahigh resistance minute current ammeter manufactured by Advantest Corporation. However, when the surface resistivity was not larger than $10^5$ $\Omega$/square, the resistance was measured with Loresta EP (manufactured by Dia Instruments Co., Ltd.) equipped with an ASP probe. It should be noted that measurements were made at 10 arbitrary points on the film surface, and the surface resistivity R0 was determined by averaging the measurements. Specimens to be used were left to stand overnight in a room maintained at a temperature of 23°C and a humidity of 65%RH. With respect to the surface resistivity R1, the film specimen was processed in a pressure cooker manufactured by Tabai Espec Corp. for 24 hours under the conditions of a temperature of 125°C and a humidity of 100%RH, and the surface resistivity R1 of the specimen thus processed was measured by the same procedure as above. It should be noted that measurements were made at 10 arbitrary points on the film surface, and the surface resistivity R1 was determined by averaging the measurements. After being processed, the specimens to be used were taken out of the pressure cooker and left to stand overnight in a room maintained at a temperature of 23°C and a humidity of 65%RH, followed by measurement.

B. Rupture elongation and elongation retention percentage

The rupture elongation was measured according to ASTM-D822 (1999) by cutting out a sample with a size of 1 cm x 20 cm and pulling it under the conditions of a chuck-to-chuck distance of 5 cm and a pulling rate of 300 mm/min. Here the test was executed for 5 samples, and the rupture elongation E0 was determined by averaging the measurements. Next, the sample was cut into a specimen of a specific shape for measurement (1 cm x 20 cm), and then processed by a pressure cooker manufactured by Tabai Espec Corp. for 24 hours under the conditions of a temperature of 125°C and a humidity of 100%RH, and subsequently, the specimen thus processed was subjected to rupture elongation measurement in accordance with ASTM-D882 (1999) . It was pulled under the conditions of a chuck-to-chuck distance of 5 cm and a pulling rate of 300 mm/min. Here the test was executed for 5 samples, and the rupture elongation E1 was determined by averaging the measurements. Using the resulting rupture elongations E0 and E1, the elongation retention percentage was calculated by the following formula (1).

$$\text{Elongation retention percentage (\%)} = E1/E0 \times 100 \qquad (1)$$

The specimens were evaluated in terms of elongation retention percentage according to the following criteria.
If the elongation retention percentage was not less than 70% : S If the elongation retention percentage was not less than 60% and less than 70% : A
If the elongation retention percentage was not less than 50% and less than 60% : B
If the elongation retention percentage was less than 50% : C Specimens evaluated as S, A, or B have good quality, and in particular, those of S have the best quality.

C. Weight average molecular weight (Mw) and number average molecular weight (Mn)

Using a GCP-244 gel permeation chromatograph (manufactured by Waters Corporation) equipped with two Shodex HFIP 806M columns (manufactured by Showa Denko K.K.) and a RI type detector (Model 2414., sensitivity 256, manufactured by Waters Corporation), GPC measurements were made with PET-DMT (standard grade) at room temperature (23°C) and a flow rate of 0.5 ml/min. The measurements of the elution volume (V) and molecular weight (M) thus obtained were used to calculate the factor $A_1$ of the three-order approximation formula given as formula (2) below, followed by drawing a calibration curve.

$$\text{Log (M)} = A_0 + A_1V + A_2V^2 + A_3V^3 \qquad (2)$$

Next, hexafluoropropanol (0. 005 N sodium trifluoroacetate) was used as a solvent to prepare a solution in which the material of layer B1 was dissolved so that it would account for 0.06% by mass, and this solution was applied to GPC measurement. The measurement conditions may be set up appropriately, but measurements here were made at an injection quantity of 0.300 ml and a flow rate of 0.5 ml/min.
The resulting elution curve/molecular weight curve and the molecular weight calibration curve were superimposed to determine the molecular weight for different efflux times, and the value calculated by the following formula (3) was used as weight average molecular weight.

$$\text{Weight average molecular weight (Mw)} = \Sigma(Ni \cdot Mi^2) / \Sigma(Ni \cdot Mi) \qquad (3)$$

The number average molecular weight was calculated by the following formula (4).

$$\text{Average number molecular weight (Mn)} = \Sigma Ni \cdot Mi / \Sigma Ni \qquad (4)$$

where Ni denotes the molar fraction and Mi represents the molar weight at the relevant elution position on the GPC curve obtained via the molecular weight calibration curve.

In the case of a base layer (layer B) having a layered construction, measurement was performed for a specimen comprising only layer B1 that was prepared by detaching the other layers or grinding the film while observing it with a microscope.

D. Minute endothermic peak temperature TmetaB1 and melting point TmB1

For measurement of the minute endothermic peak temperature TmetaB1 and the melting point TmB1 in layer B1, a differential scanning calorimeter (Robot DSC-RDC220.manufactured by Seiko Electronics Industrial Co., Ltd.) was used, and for data analysis, Disc Session SSC/5200 was used to execute the test according to JIS K7122 (1999) . A 5 mg specimen of layer B1 was weighed out on a sample pan and heated at a heating rate of 20°C/min. In the first run, the resin was heated at a heating rate of 20°C/min from 25°C to 300°C, held there for 5 minutes, and quenched to a temperature of not more than 25°C, followed by the second run, in which the temperature was raised up to 300°C at a heating rate of 20°C/min to execute the test. TmetaB1 was determined as the minute endothermic peak temperature before the crystal melting peak on the differential scanning calorimetry chart in the first run, while Tmb1 of layer B1 was determined as the peak top temperature in the crystal melting peak observed in the second run.

E. Partial electrical discharge voltage

The partial electrical discharge voltage was determined by using a KPD2050 partial electrical discharge tester manufactured by Kikusui Electronics Corp. The testing conditions are as follows:

· The output voltage application pattern in the output sheet should be a pattern composed of the following three steps: simply raising the voltage from 0 V to a predetermined testing voltage in the first step, maintaining the predetermined testing voltage in the second step, and simply dropping the voltage from the predetermined testing voltage to 0 V.
· The frequency should be 50 Hz. The Testing voltage should be 1 kV.
· Time t1 of the first step is set to 10 seconds, time t2 of the second step is set to 2 seconds, and time T3 of the third step is set to 10 seconds.
· The counting mode for the pulse counting sheet is set to "+" (plus), with a detection level set to 50%.
· The quantity of electric charge for the range sheet is set to the range 1,000 pcs.
· In the protection sheet, a check box of the voltage is checked before 2 kV is applied. The pulse count is set to 100,000.
· The starting voltage in the measurement mode is set to 1.0 pc, and the extinction voltage to 1.0 pc.

It should be noted that measurements were made at 10 arbitrary points on the surface of the film for the case where the top electrode faces surface A and for the case where the bottom electrode faces surface A, followed by calculating the average for each case. The higher of the average values was taken as the partial electrical discharge voltage V0 . The specimens to be used for measurement were left to stand overnight at 23°C and 65%RH before measurement. After the moist heat treatment, the film for the partial electrical discharge voltage V1 was treated using a pressure cooker (manufactured by Tabai ESPEC Co., Ltd.) for 24 hours under the conditions of a temperature of 125°C and a humidity of 100%RH, and then the treated specimen was subjected to measurement of the partial electrical discharge voltage V1. It should be noted that measurements were made at 10 arbitrary points on the surface of the film for the case where the top electrode faces surface A and for the case where the bottom electrode faces surface A, followed by calculating the average for each case. The higher of the average values was taken as the partial electrical discharge voltage V1. The specimen to be used for measurement was taken out of the pressure cooker after the treatment and left to stand overnight in a room maintained at a temperature of 23 °C and a humidity of 65%RH, followed by measurement. To determine the partial electrical discharge voltage V2 after the light resistance (UV) test, the film was subjected to ultraviolet ray irradiation test for 4 hours under the "light 24 hours" conditions (illumination intensity: 100 mW/cm$^2$, temperature and humidity: 60°C, 50%RH) using an ultraviolet degradation acceleration tester (Eye Super UV Tester SUV-W131, manufactured by Iwasaki Electric Co., Ltd.), and then the partial electrical discharge voltage V2 after the treatment was measured. Measurements were made at 10 arbitrary points on the surface of the film. The specimen for measurement was taken out of the ultraviolet ray degradation acceleration tester after the treatment, and then left to stand overnight in a room maintained at a temperature of 23°C and a humidity of 65%RH, followed by measurement. Said measurements were made for the case where the top electrode faces surface A and for the case where the top electrode faces surface B, followed by calculating the average for each case. The higher of the average values was taken as the partial electrical discharge voltage V2.

F. Nitrogen content percentage

Only layer B1 was skived out and dried in a vacuum at 40°C for 5 hours, followed by determining the nitrogen content using an automatic elemental analysis apparatus (VarioEL, manufactured by Yanagimoto Analytical Industry Co., Ltd.).

G. Air bubble content

The content was determined by the following procedure from step (A1) to step (A5). Measurements were made at 10 different points, and their average was calculated to determine the air bubble content in the air bubble containing layer.

(A1) Using a microtome, the film is cut perpendicular to the plane direction of the film without allowing the cross section of the film to collapse in the thickness direction.

(A2) Next, the cross section thus cut out is observed by electron microscopy to obtain an image enlarged at a magnification of 2, 000 times. Here, the observation points are selected in the air bubble containing layer in a random way, but the longitudinal direction of the image is parallel with the film's thickness direction while the horizontal direction of the image is parallel with the film's plane direction.

(A3) The area of the air bubble containing layer in the image obtained in step (A2) is measured, and this is hereafter referred to as area A.

(A4) The area of all air bubbles present in the image is measured, and this total area is hereafter referred to as area B. Here, the observation is not limited to those air bubbles that are entirely accommodated in the image, but also includes those air bubbles that contained only partially in the image.

(A5) Area B is divided by area A, i.e. (B/A), and multiplied by 100 to determine the air bubble content (% by volume) in the air bubble containing layer.

H. Inherent viscosity

Layer B1 was dissolved in 100 ml of orthochlorophenol (concentration of the solution C = 1.2 g/ml), and the viscosity of this solution at 25°C was measured with an Ostwald viscometer. The viscosity of the solvent was also measured by the same procedure as above. Using the measurements of the viscosity of the solution and that of the solvent, the term [η] was calculated by the following formula, and the value obtained was taken as the intrinsic viscosity (IV).

$$\eta sp/C = [\eta] + K[\eta]^2 \cdot C \qquad (3)$$

where ηsp = (viscosity of solution / viscosity of solvent) - 1, and K denotes the Huggins constant (0.343).

[Examples]

The present invention will now be illustrated with reference to Examples, but it should be understood that the invention is not construed as being limited thereto.

(Material for layer A for the case where layer A is formed by coating)

Electrically conductive material (a)

a-1: Water dispersion of water-insoluble cationic electrical conductive material Bondeip-PM (registered trademark) (supplied by Konishi Co., Ltd., solids content 30%) used as base resin

a-2: Water dispersion of water-insoluble polythiophene based electrical conductive polymer Baytron (registered trademark) P (supplied by Bayer AG / H. C. Stark GMBH (Germany), solids content 1.2%)

a-3: water-soluble cationic material: ammonium polystyrene sulfonate (weight average molecular weight: 65,000)

a-4: Water dispersion of carbon nanotube (prepared by adding 0.85 parts by mass of double wall CNT (supplied by Science Laboratory, purity 95%) and 2 parts by mass of polyvinyl pyrolidone to 97.15 parts by mass of pure water, followed by ultrasonic treatment in ultrasonic disintegrator (CX-502, supplied by Tokyo Rikakikai Co., Ltd., output 250W, direct irradiation) for 30 minutes

· Binder resin (b)

b-1: Water-insoluble acrylic resin: methyl methacrylate / ethyl acrylate / acrylic acid / N-methylol acrylamide = 62 / 35 / 2 /: 1 (ratio by mass) copolymerized into acrylic resin (glass transition temperature: 42°C), dispersed as particles in water at solids content of 10%

b-2: Water-insoluble polyester based resin: terephthalic acid / isophthalic acid / 5-sodium sulfoisophthalate = 60 / 30 / 10 as acid components and ethylene glycol / diethylene glycol / polyethylene glycol = 95 / 3 / 2 as diol components copolymerized into polyester resin (glass transition temperature 48°C), dispersed at concentration of 10% by mass

· Crosslinking agent (c)

c-1: Water dispersion of oxazoline group containing compound: Epocros (registered trademark) WS-500 (supplied by Nippon Shokubai Co., Ltd., solids content 40%)

c-2: Epoxy based crosslinking agent: polyglycerol polyglycidyl ether based epoxy crosslinking agent EX-512 (molecular weight of about 630) (supplied by Nagase ChemteX Corporation)

· Surface active agent (d)

d-1: Acetylene diol based surface active agent: Olfin (registered trademark) EXP4051F (supplied by Nissin Chemical Industry Co., Ltd.)

· Light stabilization agent (e)

e-1: Water dispersion of titanium oxide: NanoTek (registered trademark) RTIW15WT%G0 (titanium oxide particles, supplied by C. I. Kasei Co., Ltd, diameter 20-30 nm, concentration 15% by mass)

e-2: Water dispersion of zinc oxide: GZOW15WT%-E05 (zinc oxide particles, supplied by C. I. Kasei Co., Ltd., diameter 20-30 nm, concentration 15% by mass)

(Example 1-1)

As the first step, 100 parts by mass of dimethyl terephthalate, 57.5 parts by mass of ethylene glycol, 0.06 parts by mass of magnesium acetate, and 0.03 parts by mass of antimony trioxide are melted at 150°C in a nitrogen atmosphere, and heated while stirring so that the temperature would reach 230°C in 3 hours, evaporating methanol to carry out ester interchange reaction.

As the second step, polymerization reaction is carried out under the conditions of a final temperature of 285°C and a vacuum of 0.1 torr to prepare polyester with an intrinsic viscosity of 0.54. As the third step, the resulting polyethylene terephthalate was dried at 160°C for 6 hours, crystallized, and solid-phase polymerized for 8 hours at 220°C and a vacuum of 0.3 torr to produce polyester with an intrinsic viscosity of 0.81.

The resulting polyethylene terephthalate with an intrinsic viscosity of 0.81 (melting point TmB1 = 255°C) is vacuum-dried at a temperature of 180°C for 3 hours, then supplied to an extruder, melted at a temperature of 280°C in a nitrogen atmosphere, and introduced to a T-die orifice. Then, the melt was extruded through the T-die orifice into a sheet to prepare a molten monolayer sheet, and this molten monolayer sheet is cooled and solidified through electrostatic treatment by bringing it into close contact with a drum with a surface maintained at a temperature of 25°C to produce an unstretched monolayer film. Subsequently, said unstretched monolayer film is preheated on rolls heated at a temperature of 90°C, stretched 3.3 times in the length direction (vertical direction) using heating rollers maintained at a temperature of 95°C, and cooled on rolls maintained at a temperature of 25°C to produce an uniaxially stretched film. The uniaxially stretched film is subjected to corona treatment, and then the undermentioned coating material 1-1 is applied with a #6 metering bar.

<Coating material 1-1>

· Electrically conductive material :a-1 18 parts by mass
· Binder resin: b-1 3 parts by mass
· Crosslinking agent: c-1 0.75 part by mass
· Surface active agent: d-1 0.1 part by mass
· Water: 78.15 parts by mass

The resulting uniaxially stretched film, with its ends held by clips, was supplied to the preheat zone maintained at a temperature of 95˚C in a tenter, and continuously fed to a heating zone where it was stretched at a temperature of 105˚C 3.5 times in the direction (width direction) perpendicular to the length direction. In succession to this, heat treatment was carried out at a temperature of 200˚C for 20 seconds in the heat treatment zone in the tenter, followed by relaxation treatment at a temperature of 180˚C by 4% in the width direction and in addition relaxation treatment at a temperature of 140˚C by 3% in the width direction. Subsequently, uniform slow cooling and winding-up were performed to produce a biaxially stretched film with a thickness of 50 $\mu$m having layer A with a thickness of 0.15 $\mu$m formed on its surface. The resulting film was subjected to measurement of the weight average molecular weight of layer B1, number average molecular weight, surface resistivity of surface A, surface resistivity of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It is seen that the film is good in all these characteristics. Then, this film, used as the first layer, was coated with 90 parts by mass of Takelac (registered trademark) A310 (supplied by Mitsui Takeda Chemicals Inc.) and Takenate (registered trademark) A3 (supplied by Mitsui Takeda Chemicals Inc.) to form an adhesion layer, and as the second layer, a biaxially stretched polyester film with a thickness of 125 $\mu$m (Lumirror (registered trademark) S10, supplied by Toray Industries, Inc., both surfaces with a surface resistivity of $4.5 \times 10^{15}$ Q/square) was stuck. Subsequently, the above-mentioned adhesive layer was applied over the second layer, and, Barrialox HGTS with a thickness of 12 $\mu$m (alumina deposited PET film, supplied by Toray Advanced Film Co.) was stuck to it in such a manner that the deposited layer is on the opposite side to the second layer to produce a backsheet with a thickness of 188 $\mu$m. Here, with respect to the first layer, two samples were prepared: sticking was carried out so that surface A would be on the internal side (facing the second layer) in one and on the external side (opposite to the second layer) in the other. The partial discharge voltage of the resulting backsheets was measured. The results are given in Table 3. Thus, it was found that all samples had a high partial discharge voltage, and in particular, the one having surface A formed on the external side had a higher partial discharge voltage.

(Examples 1-2 to 1-3)

Except that the undermentioned coating material 1-2 or 1-3 was used as the coating material to form layer A, the same procedure as in Example 1-1 was carried out to prepare a biaxially stretched film with a thickness of 50 $\mu$m having layer A with a thickness of 0.15 $\mu$m formed on the surface.

<Coating material 1-2>

· Electrically conductive material :a-1 16 parts by mass
· Binder resin: b-1 6 parts by mass
· Crosslinking agent: c-1 1.25 parts by mass
· Surface active agent: d-1 0.1 part by mass
· Water: 76.65 parts by mass

<Coating material 1-3>

· Electrically conductive material :a-1 12 parts by mass
· Binder resin: b-1 12 parts by mass
· Crosslinking agent: c-1 2.5 parts by mass
· Surface active agent: d-1 0.1 part by mass

· Water: 73.4 parts by mass

The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics as in Example 1-1. The resulting film was used to prepare a backsheet by the same procedure as in Example 1-1. The partial discharge voltage of the resulting backsheet was measured. The results are given in Table 3. Thus, it was found that all samples had a high partial discharge voltage as in Example 1-1, and in particular, the one having surface A formed on the external side had a higher partial discharge voltage.

(Examples 1-4 and 1-5)

Except that the undermentioned coating material 1-4 or 1-5 was used as the coating material to form layer A, the same procedure as in Example 1-1 was carried out to prepare a biaxially stretched film with a thickness of 50 $\mu$m having layer A with a thickness of 0.15 $\mu$m or with a thickness of 0.03 $\mu$m formed on the surface.

<Coating material 1-4>

· Electrically conductive material :a-1 10 parts by mass
· Binder resin: b-1 15 parts by mass
· Crosslinking agent: c-1 3.75 parts by mass
· Surface active agent: d-1 0.1 part by mass
· Water: 71.15 parts by mass

<Coating material 1-5>

· Electrically conductive material :a-2 41.6 parts by mass
· Binder resin: b-2 2.5 parts by mass
· Crosslinking agent: c-2 0.25 part by mass
· Surface active agent: d-1 0.1 part by mass
· Water: 32.1 parts by mass

The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although somewhat lower than in Examples 1-1 to 1-3, the film showed a high partial discharge voltage and had good characteristics. The resulting film was used to prepare a backsheet by the same procedure as in Example 1-1. The partial discharge voltage of the resulting backsheet was measured. The results are given in Table 3. Thus, it was found that although somewhat lower than in Examples 1-1 to 1-3, the film had a high partial discharge voltage, and in particular, the sample having surface A formed on the external side had a higher partial discharge voltage.

(Example 1-6)

Except that the undermentioned coating material 1-6 was used as the coating material to form layer A, the same procedure as in Example 1-1 was carried out to prepare a biaxially stretched film with a thickness of 50 $\mu$m having layer A with a thickness of 0.03 $\mu$m formed on the surface.

<Coating material 1-6>

· Electrically conductive material :a-2 50 parts by mass

· Binder resin: b-2 2 parts by mass
· Crosslinking agent: c-2 0.2 part by mass
· Surface active agent: d-1 0.1 part by mass
· Water: 47.7 parts by mass

The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although somewhat lower than in Examples 1-4 and 1-5, the film showed a high partial discharge voltage and had good characteristics. The resulting film was used to prepare a backsheet by the same procedure as in Example 1-1. The partial discharge voltage of the resulting backsheet was measured. The results are given in Table 3. Thus, it was found that although somewhat lower than in Examples 1-4 and 1-5, the film had a high partial discharge voltage, and in particular, the sample having surface A formed on the external side had a higher partial discharge voltage.

(Example 1-7)

Except that the undermentioned coating material 1-7 was used as the coating material to form layer A, the same procedure as in Example 1-1 was carried out to prepare a biaxially stretched film with a thickness of 50 $\mu$m having layer A with a thickness of 0.03 $\mu$m formed on the surface.

<Coating material 1-7>

· Electrically conductive material :a-2 66.7 parts by mass
· Binder resin: b-2 1 part by mass
· Crosslinking agent: c-2 0.1 part by mass
· Surface active agent: d-1 0.1 part by mass
· Water: 32.1 parts by mass

The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although somewhat lower than in Example 1-6, the film showed a high partial discharge voltage and had good characteristics. The resulting film was used to prepare a backsheet by the same procedure as in Example 1-1. The partial discharge voltage of the resulting backsheet was measured. The results are given in Table 3. Thus, it was found that although somewhat lower than in Examples 1-6, the film had a high partial discharge voltage, and in particular, the sample having surface A formed on the external side had a higher partial discharge voltage.

(Example 1-8)

Except that the film thickness was 125 $\mu$m, the same procedure as in Example 1-1 was carried out to prepare a biaxially stretched film with a thickness of 125 $\mu$m having layer A with a thickness of 0.15 $\mu$m formed on the surface. The resulting film was subjected to measurement of the surface resistivity, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all these characteristics. Except that a biaxially stretched polyester film Lumirror (registered trademark) S10 (supplied by Toray Industries, Inc.) with a thickness of 50 $\mu$m was used as the second layer, the same procedure as in Example 1-1 was carried out using the film prepared above to prepare a backsheet. The partial discharge voltage of the resulting backsheet was measured. Results are given in Table 3. Thus, it was found that although somewhat lower than in Examples 1-1, the film had a high partial discharge voltage, and in particular, the sample having surface A formed on the external side had a higher partial discharge voltage.

(Example 1-9)

Except that the film thickness was 188 $\mu$m, the same procedure as in Example 1-1 was carried out to prepare a biaxially stretched film with a thickness of 188 μm having layer A with a thickness of 0.15 μm formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all these characteristics. The resulting film, which was to be used as the first layer, was placed in an electron beam deposition apparatus, and alumina was used as volatilization source to electron-beam-evaporate alumina in the normal direction to the film surface under the conditions of a vacuum of $3.4 \times 10^{-5}$ Pa, a deposition rate of 10 angstrom/sec, and a source-substrate distance of 25 cm, in order to form the second layer made of alumina with a thickness of 0.2 μm. Here, with respect to the first layer, two samples were prepared: deposition was carried out so that surface A would be on the internal side (facing the second layer) in one and on the external side (opposite to the second layer) in the other. The partial discharge voltage of the resulting backsheet was measured. Results are given in Table 3. Thus, it was found that all samples had a high partial discharge voltage as in Example 1-1, and in particular, the one having surface A formed on the external side had a higher partial discharge voltage.

(Example 1-10)

Except that the undermentioned coating material 1-10 was used as the coating material to form layer A, the same procedure as in Example 1-1 was carried out to prepare a biaxially stretched film with a thickness of 50 μm having layer A with a thickness of 0.15 μm formed on the surface.

<Coating material 1-10>

· Electrically conductive material :a-1 18 parts by mass
· Binder resin: b-1 6 parts by mass
· Surface active agent: c-1 0.1 part by mass
· Water: 75.9 parts by mass

The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics as in Example 1-1. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 1-11)

Except that the undermentioned coating material 1-11 was used as the coating material to form layer A, the same procedure as in Example 1-1 was carried out to prepare a biaxially stretched film with a thickness of 50 μm having layer A with a thickness of 0.15 μm formed on the surface.

<Coating material 1-11>

· Binder resin: a-1 12 parts by mass
· Surface active agent: c-1 0.1 part by mass
· Water: 87.9 parts by mass

The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although somewhat lower in partial discharge voltage after moist heat treatment as compared with Examples 1-1, the film was good in all characteristics. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 1-12)

Except that the undermentioned coating material 1-12 was used as the coating material to form layer A, the same procedure as in Example 1-1 was carried out to prepare a biaxially stretched film with a thickness of 50 $\mu$m having layer A with a thickness of 0.15 $\mu$m formed on the surface.

<Coating material 1-12>

· Electrically conductive material :a-3 1.5 parts by mass
· Binder resin: b-1 35 parts by mass
· Crosslinking agent: c-1 4.2 parts by mass
· Surface active agent: d-1 0.1 part by mass
· Water: 59.2 parts by mass

The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics as in Example 1-1. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 1-13)

Except that the undermentioned coating material 1-13 was used as the coating material to form layer A, the same procedure as in Example 1-1 was carried out to prepare a biaxially stretched film with a thickness of 50 $\mu$m having layer A with a thickness of 0.15 $\mu$m formed on the surface.

<Coating material 1-13>

· Electrically conductive material :a-3 1.5 parts by mass
· Binder resin: b-1 45 parts by mass
· Surface active agent: c-1 0.1 part by mass
· Water: 53.4 parts by mass

The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although somewhat lower in partial discharge voltage after moist heat treatment as compared with Examples 1-10 where a water-insoluble cationic electrically conductive material was used, the film was good in all characteristics. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 1-14)

Except that the undermentioned coating material 1-14 was used as the coating material to form layer A, the same procedure as in Example 1-12 was carried out to prepare a biaxially stretched film with a thickness of 50 $\mu$m having layer A with a thickness of 0.15 $\mu$m formed on the surface.

<Coating material 1-14>

· Electrically conductive material :a-3 6 parts by mass
· Surface active agent: c-1 0.1 part by mass
· Water: 93.9 parts by mass

The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although the partial discharge voltage was not improved by the moist heat treatment unlike Examples 1-10 where a water-insoluble cationic electrically conductive material was used, the film was good in the other characteristics. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Examples 1-15 to 1-17)

Except that the solid phase polymerization time in the third step was 5.5 hours, 4.5 hours, or 3.5 hours, the same procedure was carried out as in Example 1-1 to prepare polyethylene terephthalate samples with an intrinsic viscosity of 0.75, 0.70, or 0.66, respectively, and subsequently, except that the longitudinal drawing temperature was set to 95˚C, 90˚C, or 85˚C, the same procedure was carried out as in Example 1-1 to prepare a biaxially stretched film with a thickness of 50 $\mu$m having layer A with a thickness of 0.15 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although somewhat lower in rupture elongation after moist heat treatment as compared with Examples 1-1, the film was good in all characteristics. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1; and in particular, the one having surface A formed on the external side had a higher partial discharge voltage.

(Examples 1-18 and 1-19)

Except that the heat treatment temperature was 210˚C or 160.˚C, the same procedure as in Example 1-1 was carried out to prepare a biaxially stretched film with a thickness of 50 $\mu$m having layer A with a thickness of 0.15 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although somewhat lower in rupture elongation after moist heat treatment as compared with Examples 1-1, the film was good in all characteristics. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 1-20)

As the first step, 100 parts by mass of 2,6-dimethyl naphthalene dicarboxylate, 60 parts by mass of ethylene glycol, 0.06 parts by mass of magnesium acetate, and 0.03 parts by mass of antimony trioxide are melted at 150˚C in a nitrogen atmosphere, and heated while stirring so that the temperature would reach 240˚C in 3 hours, evaporating methanol to carry out ester interchange reaction. As the second step, polymerization reaction is carried out under the conditions of a final temperature of 290˚C and a vacuum of 0.1 torr to prepare polyester with an intrinsic viscosity of 0.54. As the third step, the resulting polyethylene naphthalate was dried at 160˚C for 6 hours, crystallized, and solid-phase polymerized for 8 hours at 225˚C and a vacuum of 0.3 torr to produce polyester with an intrinsic vi-scosity of 0.82.

Except that polyethylene naphthalate (melting point TmB1 = 270˚C) with an intrinsic viscosity of 0.82 was used as material for layer B1 and the extrusion temperature, longitudinal extension temperature, and transverse extension temperature were 290˚C, 140˚C, and 150˚C, respectively, the same procedure as in Example 1-1 was carried out to prepare a biaxially stretched film with a thickness of 50 $\mu$m having layer A with a thickness of 0.15 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics as in Example 1-1. In particular, it was found that the film was high in rupture elongation after moist heat treatment as compared with Examples 1-1. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Examples 1-21 to 1-23)

Except that the solid phase polymerization time in the third step was 10 hours, 11 hours, or 12 hours, the same procedure was carried out as in Example 1-1 to prepare polyethylene terephthalate samples with an intrinsic viscosity of 0.90, 1.0, or 1.2, respectively, and subsequently, except that the longitudinal drawing temperature was set to 95˚C, the same procedure was carried out as in Example 1-1 to prepare a biaxially stretched film with a thickness of 50 $\mu$m having layer A with a thickness of 0.15 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was high in rupture elongation after moist heat treatment as compared with Examples 1-1, and good in all characteristics. The resulting film was used to prepare a backsheet by the same procedure as in Example 1-1.
The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 1-24)

Except that the undermentioned coating material 1-16 was used as the coating material to form layer A, the same procedure as in Example 1-1 was carried out to prepare a biaxially stretched film with a thickness of 50 $\mu$m having layer A with a thickness of 0.03 $\mu$m formed on the surface.

<Coating material 1-16>

    · Electrically conductive material :a-4 5 parts by mass
    · Binder resin: b-1 2.5 parts by mass
    · Water: 92.5 parts by mass

The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics as in Example 1-1 and had a higher partial discharge voltage after UV irradiation than in Example 1-1. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Examples 1-25, 1-26, and 1-27)

Except that the undermentioned coating material 1-17, 1-18, or 1-19 was used as the coating material to form layer A, the same procedure as in Example 1-1 was carried out to prepare a biaxially stretched film with a thickness of 50 μm having layer A with a thickness of 0.15 μm formed on the surface.

<Coating material 1-17>

> · Electrically conductive material :a-1 18 parts by mass
> · Binder resin: b-1 3 parts by mass
> · Crosslinking agent: c-1 0.75 part by mass
> · Surface active agent: d-1 0.1 part by mass
> · Light stabilization agent: e-1 5 parts by mass
> · Water: 73.15 parts by mass

(Layer A contains titanium oxide as light stabilization agent which accounts for 11% by mass relative to layer A.)

<Coating material 1-18>

> · Electrically conductive material :a-1 18 parts by mass
> · Binder resin: b-1 3 parts by mass
> · Crosslinking agent: c-1 0.75 part by mass
> · Surface active agent: d-1 0.1 part by mass
> · Light stabilization Light stabilization g agent: e-1 10 parts by mass
> · Water: 68.15 parts by mass

(Layer A contains titanium oxide as light stabilization agent which accounts for 20% by mass relative to layer A.)

<Coating material 1-19>

> · Electrically conductive material :a-1 18 parts by mass
> · Binder resin: b-1 3 parts by mass
> · Crosslinking agent: c-1 0.75 part by mass
> · Surface active agent: d-1 0.1 part by mass
> · Light stabilization agent: e-2 10 parts by mass
> · Water: 73.15 parts by mass

(Layer A contains zinc oxide as light stabilization agent which accounts for 20% by mass relative to layer A.)
The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics as in Example 1-1 and had a higher partial discharge voltage after UV irradiation than in Example 1-1. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 1-28)

As the first step, 100 parts by mass of dimethyl terephthalate, 57.5 parts by mass of ethylene glycol, 0.06 parts by mass of magnesium acetate, and 0.03 parts by mass of antimony trioxide are melted at 150°C in a nitrogen atmosphere, and heated while stirring so that the temperature would reach 230°C in 3 hours, evaporating methanol to carry out ester interchange reaction. As the second step following the ester interchange reaction, an ethylene glycol solution (PH5.0) prepared by dissolving 0.019 parts by mass (equivalent to 1.9 mol/ton) of phosphoric acid and 0.027 parts by mass (equivalent to 1.5 mol/ton) of sodium dihydrogenphosphate dihydrate in 0.5 parts by mass of ethylene glycol was added.

As the third step, polymerization reaction is carried out under the conditions of a final temperature of 285°C and a vacuum of 0.1 torr to prepare polyester with an intrinsic viscosity of 0.54. As the fourth step, the resulting polyethylene terephthalate was dried at 160°C for 6 hours, crystallized, and solid-phase polymerized for 8 hours at 220°C and a vacuum of 0.3 torr to produce polyester with an intrinsic viscosity of 0.81.

Except that said polyester resin was used, the same procedure as in Example 1-1 was carried out to prepare a biaxially stretched film with a thickness of 50 $\mu$m having layer A with a thickness of 0.15 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics, and in particular, higher in rupture elongation after moist heat treatment as compared with Examples 1-1. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage

(Example 1-29)

To a twin screw extruder with a vacuum vent, 90 parts by mass of polyethylene terephthalate (melting point TmB1 = 255°C) with an intrinsic viscosity of 0.81 prepared by carrying out the same procedure as in Example 1-1 and 10 parts by mass of Stabaxol (supplied by Rhein Chemie Rheinau GmbH), used as end-sealing agent, are supplied, and then they are melt-kneaded at a temperature of 260°C and extruded in a thread-like shape into a water of 60°C, followed by quenching to form a strand. Subsequently, this was cut into pieces to provide master chips containing 10% end-sealing agent. Then, a mixture of 10 parts by mass of the resulting master batch and 90 parts by mass of polyethylene terephthalate (melting point TmB1 = 255°C) with an intrinsic viscosity of 0.81 prepared by the same procedure as in Example 1-1 was vacuum-dried at a temperature of 180°C for 3 hours and supplied to an extruder, and the same procedure as in Example 1-1 except for this was carried out to prepare a biaxially stretched film with a thickness of 50 $\mu$m having layer A with a thickness of 0.15 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics, and in particular, higher in rupture elongation after moist heat treatment as compared with Examples 1-1. Here, the nitrogen content in the film was 0.11% by mass. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 1-30)

A composite film production apparatus consisting of a primary extruder and a secondary extruder was set up, and the materials for the main layer, namely, 95 parts by mass of polyethylene terephthalate (melting point TmB1 = 255°C) with an intrinsic viscosity of 0.81 prepared by the same procedure as in Example 1-1 and vacuum-dried at a temperature of 180°C for 3 hours and 5 parts by mass of polymethylpentene dried for 5 hours in a hot air oven of 80°C were supplied to the primary extruder, melt-extruded at a temperature of 280°C, and introduced to the composite orifice of the T-die. On the other hand, the materials for layer B1, namely, polyethylene terephthalate (melting point Tomb1 = 255°C) with an intrinsic viscosity of 0.81 prepared by the same procedure as in Example 1-1 and vacuum-dried at a temperature of 180 °C for 3 hours was supplied to the secondary extruder, melt-extruded at a temperature of 280°C, and introduced to the composite orifice of the T-die. Subsequently, the mixtures were combined in said composite orifice of the T-die in such a manner that the resin layer extruded from the primary extruder is sandwiched between resin layers extruded from the secondary extruder (resin layer extruded from the secondary extruder / resin layer extruded from the primary extruder / resin layer extruded from the secondary extruder), and co-extruded into a sheet-like shape to produce a molten laminated sheet, and then said molten laminated sheet was electrostatically brought into close contact with a drum with a surface temperature of 25°C to achieve cooling and solidification to produce an unstretched laminated film. Except that said unstretched laminated film was used, the same procedure as in Example 1-1 was carried out to prepare a biaxially stretched film with a thickness of 50 $\mu$m having layer A with a thickness of 0.15 $\mu$m formed on the surface. The resulting film consists of a bubble-containing layer provided with layer B1 on both sides, and each layer B1 had a thickness of 10 $\mu$m. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 to 3. It was found that the film was good in all characteristics as in Examples 1-1, and in particular, higher in partial discharge voltage as compared with Examples 1-1. Here, the bubbles accounted for 25% by volume in the bubble-containing film.

(Examples 1-31 and 1-32)

Except that the same coating material as in Example 1-7 or 1-4 was used as the coating material to form layer A, the same procedure as in Example 1-7 was carried out to prepare a biaxially stretched film with a thickness of 50 $\mu$m having layer A with a thickness of 0.15 $\mu$m formed on the surface.
The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. Although the samples prepared in Example 1-31 and Example 1-32 were inferior to those in Example 1-6 and Examples 1-1 to 1-3, respectively, it was found that they did show a high partial discharge voltage, and they were good in all characteristics despite a lower rupture elongation after moist heat treatment as compared with Example 1-1. The resulting film was used to prepare a backsheet by the same procedure as in Example 1-1. The partial discharge voltage of the resulting backsheet was measured. Results are given in Table 3. Thus, it was found that although the samples prepared in Example 1-31 and Example 1-32 were inferior to those in Example 1-6 and Examples 1-1 to 1-3, respectively, they had a higher partial discharge voltage particularly when they had surface A formed on the external side.

(Examples 1-33 and 1-34)

Except that the same polyethylene terephthalate as in Example 1-23 was used and the longitudinal extension temperature was set to 95°C, the same procedure as in Example 1-31 or 1-32 was carried out to prepare a biaxially stretched film with a thickness of 50 $\mu$m having layer A with a thickness of 0.15 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. Although the samples prepared in Example 1-33 and Example 1-34 were inferior to those in Example 1-6 and Examples 1-1 to 1-3, respectively, it was found that they had a high partial discharge voltage, and they were higher in rupture elongation after moist heat treatment than in Example 1-1, showing that they were good in all characteristics. The resulting film was used to prepare a backsheet by the same procedure as in Example 1-1. The partial discharge voltage of the resulting backsheet was measured. Results are given in Table 3. Thus, it was found that although the samples prepared in Example 1-33 and Example 1-34 were inferior to those in Example 1-6 and Examples 1-1 to 1-3, respectively, they had a higher partial discharge voltage particularly when they had surface A formed on the external side.

(Examples 1-35 and 1-36)

Except that the same polyethylene terephthalate as in Example 1-16 was used and the longitudinal extension temperature was set to 90°C, the same procedure as in Example 1-31 or 1-32 was carried out to prepare a biaxially stretched film with a thickness of 50 $\mu$m having layer A with a thickness of 0.15 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. Although the samples prepared in Example 1-35 and Example 1-36 were inferior to those in Example 1-6 and Examples 1-1 to 1-3, respectively, it was found that they did show a high partial discharge voltage, and they were good in all characteristics despite a lower rupture elongation after moist heat treatment as compared with Example 1-1. The resulting film was used to prepare a backsheet by the same procedure as in Example 1-1. The partial discharge voltage of the resulting backsheet was measured. Results are given in Table 3. Thus, it was found that although the samples prepared in Example 1-35 and Example 1-36 were inferior to those in Example 1-6 and Examples 1-1 to 1-3, respectively, they had a higher partial discharge voltage particularly when they had surface A formed on the external side.

(Examples 1-37 and 1-38)

Except that the same polyethylene terephthalate as in Example 1-15 was used and the longitudinal extension temperature was set to 95°C, the same procedure as in Example 1-31 or 1-32 was carried out to prepare a biaxially stretched film with a thickness of 50 μm having layer A with a thickness of 0.15 μm formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. Although the' samples prepared in Example 1-37 and Example 1-38 were inferior to those in Example 1-6 and Examples 1-1 to 1-3, respectively, it was found that they did show a high partial discharge voltage, and they were good in all characteristics despite a lower rupture elongation after moist heat treatment as compared with Example 1-1. The resulting film was used to prepare a backsheet by the same procedure as in Example 1-1. The partial discharge voltage of the resulting backsheet was measured. Results are given in Table 3. Thus, it was found that although the samples prepared in Example 1-37 and Example 1-38 were inferior to those in Example 1-6 and Examples 1-1 to 1-3, respectively, they had a higher partial discharge voltage particularly when they had surface A formed on the external side.

(Examples 1-39 and 1-40)

Except that the same polyethylene terephthalate as in Example 1-21 was used and the longitudinal extension temperature was set to 95°C, the same procedure as in Example 1-31 or 1-32 was carried out to prepare a biaxially stretched film with a thickness of 50 μm having layer A with a thickness of 0.15 μm formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. Although the samples prepared in Example 1-39 and Example 1-40 were inferior to those in Example 1-6 and Examples 1-1 to 1-3, respectively, it was found that they had a high partial discharge voltage, and they were higher in rupture elongation after moist heat treatment than in Example 1-1, showing that they were good in all characteristics. The resulting film was used to prepare a backsheet by the same procedure as in Example 1-1. The partial discharge voltage of the resulting backsheet was measured. Results are given in Table 3. Thus, it was found that although the samples prepared in Example 1-39 and Example 1-40 were inferior to those in Example 1-6 and Examples 1-1 to 1-3, respectively, they had a higher partial discharge voltage particularly when they had surface A formed on the external side.

(Examples 1-41 and 1-42)

Except that the same polyethylene terephthalate as in Example 1-22 was used and the longitudinal extension temperature was set to 95°C, the same procedure as in Example 1-31 or 1-32 was carried out to prepare a biaxially stretched film with a thickness of 50 μm having layer A with a thickness of 0.15 μm formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. Although the samples prepared in Example 1-41 and Example 1-42 were inferior to those in Example 1-6 and Examples 1-1 to 1-3, respectively, it was found that they had a high partial discharge voltage, and they were higher in rupture elongation after moist heat treatment than in Example 1-1, showing that they were good in all characteristics. The resulting film was used to prepare a backsheet by the same procedure as in Example 1-1. The partial discharge voltage of the resulting backsheet was measured. Results are given in Table 3. Thus, it was found that although the samples prepared in Example 1-41 and Example 1-42 were inferior to those in Example 1-6 and Examples 1-1 to 1-3, respectively, they had a higher partial discharge voltage particularly when they had surface A formed on the external side.

(Example 2-1)

Except that layer A was not formed, the same procedure as in Example 1-1 was carried out to prepare a biaxially stretched film with a thickness of 50$\mu$m. The resulting film was placed in an electron beam deposition apparatus and aluminum with a purity of 99.999% was used as volatilization source to electron-beam-evaporate aluminum in the' normal direction to the film surface while introducing oxygen gas at 350 sccm under the conditions of a vacuum of 3.4 $\times$ 10$^{-5}$ Pa, a deposition rate of 10 angstrom/sec, and a source-substrate distance of 25 cm, in order to form layer A made of aluminum oxide with a thickness of 0.15 $\mu$m. The resulting film was subj ected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics as in Example 1-1. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Examples 2-2 and 2-3)

Except that the oxygen supply rate was set to 400 sccm or 500 sccm, the same procedure as in Example 2-1 was carried out to form layer A with a thickness of 0.15 $\mu$m on a biaxially stretched film with a thickness of 50$\mu$m. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics as in Example 2-1. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 2-1, and in particular, the one having surface A formed on the external side had a higher partial discharge voltage.

(Examples 2-4 and 2-5)

Except that the oxygen supply rate was set to 600 sccm or 330 sccm, the same procedure as in Example 2-1 was carried out to form layer A with a thickness of 0.15 $\mu$m on a biaxially stretched film with a thickness of 50$\mu$m. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although somewhat lower than in Examples 2-1 to 2-3, the film showed a high partial discharge voltage and had good characteristics. The resulting film was used to prepare a backsheet by the same procedure as in Example 1-1. The partial discharge voltage of the resulting backsheet was measured. Results are given in Table 3. Thus, it was found that although somewhat lower than in Examples 2-1 to 2-3, the film had a high partial discharge voltage, and in particular, the sample having surface A formed on the external side had a higher partial discharge voltage.

(Example 2-6)

Except that the oxygen supply rate was set to 320 sccm, the same procedure as in Example 2-1 was carried out to form layer A with a thickness of 0.15 $\mu$m on a biaxially stretched film with a thickness of 50$\mu$m. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although somewhat lower than in Examples 2-4 to 2-5, the film showed a high partial discharge voltage and had good characteristics. The resulting film was used to prepare a backsheet by the same procedure as in Example 1-1. The partial discharge voltage of the resulting backsheet was measured. Results are given in Table 3. Thus, it was found that although somewhat lower than in Examples 2-4 to 2-5, the film had a high partial discharge voltage, and'in particular, the sample having surface A formed on the external side had a higher partial discharge voltage.

(Example 2-7)

Except that the oxygen supply rate was set to 310 sccm, the same procedure as in Example 2-1 was carried out to form layer A with a thickness of 0.15 $\mu$m on a biaxially stretched film with a thickness of 50$\mu$m. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although somewhat lower than in Example 2-6, the film showed a high partial discharge voltage and had good characteristics. The resulting film was used to prepare a backsheet by the same procedure as in Example 1-1. The partial discharge voltage of the resulting backsheet was measured. Results are given in Table 3. Thus, it was found that although somewhat lower than in Examples 2-6, the film had a high partial discharge voltage, and in particular, the sample having surface A formed on the external side had a higher partial discharge voltage.

(Example 3-1)

Polyethylene terephthalate (melting point TmB1 = 255˚C) with an intrinsic viscosity of 0.81 prepared by the same procedure as in Example 1-1 was vacuum-dried at a temperature of 180˚C for 3 hours, and supplied to the primary extruder. The secondary extruder was set up separately from the primary extruder, and the materials for the main layer, namely, 85 parts by mass of polyethylene terephthalate (melting point TA = 255˚C) with an intrinsic viscosity of 0.81 prepared by the same procedure as in Example 1-1 and vacuum-dried at a temperature of 180˚C for 3 hours and 15 parts by mass of a polyether amide based electrically conductive polymer (Irgastat P18, supplied by Ciba Japan K.K.) vacuum-dried at 100˚C for 6 hours were supplied to the secondary extruder. Both components were melted at a temperature of 280˚C in a nitrogen atmosphere and combined in such manner that the layers of the components fed to the secondary extruders covered both sides of the layer of the component fed to the primary extruder at a ratio in thickness between the component layer from the primary extruder and each component layer from the secondary extruder of 9 : 1, and subjected to double molten layer stacked co-extrusion through the T-die orifice to prepare a laminated sheet, which was then electrostatically brought into close contact with a drum with a surface temperature maintained at 20˚C to achieve cooling and solidification to produce an unoriented (unstretched) laminated film. Except that the resulting unstretched film was used and that the film was not corona-treated and coated after longitudinal extension, the same procedure as in Example 1-1 was carried but to prepare a biaxially stretched film with a thickness of 50 $\mu$m having layer A with a thickness of 5 $\mu$m formed on the surface. The resulting film was subjected to measurement of the weight average molecular weight of layer B1, number average molecular weight, surface resistivity of surface A, rupture elongation, partial discharge voltage, and degree of heat shrinkage, as well as the surface resistivity, surface resistivity R2 of the surface opposite to surface A, rupture elongation, and partial discharge voltage after moist heat treatment. Results are given in Tables 1 and 2. It was found that the film was good in all these characteristics. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 3-2)

Master pellets were prepared by mixing 75 parts by mass of polyethylene terephthalate with an intrinsic viscosity of 0.81 prepared by the same procedure as in Example 1-1, 20 parts by mass of sodium dodecylbenzenesulfonate, and 5% by mass of polyethylene glycol with a polymerization degree of 400, and a mixture of 10 parts by mass of the master pellets and 90 parts by mass of polyethylene terephthalate (melting point TmA = 255˚C) with an intrinsic viscosity of 0.81 was vacuum-dried at a temperature of 180˚C-for 3 hours and used as the material to be supplied to the secondary extruder. Except for this, the same procedure as in Example 3-1 was carried out to prepare a biaxially stretched film with a thickness of 50 $\mu$m having layer A with a thickness of 5 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. Although no improvement in partial discharge voltage was seen after moist heat treatment, the film was found to be good in the other characteristics. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 3-3)

A mixture of 65 parts by mass of polyethylene terephthalate with an intrinsic viscosity of 0.81 prepared by the same procedure as in Example 1-1 (melting point TmA = 255˚C) and vacuum-dried at a temperature of 180˚C for 3 hours, 20 parts by mass of rutile type titanium oxide-containing PET with an average particle diameter of 230 nm (prepared by kneading PET with an intrinsic viscosity of 0.81 and titanium oxide at a mass ratio PET/titanium oxide of 1/1 in a twin screw extruder with vent) vacuum-dried at a temperature of 180˚C for 3 hours, and 15 parts by mass of a polyether amide based electrically conductive polymer (Irgastat P18, supplied by Ciba Japan K.K.) vacuum-dried at 100˚C for 6 hours was used as the material to be supplied to the secondary extruder (layer A contained titanium oxide as light stabilization agent up to a content of 10% by mass relative to layer A). Except for this, the same procedure as in Example 3-1 was carried out to prepare a biaxially stretched film with a thickness of 50 $\mu$m having layer A with a thickness of 5 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics, and in particular, had a higher partial discharge voltage after UV irradiation than in Example 1-1. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 3-4)

A mixture of 65 parts by mass of PET with an intrinsic viscosity of 0.81 prepared by the same procedure as in Example 1-1 (melting point TmA = 255˚C) and vacuum-dried at a temperature of 180˚C for 3 hours, 40 parts by mass of rutile type titanium oxide-containing PET with an average particle diameter of 230 nm (prepared by kneading PET with an intrinsic viscosity of 0.81 and titanium oxide at a mass ratio PET/titanium oxide of 1/1 in a twin screw extruder with vent) vacuum-dried at a temperature of 180˚C for 3 hours, and 15 parts by mass of a polyether amide based electrically conductive polymer (Irgastat P18, supplied by Ciba Japan K.K.) vacuum-dried at 100˚C for 6 hours was used as the material to be supplied to the secondary extruder (layer A contained titanium oxide as light stabilization agent at a content of 20% by mass relative to layer A) . Except for this, the same procedure as in Example 3-1 was carried out_ to prepare a biaxially stretched film with a thickness of 50 $\mu$m having layer A with a thickness of 5 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics, and in particular, had a higher partial discharge voltage after UV irradiation than in Example 3-3.
The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Example 3-5)

A mixture of 35 parts by mass of PET with an intrinsic viscosity of 0.81 prepared by the same procedure as in Example 1-1 (melting point TmA = 255˚C) and vacuum-dried at a temperature of 180˚C for 3 hours, 50 parts by mass of zinc oxide-containing PET with an average particle diameter of 30 nm (prepared by kneading PET with an intrinsic viscosity of 0.81 and zinc oxide at a mass ratio PET/zinc oxide of 8/2 in a twin screw extruder with vent) vacuum-dried at a temperature of 180˚C for 3 hours, and 15 parts by mass of a polyether amide based electrically conductive polymer (Irgastat P18, supplied by Ciba Japan K.K.) vacuum-dried at 100˚C for 6 hours was used as the material to be supplied to the secondary extruder (layer A contained zinc oxide as light stabilization agent at a content of 10% by mass relative to layer A). Except for this, the same procedure as in Example 3-1 was carried out to prepare a'biaxially stretched film with a thickness of 50 $\mu$m having layer A with a thickness of 5 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics, and in particular, had a higher partial discharge voltage after UV irradiation than in Example 3-3. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Examples 3-6 and 3-7)

A mixture of 65 parts by mass of PET with an intrinsic viscosity of 0.81 prepared by the same procedure as in Example 1-1 (melting point TmA = 255˚C) and vacuum-dried at a temperature of 180˚C for 3 hours, 40 parts by mass of rutile type titanium oxide-containing PET with an average particle diameter of 230 nm (prepared by kneading PET with an intrinsic viscosity of 0.81 and titanium oxide at a mass ratio PET/titanium oxide of 1/1 in a twin screw extruder with vent) vacuum-dried at a temperature of 180˚C for 3 hours, and 15 parts by mass of a polyether amide based electrically conductive polymer (Irgastat P18, supplied by Ciba Japan K.K.) vacuum-dried at 100˚C for 6 hours was used as the material to be supplied to the secondary extruder (layer A contained titanium oxide as light stabilization agent at a content of 20% by mass relative to layer A), and the layers of the components fed to the secondary extruders and the layer of the component fed to the primary extruder were combined in such a manner that the ratio in thickness between the component layer from the primary extruder and each component layer from the secondary extruders, which covered both sides of the former layer, was 24 : 1 or 48 : 1 and subjected to double molten layer stacked co-extrusion through the T-die. Except for this, the same procedure as in Example 3 - 1 was carried out to prepare a biaxially stretched film with a thickness of 50 $\mu$m having layer A with a thickness of 2 $\mu$m or 1 $\mu$m formed on each surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film was good in all characteristics, and in particular, had a higher partial discharge voltage after UV irradiation than in Example 3-1 although lower than in Example 3-5. The resulting film was used to prepare a backsheet by the same procedure as in Example 1-1. The partial discharge voltage of the resulting backsheet was measured. Results are given in Table 3. Thus, it was found that the samples had a high partial discharge voltage as in Example 1-1, and in particular, the one having surface A formed on the external side had a higher partial discharge voltage.

(Comparative example 1-1)

Except that layer A was not formed, the same procedure as in Example 1-1 was carried out to prepare a biaxially stretched film with a thickness of 50$\mu$m. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film had a lower partial discharge voltage than the samples without layer A. The resulting film was used to prepare a backsheet by the same procedure as in Example 1-1. The partial discharge voltage of the resulting backsheet was measured. Results are given in Table 3. It was found that the film had a lower partial discharge voltage than the samples without layer A.

(Comparative example 1-2)

Except that layer A was not formed, the same procedure as in Example 1-1 was carried out to prepare a biaxially stretched film with a thickness of 125 $\mu$m. The resulting film was subjected to measurement of the weight average molecular weight of layer B1, number average molecular weight, surface resistivity of surface A, rupture elongation, partial discharge voltage, and degree of heat shrinkage, as well as the surface resistivity, rupture elongation, and partial discharge voltage after moist heat treatment. Results are given in Tables 1 and 2. It was found that the film had'a lower partial discharge voltage than the samples without layer A. The resulting film was used to prepare a similar backsheet to the one prepared in Example 1-8. The partial discharge voltage of the resulting backsheet was measured. Results are given in Table 3. It was found that the film had a lower partial discharge voltage than the samples without layer A.

(Comparative example 1-3)

Except that layer A was not formed, the same procedure as in Example 1-1 was carried out to prepare a biaxially stretched film with a thickness of 188 $\mu$m. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film had a lower partial discharge voltage than the samples without layer A. The resulting film was used to prepare a backsheet by the same procedures as in Example 1-9. The partial discharge voltage of the resulting backsheet was measured. Results are given in Table 3. It was found that the film had a lower partial discharge voltage than the samples without layer A.

(Comparative example 1-4)

Except that the undermentioned coating material 1-15 was used as the coating material to form layer A, the same procedure as in Example 1-1 was carried out to prepare a biaxially stretched film with a thickness of 50 $\mu$m having layer A with a thickness of 0.03 $\mu$m.

<Coating material 1-15>

· Electrically conductive material :a-2 83 parts by mass
· Surface active agent: d-1 0.1 part by mass
· Water: 16.9 parts by mass

The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although lower in surface resistivity than in Examples, the film had a lower partial discharge voltage than the samples in Examples. The resulting film was used to prepare a backsheet by the same procedure as in Example 1-1. The partial discharge voltage of the resulting backsheet was measured. Results are given in Table 3. It was found that the film had a lower partial discharge voltage than the samples in Examples.

(Examples 1-5 to 1-7)

Except for using polyethylene terephthalate with an intrinsic viscosity 0.63 prepared under the conditions of a solid phase polymerization time of 2.5 hours in the third step, the same procedure was carried out to prepare a biaxially stretched film with a thickness of 50 $\mu$m having layer A with a thickness of 0.15 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 to 3. As compared with Examples 1-17, 1-13, and 1-32, the films had partial discharge voltage values in the same range, but they were largely inferior in rupture elongation after moist heat treatment and failed to have practical characteristics. A backsheet was formed from the resulting films as in Example 1-1 and subjected to measurement of their partial discharge voltage, showing that they had similar characteristics to the samples in Examples 1-17, 1-13, and 1-32. Thus, it was found that all samples had a high partial discharge voltage, and in particular, the one having surface A formed on the external side had a higher partial discharge voltage.

(Comparative example 2-1)

Except that the oxygen supply rate was set to 300 sccm, the same procedure as in Example 2-1 was carried out to form layer A with a thickness of 0. 15 $\mu$m on a biaxially stretched film with a thickness of 50 $\mu$m. The resulting film was subjected to measurement of the weight average molecular weight of layer B1, number average molecular weight, surface resistivity of surface A, surface resistivity of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that although lower in surface resistivity than in Examples, the film had a lower partial discharge voltage than the samples in Examples. The resulting film was used to prepare a backsheet by the same procedure as in Example 1-1. The partial discharge voltage of the resulting backsheet was measured. Results are given in Table 3. It was found that the film had a lower partial discharge voltage than the samples in Examples.

(Comparative example 2-2)

Except that alumina was used as deposition source, the same procedure as in Example 2-1 was carried out to form layer A with a thickness of 0.15 $\mu$m on a biaxially stretched film with a thickness of 50 $\mu$m. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film had a higher surface resistivity and a lower partial discharge voltage than the samples in Examples. The resulting film was used to prepare a backsheet by the same procedure as in Example 1-1. The partial discharge voltage of the resulting backsheet was measured. Results are given in Table 3. It was found that the film had a lower partial discharge voltage than the samples in Examples.

(Examples 3-1 and 3-2)

PET with an intrinsic viscosity of 0.81 prepared by the same procedure as in Example 1-1 (melting point TmA = 255˚C) and vacuum-dried at a temperature of 180˚C for 3 hours and rutile type titanium oxide-containing PET with an average particle diameter of 230 nm (prepared by kneading PET with an intrinsic viscosity of 0.81 and titanium oxide at a mass ratio PET/titanium oxide of 1/1 in a twin screw extruder with vent) vacuum-dried at a temperature of 180˚C for 3 hours were mixed at a mass ratio PET/ titanium oxide-containing PET of 8/2 or 6/4 (layer A contained titanium oxide as light stabilization agent at a content of 10 or 20% by mass relative to layer A) to prepare the material to be supplied to the secondary extruder. Except for this, the same procedure as in Example 3-1 was carried out to prepare a biaxially stretched film with a thickness of 50 $\mu$m having layer A with a thickness of 5 $\mu$m formed on the surface. The resulting film was subjected to measurement of the weight average molecular weight of layer B1, number average molecular weight, surface resistivity of surface A, surface resistivity R2 of the surface opposite to surface A, rupture elongation, partial discharge voltage, and degree of heat shrinkage, as well as the surface resistivity, rupture elongation, and partial discharge voltage after moist heat treatment. Results are given in Tables 1 and 2. It was found that the film had a higher surface resistivity and a lower partial discharge voltage than the samples in Examples. The resulting film was used to prepare a backsheet by the same procedure as in Example 1-1. The partial discharge voltage of the resulting backsheet was measured. Results are given in Table 3. It was found that the film had a lower partial discharge voltage than the samples in Examples.

<Table 1-1>

| | Conductive layer (layer A) | | | Base layer (layer B) | | | | | |
| | Film thickness (μm) | Thickness (μm) | Surface resistivity R0 (Ω/square) | Material | | | | Layer B | |
| | | | | Intrinsic viscosity | TmB1 (°C) | TmetaB1 (°C) | TmB1-TmetaB1 (°C) | Weight average molecular weight | Number average molecular weight |
|---|---|---|---|---|---|---|---|---|---|
| Example 1-1 | 50 | 0.15 | $6.0\times10^9$ | 0.81 | 255 | 190 | 65 | 43,000 | 12,000 |
| Example 1-2 | 50 | 0.15 | $3.0\times10^{11}$ | 0.81 | 255 | 190 | 65 | 43,000 | 12,000 |
| Example 1-3 | 50 | 0.15 | $8.0\times10^{12}$ | 0.81 | 255 | 190 | 65 | 43,000 | 12,000 |
| Example 1-4 | 50 | 0.15 | $5.0\times10^{13}$ | 0.81 | 255 | 190 | 65 | 43,000 | 12,000 |
| Example 1-5 | 50 | 0.03 | $5.0\times10^8$ | 0.81 | 255 | 190 | 65 | 43,000 | 12,000 |
| Example 1-6 | 50 | 0.03 | $3.0\times10^7$ | 0.81 | 255 | 190 | 65 | 43,000 | 12,000 |
| Example 1-7 | 50 | 0.03 | $8.5\times10^6$ | 0.81 | 255 | 190 | 65 | 43,000 | 12,000 |
| Example 1-8 | 125 | 0.15 | $6.0\times10^9$ | 0.81 | 255 | 190 | 65 | 43,000 | 12,000 |
| Example 1-9 | 188 | 0.15 | $6.0\times10^9$ | 0.81 | 255 | 190 | 65 | 43,000 | 12,000 |
| Example 1-10 | 50 | 0.15 | $2.0\times10^{10}$ | 0.81 | 255 | 190 | 65 | 43,000 | 12,000 |
| Example 1-11 | 50 | 0.15 | $6.5\times10^9$ | 0.81 | 255 | 190 | 65 | 43,000 | 12,000 |
| Example 1-12 | 50 | 0.15 | $4.0\times10^{11}$ | 0.81 | 255 | 190 | 65 | 43,000 | 12,000 |
| Example 1-13 | 50 | 0.15 | $1.0\times10^{11}$ | 0.81 | 255 | 190 | 65 | 43,000 | 12,000 |
| Example 1-14 | 50 | 0.15 | $4.0\times10^9$ | 0.81 | 255 | 190 | 65 | 43,000 | 12,000 |
| Example 1-15 | 50 | 0.15 | $6.0\times10^9$ | 0.75 | 255 | 190 | 65 | 40,500 | 10,750 |
| Example 1-16 | 50 | 0.15 | $6.0\times10^9$ | 0.70 | 255 | 190 | 65 | 39,000 | 10,250 |
| Example 1-17 | 50 | 0.15 | $6.0\times10^9$ | 0.66 | 255 | 190 | 65 | 38,000 | 9,750 |
| Example 1-18 | 50 | 0.15 | $6.0\times10^9$ | 0.81 | 255 | 210 | 45. | 43,000, | 12,000 |
| Example 1-19 | 50 | 0.15 | $6.0\times10^9$ | 0.81 | 255 | 160 | 95 | 43,000 | 12,000 |
| Example 1-20 | 50 | 0.15 | $6.0\times10^9$ | 0.82 | 270 | 220 | 50 | 43,000 | 12,000 |
| Example 1-21 | 50 | 0.15 | $6.0\times10^9$ | 0.90 | 255 | 190 | 65 | 44,000 | 17,000 |

| | Film thickness (μm) | Conductive layer (layer A) | | Base layer (layer B) | | | | | |
| | | Thickness (μm) | Surface resistivity R0 (Ω/square) | Material | | Layer B | | | |
| | | | | Intrinsic viscosity | TmB1 (˚C) | TmetaB1 (˚C) | TmB1-TmetaB1 (˚C) | Weight average molecular weight | Number average molecular weight |
| Example 1-22 | 50 | 0.15 | $6.0\times10^9$ | 1.0 | 255 | 190 | 65 | 46,000 | 19,500 |
| Example 1-23 | 50 | 0:15 | $1.0\times10^9$ | 1.2 | 255 | 190 | 65 | 47,000 | 20,500 |
| Example 1-24 | 50 | 0.03 | $5.0\times10^9$ | 0.81 | 255 | 190 | 65 | 43,000 | 12,000 |

<Table 1-2>

| | Film thickness ($\mu$m) | Conductive layer (layer A) | | Base layer (layer B) | | | | | | |
|---|---|---|---|---|---|---|---|---|---|---|
| | | | | Material | | Layer B1 | | | | |
| | | Thickness ($\mu$m) | Surface resistivity R0 ($\Omega$/square) | Intrinsic viscosity | TmB1 (°C) | TmetaB1 (°C) | TmB1-TmetaB1 (°C) | Weight average molecular weight | Number average molecular weight |
| Example 1-25 | 50 | 0.15 | $9.0 \times 10^9$ | 0.81 | 255 | 190 | 65 | 43,000 | 12,000 |
| Example 1-26 | 50 | 0.15 | $9.0 \times 10^9$ | 0.81 | 255 | 190 | 65 | 43,000 | 12,000 |
| Example 1-27 | 50 | 0.15 | $9.0 \times 10^9$ | 0.81 | 255 | 190 | 65 | 43,000 | 12,000 |
| Example 1-28 | 50 | 0.15 | $6.0 \times 10^9$ | 0.81 | 255 | 190 | 65 | 43,000 | 12,000 |
| Example 1-29 | 50 | 0.15 | $6.0 \times 10^9$ | 0.81 | 255 | 190 | 65 | 43,000 | 12,000 |
| Example 1-30 | 50 | 0.15 | $6.0 \times 10^9$ | 0.81 | 255 | 190 | 65 | 43,000 | 12,000 |
| Example 1-31 | 50 | 0.15 | $8.5 \times 10^6$ | 0.66 | 255 | 190 | 65 | 38,000 | 9,750 |
| Example 1-32 | 50 | 0.15 | $5.0 \times 10^{13}$ | 0.66 | 255 | 190 | 65 | 38,000 | 9,750 |
| Example 1-33 | 50 | 0.15 | $8.5 \times 10^6$ | 1.2 | 255 | 190 | 65 | 47,000 | 20,500 |
| Example 1-34 | 50 | 0.15 | $5.0 \times 10^{13}$ | 1.2 | 255 | 190 | 65 | 47,000 | 20,500 |
| Example 1-35 | 50 | 0.15 | $8.5 \times 10^6$ | 0.70 | 255 | 190 | 65 | 38,000 | 9,750 |
| Example 1-36 | 50 | 0.15 | $5.0 \times 10^{13}$ | 0.70 | 255 | 190 | 65 | 38,000 | 9,750 |
| Example 1-37 | 50 | 0.15 | $8.5 \times 10^6$ | 0.75 | 255 | 190 | 65 | 38,000 | 9,750 |
| Example 1-38 | 50 | 0.15 | $5.0 \times 10^{13}$ | 0.75 | 255 | 190 | 65 | 38,000 | 9,750 |
| Example 1-39 | 50 | 0.15 | $8.5 \times 10^6$ | 0.90 | 255 | 190 | 65 | 38,000 | 9,750 |
| Example 1-40 | 50 | 0.15 | $5.0 \times 10^{13}$ | 0.90 | 255 | 190 | 65 | 38,000 | 9,750 |
| Example 1-41 | 50 | 0.15 | $8.5 \times 10^6$ | 1.0 | 255 | 190 | 65 | 38,000 | 9,750 |
| Example 1-42 | 50 | 0.15 | $5.0 \times 10^{13}$ | 1.0 | 255 | 190 | 65 | 38,000 | 9,750 |

<Table 1-3>

| | Film thickness (μm) | Conductive layer (layer A) | | Base layer (layer B) | | | | | |
| | | | | Material | | Layer B1 | | | |
| | | Thickness (μm) | Surface resistivity R0 (Ω/square) | Intrinsic viscosity | TmB1 (°C) | TmetaB1 (°C) | TmB1-TmetaB1 (°C) | Weight average molecular weight | Number average molecular weight |
|---|---|---|---|---|---|---|---|---|---|
| Example 2-1 | 50 | 0.15 | $2.0 \times 10^9$ | 0.81 | 255 | 190 | 65 | 43,000 | 12,000 |
| Example 2-2 | 50 | 0.15 | $2.0 \times 10^{11}$ | 0.81 | 255 | 190 | 65 | 43,000 | 12,000 |
| Example 2-3 | 50 | 0.15 | $1.0 \times 10^{13}$ | 0.81 | 255 | 190 | 65 | 43,000 | 12,000 |
| Example 2-4 | 50 | 0.15 | $9.5 \times 10^{13}$ | 0.81 | 255 | 190 | 65 | 43,000 | 12,000 |
| Example 2-5 | 50 | 0.15 | $4.0 \times 10^8$ | 0.81 | 255 | 190 | 65 | 43,000 | 12,000 |
| Example 2-6 | 50 | 0.15 | $1.5 \times 10^7$ | 0.81 | 255 | 190 | 65 | 43,000 | 12,000 |
| Example 2-7 | 50 | 0.15 | $7.0 \times 10^6$ | 0.81 | 255 | 190 | 65 | 43,000 | 12,000 |
| Example 3-1 | 50 | 5 | $5.0 \times 10^{11}$ | 0.81 | 255 | 190 | 65 | 43,000 | 12,000 |
| Example 3-2 | 50 | 5 | $5.0 \times 10^{11}$ | 0.81 | 255 | 190 | 65 | 43,000 | 12,000 |
| Example 3-3 | 50 | 5 | $5.0 \times 10^{11}$ | 0.81 | 255 | 190 | 65 | 43,000 | 12,000 |
| Example 3-4 | 50 | 5 | $5.0 \times 10^{11}$ | 0.81 | 255 | 190 | 65 | 43,000 | 12,000 |
| Example 3-5 | 50 | 5 | $5.0 \times 10^{11}$ | 0.81 | 255 | 190 | 65 | 43,000 | 12,000 |
| Example 3-6 | 50 | 2 | $1.0 \times 10^{12}$ | 0.81 | 255 | 190 | 65 | 43,000. | 12,000 |
| Example 3-7 | 50 | 1 | $1.5 \times 10^{12}$ | 0.81 | 255 | 190 | 65 | 43,000 | 12,000 |
| Comparative example 1-1 | 50 | - | $4.0 \times 10^{15}$ | 0.81 | 255 | 190 | 65 | 43,000 | 12,000 |
| Comparative example 1-2 | 125 | - | $4.0 \times 10^{15}$ | 0.81 | 255 | 190 | 65 | 43,000 | 12,000 |
| Comparative example 1-3 | 188 | - | $4.0 \times 10^{15}$ | 0.81 | 255 | 190 | 65 | 43,000 | 12,000 |
| Comparative example 1-4 | 50 | 0.03 | $8.0 \times 10^5$ | 0.81 | 255 | 190 | 65 | 43,000 | 12,000 |

EP 2 437 307 A1

| | Film thickness (μm) | Conductive layer (layer A) | | Base layer (layer B) | | | | | |
| --- | --- | --- | --- | --- | --- | --- | --- | --- | --- |
| | | | | Material | | Layer B1 | | | |
| | | Thickness (μm) | Surface resistivity R0 (Ω/square) | Intrinsic viscosity | TmB1 (°C) | TmetaB1 (°C) | TmB1-TmetaB1 (°C) | Weight average molecular weight | Number average molecular weight |
| Comparative example 1-5 | 50 | 0.15 | $6.0 \times 10^9$ | 0.63 | 255 | 190 | 65 | 37,000 | 9,600 |
| Comparative example 1-6 | 50 | 0.03 | $8.5 \times 10^6$ | 0.63 | 255 | 190 | 65 | 37,000 | 9,600 |
| Comparative example 1-7 | 50 | 0.15 | $5.0 \times 10^{13}$ | 0.63 | 255 | 190 | 65 | 37,000 | 9,600 |
| Comparative example 2-1 | 50 | 0.15 | $7.0 \times 10^5$ | 0.81 | 255 | 190 | 65 | 43,000 | 12,000 |
| Comparative example 2-2 | 50 | 0.15 | $2.0 \times 10^{15}$ | 0.81 | 255 | 190 | 65 | 43,000 | 12,000 |
| Comparative example 3-1 | 50 | - | $4.0 \times 10^{15}$ | 0.81 | 255 | 190 | 65 | 43,000 | 12,000 |
| Comparative example 3-2 | 50 | - | $4.0 \times 10^{15}$ | 0.81 | 255 | 190 | 65 | 43,000 | 12,000 |

EP 2 437 307 A1

<Table 2-1>

| | Surface resistivity of surface opposite to surface A R2 ($\Omega$/quare) | Rupture elongation E0 (%) | Partial discharge voltage V0 (V) | Heat shrinkage (%) | Conductive layer (layer A) | | Rupture elongation E1 (%) | Elongation retention rate (%) | Partial discharge voltage V1(V) | Partial discharge voltage V2 (V) |
|---|---|---|---|---|---|---|---|---|---|---|
| | | | | | Surface resistivity R1 ($\Omega$/square) | | | | | |
| Example 1-1 | $4.5\times10^{15}$ | 180 | 600 | ○ | $9.5\times10^{9}$ | 155 | 86.1 | 600 | 500 |
| Example 1-2 | $4.5\times0^{15}$ | 180 | 600 | ○ | $6.0\times10^{11}$ | 155 | 86.1 | 600 | 500 |
| Example 1-3 | $4.5\times10^{15}$ | 180 | 600 | ○ | $1.0\times10^{13}$ | 155 | 86.1 | 600 | 500 |
| Example 1-4 | $4.5\times10^{15}$ | 180 | 540 | ○ | $5.0\times10^{13}$ | 155 | 86.1 | 540 | 490 |
| Example 1-5 | $4.5\times10^{15}$ | 180 | 540 | ○ | $9.0\times10^{8}$ | 155 | 86.1 | 540 | 490 |
| Example 1-6 | $4.5\times10^{15}$ | 180 | 520 | ○ | $5.0\times10^{7}$ | 155 | 86.1 | 520 | 480 |
| Example 1-7 | $4.5\times10^{15}$ | 180 | 500 | ○ | $9.5\times10^{6}$ | 155 | 86.1 | 500 | 470 |
| Example 1-8 | $4.5\times10^{15}$ | 180 | 840 | ○ | $9.5\times10^{9}$ | 150 | 83.3 | 800 | 700 |
| Example 1-9 | $4.5\times10^{15}$ | 180 | 1100 | ○ | $9.5\times10^{9}$ | 145 | 80.6 | 1,100 | 950 |
| Example 1-10 | $4.5\times10^{15}$ | 180 | 600 | ○ | $1.5\times10^{12}$ | 150 | 83.3 | 600 | 500 |
| Example 1-11 | $4.5\times10^{15}$ | 180 | 600 | ○ | $8.5\times10^{8}$ | 150 | 83.3 | 540 | 490 |
| Example 1-12 | $4.5\times10^{15}$ | 180 | 600 | ○ | $6.0\times10^{11}$ | 50 | 83.3 | 600 | 500 |
| Example 1-13 | $4.5\times10^{15}$ | 180 | 600 | ○ | $9.5\times10^{13}$ | 150 | 83.3 | 500 | 470 |
| Example 1-14 | $4.5\times10^{15}$ | 180 | 600 | ○ | $1.0\times10^{15}$ | 150 | 83.3 | 480 | 470 |
| Example 1-15 | $4.5\times10^{15}$ | 180 | 600 | ○ | $9.5\times10^{9}$ | 135 | 75.0 | 600 | 500 |
| Example 1-16 | $4.5\times10^{15}$ | 180 | 600 | ○ | $9.5\times10^{9}$ | 125 | 69.4 | 600 | 500 |

EP 2 437 307 A1

48

(continued)

| | Surface resistivity of surface opposite to surface A R2 ($\Omega$/quare) | Rupture elongation E0 (%) | Partial discharge voltage V0 (V) | Heat shrinkage (%) | Conductive layer (layer A) | Rupture elongation E1 (%) | Elongation retention rate (%) | Partial discharge voltage V1(V) | Partial discharge voltage V2 (V) |
|---|---|---|---|---|---|---|---|---|---|
| | | | | | Surface resistivity R1 ($\Omega$/square) | | | | |
| Example 1-17 | $4.5 \times 10^{15}$ | 180 | 600 | ○ | $9.5 \times 10^9$ | 110 | 61.1 | 600 | 500 |
| Example 1-18 | $4.5 \times 10^{15}$ | 180 | 600 | ○ | $9.5 \times 10^9$ | 140 | 77.8 | 600 | 500 |
| Example 1-19 | $4.5 \times 10^{15}$ | 180 | 600 | △ | $9.5 \times 10^9$ | 140 | 77.8 | 600 | 500 |
| Example 1-20 | $4.5 \times 10^{15}$ | 180 | 600 | ○ | $9.5 \times 10^9$ | 160 | 88.9 | 600 | 500 |
| Example 1-21 | $4.5 \times 10^{15}$ | 180 | 600 | ○ | $9.5 \times 10^9$ | 155 | 90.5 | 600 | 500 |
| Example 1-22 | $4.5 \times 10^{15}$ | 180 | 600 | ○ | $9.5 \times 10^9$ | 155 | 92.6 | 600 | 500 |
| Example 1-23 | $4.5 \times 10^{15}$ | 180 | 600 | ○ | $9.5 \times 10^9$ | 155 | 95.0 | 600 | 500 |
| Example 1-24 | $4.5 \times 10^{15}$ | 180 | 600 | ○ | $5.0 \times 10^9$ | 155 | 86.1 | 600 | 510 |

<Table 2-2>

| | Surface resistivity of surface opposite to surface A R2 ($\Omega$/square) | Rupture elongation E0 (%) | Partial discharge voltage V0(V) | Heat shrinkage (%) | Conductive layer (layer A) | | Rapture elongation E1 (%) | Elongation retention (%) | Partial discharge rate voltage V1 (V) | Partial discharge voltage V2 (V) |
|---|---|---|---|---|---|---|---|---|---|---|
| | | | | | | Surface resistivity R1 ($\Omega$/square) | | | | |
| Example 1-25 | $4.5\times10^{15}$ | 180 | 600 | ○ | $9.0\times10^9$ | 155 | 86.1 | 600 | 510 |
| Example 1-26 | $4.5\times10^{15}$ | 180 | 600 | ○ | $9.0\times10^9$ | 155 | 86.1 | 600 | 520 |
| Example 1-27 | $4.5\times10^{15}$ | 180 | 600 | ○ | $9.0\times10^9$ | 155 | 86.1 | 600 | 520 |
| Example 1-28 | $4.5x10^{15}$ | 180 | 600 | ○ | $9.0\times10^9$ | 163 | 90.6 | 600 | 500 |
| Example 1-29 | $4.5\times10^{15}$ | 180 | 600 | ○ | $9.0\times10^9$ | 170 | 94.4 | 600 | 500 |
| Example 1-30 | $4.5\times10^{15}$ | 135 | 630 | ○ | $9.0\times10^9$ | 110 | 81.5 | 630 | 525 |
| Example 1-31 | $4.5\times10^{15}$ | 180 | 500 | ○ | $9.0\times10^6$ | 110 | 61.1 | 500 | 470 |
| Example 1-32 | $4.5\times10^{15}$ | 180 | 540 | ○ | $5,0\times10^{13}$ | 110 | 61.1 | 540 | 490 |
| Example 1-33 | $4.5\times10^{15}$ | 180 | 500 | ○ | $9.0\times10^6$ | 155 | 95.0 | 500 | 470 |
| Example 1-34 | $4.5\times10^{15}$ | 180 | 540 | ○ | $5.0\times10^{13}$ | 155 | 95.0 | 540 | 490 |
| Example 1-35 | $4.5\times10^{15}$ | 180 | 500 | ○ | $9.0\times10^6$ | 125 | 69.4 | 500 | 470 |
| Example 1-36 | $4.5\times10^{15}$ | 180 | 540 | ○ | $5.0\times10^{13}$ | 125 | 69.4 | 540 | 490 |

(continued)

| | Surface resistivity of surface opposite to surface A R2 ($\Omega$/square) | Rupture elongation E0 (%) | Partial discharge voltage V0 (V) | Heat shrinkage (%) | Conductive layer (layer A) Surface resistivity R1 ($\Omega$/square) | Rapture elongation E1 (%) | Elongation retention (%) | Partial dischargerate voltage V1 (V) | Partial discharge voltage V2 (V) |
|---|---|---|---|---|---|---|---|---|---|
| Example 1-37 | $4.5\times10^{15}$ | 180 | 500 | ○ | $9.0\times10^{6}$ | 135 | 75.0 | 500 | 470 |
| Example 1-38 | $4.5\times10^{15}$ | 180 | 540 | ○ | $5.0\times10^{13}$ | 135 | 75.0 | 540 | 490 |
| Example 1-39 | $4.5\times10^{15}$ | 180 | 500 | ○ | $9.0\times10^{6}$ | 155 | 90.5 | 500 | 470 |
| Example 1-40 | $4.5\times10^{15}$ | 180 | 540 | ○ | $5.0\times10^{13}$ | 155 | 90.5 | 540 | 490 |
| Example 1-41 | $4.5\times10^{15}$ | 180 | 500 | ○ | $9.0\times10^{6}$ | 155 | 92.6 | 500 | 470 |
| Example 1-42 | $4.5\times10^{15}$ | 180 | 540 | ○ | $5.0\times10^{13}$ | 155 | 92.6 | 540 | 490 |

<Table 2-3>

| | Surface resistivity of surface opposite to surface A R2 (Ω/square) | Rupture elongation E0 (%) | Partial discharge voltage V0 (V) | Heat shrinkage (%) | Conductive layer (layer A) Surface resistivity R1 (Ω/square) | Rupture elongation E1 (%) | Elongation retention rate (%) | Partial discharge voltage V1 (V) | Partial discharge voltage V2 (V) |
|---|---|---|---|---|---|---|---|---|---|
| Example 2-1 | $4.5 \times 10^{15}$ | 180 | 600 | ○ | $2.5 \times 10^{9}$ | 155 | 86.1 | 600 | 600 |
| Example 2-2 | $4.5 \times 10^{15}$ | 180 | 600 | ○ | $2.5 \times 10^{11}$ | 155 | 86.1 | 600 | 600 |
| Example 2-3 | $4.5 \times 10^{15}$ | 180 | 600 | ○ | $1.5 \times 10^{13}$ | 155 | 86.1 | 600 | 600 |
| Example 2-4 | $4.5 \times 10^{15}$ | 180 | 540 | ○ | $9.5 \times 10^{13}$ | 155 | 86.1 | 540 | 540 |
| Example 2-5 | $4.5 \times 10^{15}$ | 180 | 540 | ○ | $8.0 \times 10^{8}$ | 155 | 86.1 | 540 | 540 |
| Example 2-6 | $4.5 \times 10^{15}$ | 180 | 520 | ○ | $7.5 \times 10^{7}$ | 55 | 86:1 | 520 | 520 |
| Example 2-7 | $4.5 \times 10^{15}$ | 180 | 500 | ○ | $9.0 \times 10^{6}$ | 155 | 86.1 | 500 | 500 |
| Example 3-1 | $4.5 \times 10^{15}$ | 180 | 600 | ○ | $5.0 \times 10^{11}$ | 155 | 86.1 | 600 | 530 |
| Example 3-2 | $4.5 \times 10^{15}$ | 180 | 600 | ○ | $5.0 \times 10^{11}$ | 155 | 86.1 | 470 | 470 |
| Example 3-3 | $4.5 \times 10^{15}$ | 180 | 600 | ○ | $5.0 \times 10^{11}$ | 155 | 86.1 | 600 | 550 |
| Example 3-4 | $4.5 \times 10^{15}$ | 180 | 600 | ○ | $5.0 \times 10^{11}$ | 155 | 86.1 | 600 | 580 |
| Example 3-5 | $4.5 \times 10^{15}$ | 180 | 600 | ○ | $5,0 \times 10^{11}$ | 155 | 86.1 | 600 | 580 |
| Example 3-6 | $4.5 \times 10^{15}$ | 180 | 600 | ○ | $1.0 \times 10^{12}$ | 155 | 86.1 | 600 | 550 |
| Example 3-7 | $4.5 \times 10^{15}$ | 180 | 600 | ○ | $1.5 \times 10^{12}$ | 155 | 86.1 | 600 | 520 |
| Comparative example 1-1 | $4.5 \times 10^{15}$ | 180 | 470 | ○ | $4.5 \times 10^{15}$ | 150 | 83.3 | 470 | 470 |
| Comparative example 1-2 | $4.5 \times 10^{15}$ | 180 | 670 | ○ | $4.5 \times 10^{15}$ | 145 | 80.6 | 670 | 500 |
| Comparative example 1-3 | $4.5 \times 10^{15}$ | 180 | 800 | ○ | $4.5 \times 10^{15}$ | 140 | 77.8 | 800 | 520 |
| Comparative example 1-4 | $4.5 \times 10^{15}$ | 180 | 450 | ○ | $9.0 \times 10^{5}$ | 150 | 83.3 | 450 | 450 |

52

| | Surface resistivity of surface opposite to surface A R2 ($\Omega$/square) | Rupture elongation E0 (%) | Partial discharge voltage V0 (V) | Heat shrinkage (%) | Conductive layer (layer A) | Rupture elongation E1 (%) | Elongation retention rate (%) | Partial discharge voltage V1 (V) | Partial discharge voltage V2 (V) |
| | | | | | Surface resistivity R1 ($\Omega$/square) | | | | |
|---|---|---|---|---|---|---|---|---|---|
| Comparative example 1-5 | $4.5 \times 10^{15}$ | 180 | 600 | ○ | $9.5 \times 10^{9}$ | 63 | 35.2 | 600 | 500 |
| Comparative example 1-6 | $4.5 \times 10^{15}$ | 180 | 500 | ○ | $9.5 \times 10^{6}$ | 63 | 35.2 | 500 | 470 |
| Comparative example 1-7 | $4.5 \times 10^{15}$ | 180 | 540 | ○ | $5.0 \times 10^{13}$ | 63 | 35.2 | 540 | 490 |
| Comparative example 2-1 | $4.5 \times 10^{15}$ | 180 | 450 | ○ | $4.5 \times 10^{5}$ | 150 | 83.3 | 450 | 450 |
| Comparative example 2-2 | $4.5 \times 10^{15}$ | 180 | 470 | ○ | $2.0 \times 10^{15}$ | 150 | 83.3 | 470 | 470 |
| Comparative example 3-1 | $4.5 \times 10^{15}$ | 180 | 450 | ○ | $4.0 \times 10^{15}$ | 150 | 83.3 | 450 | 450 |
| Comparative example 3-2 | $4.5 \times 10^{15}$ | 180 | 450 | ○ | $4.0 \times 10^{15}$ | 150 | 83.3 | 450 | 450 |

<Table 3-1>

| | First layer | Second layer | | Third layer | | Total film thickness ($\mu$m) | Partial discharge voltage (V) | |
|---|---|---|---|---|---|---|---|---|
| | Film thickness ($\mu$m) | Type | Film thickness ($\mu$m) | Type | Film thickness ($\mu$m) | | Inner side of layer A | Outer side of layer A |
| Example 1-1 | 50 | PET | 125 | Alumina-depositedPET | 12 | 188 | 1,100 | 1,000 |
| Example 1-2 | 50 | PET | 125 | Alumina-depositedPET | 12 | 188 | 1,100 | 1,000 |
| Example 1-3 | 50 | PET | 125 | Alumina-deposited PET | 12 | 188 | 1,100 | 1,000 |
| Example 1-4 | 50 | PET | 125 | Alumina-deposited PET | 12 2 | 188 | 990 | 900 |
| Example 1-5 | 50 | PET | 125 | Alumina-deposited PET | 12 | 188 | 990 | 900 |
| Example 1-6 | 50 | PET | 125 | Alumina-deposited PET | 12 | 188 | 950 | 860 |
| Example 1-7 | 50 | PET | 125 | Alumina-deposited PET | 12 | 188 | 920 | 840 |
| Example 1-8 | 125 | PET | 50 | Alumina-deposited PET | 12 | 188 | 1,100 | 1,000 |
| Example 1-9 | 188 | Alumina | 0.2 | - | - | 188 | 1,100 | 1,050 |
| Example 1-10 | 50 | PET | 125 | Alumina-deposited PET | 12 | 188 | 1,100 | 1,000 |
| Example 1-11 | 50 | PET | 125 | Alumina-deposited PET | 12 | 188 | 1,100 | 1,000 |
| Example 1-12 | 50 | PET | 125 | Alumina-deposited PET | 12 | 188 | 1,100 | 1,000 |
| Example 1-13 | 50 | PET | 125 | Alumina-deposited PET | 12 | 188 | 1,100 | 1,000 |
| Example 1-14 | 50 | PET | 125 | Alumina-deposited PET | 12 | 188 | 1,100 | 1,000 |
| Example 1-15 | 50 | PET | 125 | Alumina-deposited PET | 12 | 188 | 1,100 | 1,000 |
| Example 1-16 | 50 | PET | 125 | Alumina-depositedPET | 12 | 188 | 1,100 | 1,000 |
| Example 1-17 | 50 | PET | 125 | Alumina-deposited PET | 12 | 188 | 1,100 | 1,000 |
| Example 1-18 | 50 | PET | 125 | Alumina-deposited PET | 12 | 188 | 1,100 | 1,000 |
| Example 1-19 | 50 | PET | 125 | Alumina-deposited PET | 12 | 188 | 1,100 | 1,000 |
| Example 1-20 | 50 | PET | 125 | Alumina-deposited PET | 12 | 188 | 1,100 | 1,000 |

(continued)

| | First layer | Second layer | | Third layer | | Total film thickness (μm) | Partial discharge voltage (V) | |
|---|---|---|---|---|---|---|---|---|
| | Film thickness (μm) | Type | Film thickness (μm) | Type | Film thickness (μm) | | Inner side of layer A | Outer side of layer A |
| Example 1-21 | 50 | PET | 125 | Alumina-deposited PET | 12 | 188 | 1,100 | 1,000 |
| Example 1-22 | 50 | PET | 125 | Alumina-deposited PET | 12 | 188 | 1,100 | 1,000 |
| Example 1-23 | 50 | PET | 125 | Alumina-deposited PET | 12 | 188 | 1,100 | 1,000 |
| Example 1-24 | 50 | PET | 125 | Alumina-deposited PET | 12 | 188 | 1,100 | 1,000 |

<Table 3-2>

| | First layer | Second layer | | Third layer | | Total film thickness (μm) | Partial discharge voltage (V) | |
|---|---|---|---|---|---|---|---|---|
| | Film thickness (μm) | Type | Film thickness (μm) | Type | Film thickness (μm) | | Inner side of layer A | Outer side of layer A |
| Example 1-25 | 50 | PET | 125 | Alumina-deposited PET | 12 | 188 | 1,100 | 1,000 |
| Example 1-26 | 50 | PET | 125 | Alumina-deposited PET | 12 | 188 | 1,100 | 1,000 |
| Example 1-27 | 50 | PET | 125 | Alumina-depositedPET | 12 | 188 | 1,100 | 1,000 |
| Example 1-28 | 50 | PET | 125 | Alumina-deposited PET | 12 | 188 | 1,100 | 1,000 |
| Example 1-29 | 50 | PET | 125 | Alumina-deposited PET | 12 | 188 | 1,100 | 1,000 |
| Example 1-30 | 50 | PET | 125 | Alumina-deposited PET | 12 | 188 | 1,150 | 1,050 |
| Example 1-31 | 50 | PET | 125 | Alumina-deposited PET | 12 | 188 | 920 | 840 |
| Example 1-32 | 50 | PET | 125 | Alumina-deposited PET | 12 | 188 | 990 | 900 |
| Example 1-33 | 50 | PET | 125 | Alumina-deposited PET | 12 | 188 | 920 | 840 |
| Example 1-34 | 50 | PET | 125 | Alumina-deposited PET | 12 | 188 | 990 | 900 |
| Example 1-35 | 50 | PET | 125 | Alumina-deposited PET | 12 | 188 | 920 | 840 |
| Example 1-36 | 50 | PET | 125 | Alumina-deposited PET | 12 | 188 | 990 | 900 |
| Example 1-37 | 50 | PET | 125 | Alumina-deposited PET | 12 | 188 | 920 | 840 |

(continued)

| | First layer | Second layer | | Third layer | | Total film thickness (μm) | Partial discharge voltage (V) | |
|---|---|---|---|---|---|---|---|---|
| | Film thickness (μm) | Type | Film thickness (μm) | Type | Film thickness (μm) | | Inner side of layer A | Outer side of layer A |
| Example 1-38 | 50 | PET | 125 | Alumina-deposited PET | 12 | 188 | 990 | 900 |
| Example 1-39 | 50 | PET | 125 | Alumina-deposited PET | 12 | 188 | 920 | 840 |
| Example 1-40 | 50 | PET | 125 | Alumina-deposited PET | 12 | 188 | 990 | 900 |
| Example 1-41 | 50 | PET | 125 | Alumina-deposited PET | 12 | 188 | 920 | 840 |
| Example 1-42 | 50 | PET | 125 | Alumina-deposited PET | 12 | 188 | 990 | 900 |

<Table 3-3>

| | First layer | Second layer | | Third layer | | Total film thickness (μm) | Partial discharge voltage (V) | |
|---|---|---|---|---|---|---|---|---|
| | Film thickness (μm) | Type | Film thickness (μ m) | Type | Film thickness (μm) | | Inner side of layer A | Outer side of layer A |
| Example 2-1 | 50 | PET | 125 | Alumina-deposited PET | 12 | 188 | 1,100 | 1,000 |
| Example 2-2 | 50 | PET | 125 | Alumina-deposited PET | 12 | 188 | 1,100 | 1,000 |
| Example 2-3 | 50 | PET | 125 | Alumina-deposited PET | 12 | 188 | 1,100 | 1,000 |
| Example 2-4 | 50 | PET | 125 | Alumina-deposited PET | 12 | 188 | 990 | 900 |
| Example 2-5 | 50 | PET | 125 | Alumina-deposited PET | 12 | 188 | 990 | 900 |
| Example 2-6 | 50 | PET | 125 | Alumina-deposited PET | 12 | 188 | 950 | 860 |
| Example 2-7 | 50 | PET | 125 | Alumina-deposited PET | 12 | 188 | 920 | 840 |
| Example 3-1 | 50 | PET | 125 | Alumina-deposited PET | 12 | 188 | 1,100 | 1,000 |

(continued)

| | First layer | Second layer | | Third layer | | Total film thickness (µm) | Partial discharge voltage (V) | |
|---|---|---|---|---|---|---|---|---|
| | Film thickness (µm) | Type | Film thickness (µm) | Type | Film thickness (µm) | | Inner side of layer A | Outer side of layer A |
| Example 3-2 | 50 | PET | 125 | Alumina-deposited PET | 12 | 188 | 1,100 | 1,000 |
| Example 3-3 | 50 | PET | 125 | Alumina-deposited PET | 12 | 188 | 1,100 | 1,000 |
| Example 3-4 | 50 | PET | 125 | Alumina-deposited PET | 12 | 188 | 1,100 | 1,000 |
| Example 3-5 | 50 | PET | 125 | Alumina-deposited PET | 12 | 188 | 1,100 | 1,000 |
| Example 3-6 | 50 | PET | 125 | Alumina-deposited PET | 12 | 188 | 1,100 | 1,000 |
| Example 3-7 | 50 | PET | 125 | Alumina-deposited PET | 12 | 188 | 1,100 | 1,000 |
| Comparative example 1-1 | 50 | PET | 125 | Alumina-deposited PET | 12 | 188 | 800 | |
| Comparative example 1-2 | 125 | PET | 50 | Alumina-deposited PET | 12 | 188 | 800 | |
| Comparative example 1-3 | 188 | Alumina | 0.2 | - | - | 188 | 800 | |
| Comparative example 1-4 | 50 | PET | 125 | Alumina-deposited PET | 12 | 188 | 780 | |
| Comparative example 1-5 | 50 | PET | 125 | Alumina-deposited PET | 12 | 188 | 1,100 | 1,000 |
| Comparative example 1-6 | 50 | PET | 125 | Alumina-deposited PET | 12 | 188 | 920 | 840 |
| Comparative example 1-7 | 50 | PET | 125 | Alumina-deposited PET | 12 | 188 | 990 | 900 |
| Comparative example 2-1 | 50 | PET | 125 | Alumina-deposited PET | 12 | 188 | 780 | |
| Comparative example 2-2 | 50 | PET | 125 | Alumina-deposited PET | 12 | 188 | 800 | |

(continued)

|  | First layer | Second layer | | Third layer | | Total film thickness (μm) | Partial discharge voltage (V) | |
|---|---|---|---|---|---|---|---|---|
|  | Film thickness (μm) | Type | Film thickness (μ m) | Type | Film thickness (μm) |  | Inner side of layer A | Outer side of layer A |
| Comparative example 3-1 | 50 | PET | 125 | Alumina-deposited PET | 12 | 188 | 780 | |
| Comparative example 3-2 | 50 | PET | 125 | Alumina-deposited PET | 12 | 188 | 780 | |

[Industrial applicability]

The film for sealing the back of solar cells according to the invention can be used effectively for not only solar cells for installation on roofs, but also for flexible solar cells and electronic parts.

[Explanation of numerals]

1: solar cell backsheet
2: transparent filler
3: power generation device
4: transparent substrate
5: solar cell backsheet surface facing resin layer 2
6: solar cell backsheet surface opposite to resin layer 2

**Claims**

1. A solar cell backsheet film having a multilayered configuration composed of at least two or more layers including a layer (hereinafter referred to as layer A) having a surface with a surface resistivity R0 of not less than $10^6$ Ω/square and not more than $10^{14}$ Ω/square (hereinafter referred to as surface A) and a base layer (hereinafter referred to as layer B) wherein layer B contains a layer (hereinafter referred to as layer B1) comprising polyester, said polyester of layer B1 having an weight average molecular weight of not less than 37,500 and not more than 60,000.

2. A solar cell backsheet film as claimed in Claim 1 wherein surface A has a surface resistivity R1 in the range of $10^6$ Ω/square to $10^{14}$ Ω/square after leaving said film to stand for 24 hours under the conditions of a temperature of 125˚C and a humidity of 100%.

3. A solar cell backsheet film as claimed in either Claim 1 or 2 wherein said polyester has an intrinsic viscosity (IV) of not less than 0.65 and contains not more than 15 eq/t of terminal carboxyl groups.

4. A solar cell backsheet film as claimed in any of Claims 1 to 3 wherein layer B1 contains buffering agents in the range of not less than 0.1 mol/t and not more than 5.0 mol/t.

5. A solar cell backsheet film as claimed in any of Claims 1 to 4 wherein layer B1 contains nitrogen in the range of not less than 0.01% by mass and not more than 0.5% by mass.

6. A solar cell backsheet film as claimed in any of Claims 1 to 5 wherein the resin constituting layer B1 comprises polyethylene-2,6-naphthalate as main component.

7. A solar cell backsheet film as claimed in any of Claims 1 to 6 wherein layer B1 is oriented biaxially and has a plane orientation factor of not less than 0.16.

8. A solar cell backsheet film as claimed in any of Claims 1 to 7 wherein the minute endothermic peak temperature of layer B1, TmetaB1, determined by differential scanning calorimetry (DSC) and the melting point of layer B1, TmB1, satisfy the following formula (5) :

$$40°C \leq TmB1 - TmetaB1 \leq 90°C \qquad (5)$$

9. A solar cell backsheet film as claimed in any of Claims 1 to 8 wherein layer A has a thickness of not less than 0.01 $\mu$m and not more than 1 $\mu$m.

10. A solar cell backsheet film as claimed in any of Claims 1 to 9 wherein layer A has a thickness of not less than 1 $\mu$m and not more than 50 $\mu$m.

11. A solar cell backsheet film as claimed in any of Claims 1 to 10 wherein layer A contains a cationic conductive compound having an acrylic skeleton as conductive material, a compound having an acrylic skeleton as water-insoluble resin, and an oxazoline compound as cross-linking agent.

12. A solar cell backsheet film as claimed in any of Claims 1 to 11 wherein layer A contains a light stabilizing agent in the range of not less than 0.1% by mass and not more than 50% by mass.

13. A solar cell backsheet film as claimed in any of Claims 1 to 12 wherein the surface opposite to surface A has a surface resistivity R2 of not less than $10^{19}$ $\Omega$/square.

14. A solar cell backsheet film as claimed in any of Claims 1 to 13 further comprising a layer containing air bubbles in the range of not less than 10% by volume (layer B2).

15. A solar cell backsheet comprising a solar cell backsheet film as claimed in any of Claims 1 to 14.

16. A solar cell backsheet as claimed in Claim 15 comprising a surface having a surface resistivity R0 in the range of not less than $10^6$ $\Omega$/square and not more than $10^{14}$ $\Omega$/square (hereinafter referred to as surface A1).

17. A solar cell backsheet as claimed in either Claim 15 or 16 wherein surface A1 is surface A of a solar cell backsheet film as claimed in any of Claims 1 to 14.

18. A solar cell backsheet as claimed in any of Claims 15 to 17 wherein the surface opposite to surface A1 has a surface resistivity R3 of not less than $10^{14}$ $\Omega$/square.

19. A solar cell comprising a solar cell backsheet as claimed in any of Claims 15 to 18.

20. A solar cell as claimed in Claim 19 wherein power generation devices are formed so that they face the surface opposite to surface A1.

Fig. 1

Solar light

<table>
<tr><td colspan="2">**INTERNATIONAL SEARCH REPORT**</td><td colspan="2">International application No.<br>PCT/JP2009/059495</td></tr>
<tr><td colspan="4">A. CLASSIFICATION OF SUBJECT MATTER<br>*H01L31/042* (2006.01) i</td></tr>
<tr><td colspan="4">According to International Patent Classification (IPC) or to both national classification and IPC</td></tr>
<tr><td colspan="4">B. FIELDS SEARCHED</td></tr>
<tr><td colspan="4">Minimum documentation searched (classification system followed by classification symbols)<br>H01L31/04-31/078</td></tr>
<tr><td colspan="4">Documentation searched other than minimum documentation to the extent that such documents are included in the fields searched<br>Jitsuyo Shinan Koho     1922-1996   Jitsuyo Shinan Toroku Koho   1996-2009<br>Kokai Jitsuyo Shinan Koho   1971-2009   Toroku Jitsuyo Shinan Koho   1994-2009</td></tr>
<tr><td colspan="4">Electronic data base consulted during the international search (name of data base and, where practicable, search terms used)<br>JSTPlus(JDreamII), JST7580(JDreamII)</td></tr>
</table>

C. DOCUMENTS CONSIDERED TO BE RELEVANT

| Category* | Citation of document, with indication, where appropriate, of the relevant passages | Relevant to claim No. |
|---|---|---|
| A | JP 2008-270238 A (Toray Advanced Film Co., Ltd.), 06 November, 2008 (06.11.08), Par. Nos. [0015] to [0065] (Family: none) | 1-20 |
| A | JP 2008-166338 A (Toray Industries, Inc.), 17 July, 2008 (17.07.08), Par. Nos. [0038] to [0072] (Family: none) | 1-20 |
| A | JP 2006-253264 A (Toppan Printing Co., Ltd.), 21 September, 2006 (21.09.06), Par. Nos. [0027] to [0034], [0072] (Family: none) | 1-20 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>08 July, 2009 (08.07.09) | Date of mailing of the international search report<br>21 July, 2009 (21.07.09) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2009/059495

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2008-98592 A  (Toyo Ink Manufacturing Co., Ltd.), 24 April, 2008 (24.04.08), Claim 1; Par. Nos. [0017] to [0107] (Family: none) | 1-20 |
| A | WO 2007/105306 A1  (Toray Industries, Inc.), 20 September, 2007 (20.09.07), Par. Nos. [0012] to [0042] & US 2009/0065055 A    & EP 1995789 A1 & CN 101401217 A | 1-20 |
| A | JP 2002-26354 A  (Toray Industries, Inc.), 25 January, 2002 (25.01.02), Claim 1; Par. Nos. [0019] to [0042] (Family: none) | 1-20 |
| A | WO 2007/063860 A1  (Dainippon Printing Co., Ltd.), 07 June, 2007 (07.06.07), Par. Nos. [0011] to [0014] & EP 1956660 A1        & KR 10-2008-0078817 A & CN 101317276 A | 3 |
| E,A | JP 2009-147063 A  (Toray Advanced Film Co., Ltd.), 02 July, 2009 (02.07.09), Claims 1, 5, 7; Par. Nos. [0097] to [0116] (Family: none) | 1-20 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11261085 A
- JP 11186575 A
- JP 2006270025 A
- JP 2009012454 A
- JP 2009042421 A